# EUROPEAN PATENT APPLICATION

(11) **EP 4 693 871 A1**
(43) Date of publication of application: **11.02.2026**
(21) Application number: 24795852.3
(22) Date of filing: 11.04.2024
(51) Int. Cl.: H02M 7/00, H02M 1/00

(54) **PHOTOVOLTAIC INVERTER AND PHOTOVOLTAIC SYSTEM**

(30) Priority: 27.04.2023 CN 202310479759; 29.08.2023 CN 202311100717
(71) Applicant: Huawei Digital Power Technologies Co., Ltd., Shenzhen, Guangdong 518043 (CN)
(72) Inventor: MA, Zheng, Shenzhen, Guangdong 518043 (CN); ZHANG, Jiangteng, Shenzhen, Guangdong 518043 (CN); CHEN, Chao, Shenzhen, Guangdong 518043 (CN)
(74) Representative: Maiwald GmbH
(86) International application number: PCT/CN2024/087239
(87) International publication number: WO 2024/222471

(57) **Abstract**

This application provides a photovoltaic inverter and a photovoltaic system. The photovoltaic inverter includes a housing, a circuit board, cooling fins, a switch assembly, and PV ports. The circuit board is reversely fastened in the photovoltaic inverter. The circuit board partitions an accommodating cavity into a first subcavity and a second subcavity, and the first subcavity and the second subcavity accommodate a first device and a second device respectively. The second device includes an inverter power assembly fastened to a rear circuit board side. The cooling fins are located on a side that is of a bottom plate and that is away from a cover plate. The inverter power assembly is in thermally conductive connection to the cooling fins through a thermally conductive contact part. The switch assembly includes a knob, a connecting rod, and a switch body. The switch body includes breaking units. Pins of the breaking units are rigidly fastened to the rear circuit board side. In this application, the circuit board is reversely fastened in the photovoltaic inverter, and a large device is fastened to the rear circuit board side, so that both cooling effect and a product aesthetic feeling are considered. The switch body is rigidly fastened to the rear circuit board side through the pins. This reduces assembly difficulty of the photovoltaic inverter.

## Description

This application claims priorities to Chinese Patent Application No. 202310479759.1, filed with the China National Intellectual Property Administration on April 27, 2023 and entitled "PHOTOVOLTAIC INVERTER AND PHOTOVOLTAIC SYSTEM", and to Chinese Patent Application No. 202311100717.9, filed with the China National Intellectual Property Administration on August 29, 2023 and entitled "PHOTOVOLTAIC INVERTER AND PHOTOVOLTAIC SYSTEM", both of which are incorporated herein by reference in their entireties.

### TECHNICAL FIELD

This application relates to the field of photovoltaic technologies, and in particular, to a photovoltaic inverter and a photovoltaic system.

### BACKGROUND

With the continuous development of the new energy industry, a photovoltaic power generation system that converts solar energy into electric energy is widely used in fields such as communication, transportation, and aerospace. As one of important components of the photovoltaic power generation system, a photovoltaic inverter can convert a direct current generated by a photovoltaic solar panel into a 240 V and 50 Hz alternating current or another type of alternating current, to meet power consumption requirements of various devices. However, currently, a large quantity of connection lines exist in the photovoltaic inverter, an installation process is complex, and a cable connection fault is easily generated. In addition, currently, the photovoltaic inverter has a large size and poor cooling effect.

### SUMMARY

This application provides a photovoltaic inverter and a photovoltaic system. A circuit board is reversely fastened in the photovoltaic inverter. The photovoltaic inverter can avoid a cable connection fault, reduce an assembly difficulty, improve cooling effect, and facilitate miniaturization.

According to a first aspect, this application provides a photovoltaic inverter, including a housing, a circuit board, cooling fins, a switch assembly, and a plurality of PV ports. The housing includes a bottom housing and a cover plate. The bottom housing and the cover plate enclose an accommodating cavity. The bottom housing includes a bottom plate disposed opposite to the cover plate. In this implementation solution, the bottom housing is of a groove-shaped structure. The bottom housing and the cover plate enclose the accommodating cavity. The accommodating cavity in the housing is configured to protect the circuit board and protect the switch assembly, the first device, and the second device that are fastened to the circuit board. Because the circuit board is fixedly connected to the housing, the switch assembly, the first device, and the second device are fastened to the housing. When an external environment exerts an external force on the photovoltaic inverter, the switch assembly, the first device, and the second device are fastened to the housing and therefore are not prone to displacement relative to the housing. This helps improve stability of an overall structure of the photovoltaic inverter, and enables the photovoltaic inverter to work in a stable state.

The circuit board includes a front circuit board side and a rear circuit board side that are disposed opposite to each other in a first direction. Metal traces are disposed on the circuit board. The front circuit board side faces the cover plate. The rear circuit board side faces the bottom plate. The circuit board is fastened in the accommodating cavity of the housing, and partitions the accommodating cavity into a first subcavity and a second subcavity. In this implementation solution, the circuit board includes the front circuit board side and the rear circuit board side that are disposed opposite to each other in the first direction. The front circuit board side is a surface that is of the circuit board and that is directly presented to a user after the user opens the cover plate. When the user needs to open the cover plate, the cover plate faces the user, and an indicator is disposed on the cover plate. When the user opens the cover plate, the user can directly see the front circuit board side.

The first subcavity is located between the front circuit board side and the cover plate. The second subcavity is located between the rear circuit board side and the bottom plate. A volume of the first subcavity is less than a volume of the second subcavity. The first subcavity and the second subcavity accommodate the first device and the second device respectively. An operating heat dissipation amount of the second device is greater than an operating heat dissipation amount of the first device, or a length of the second device in the first direction is greater than a length of the first device in the first direction. The first device includes a surface mount resistor and a surface mount capacitor that are fastened to the front circuit board side. The second device includes an inverter power assembly, a bus capacitor, and an inductor that are fastened to the rear circuit board side.

In this implementation solution, the front circuit board side and the cover plate enclose the first subcavity. The first subcavity is configured to accommodate the first device. The rear circuit board side and the bottom plate enclose the second subcavity. The second subcavity is configured to accommodate the second device. The volume of the first subcavity is less than the volume of the second subcavity, to adapt to a size relationship between the first device and the second device. In an implementation, the first device further includes a diode.

The cooling fins are located on a side that is of the bottom plate and that is away from the cover plate. A thermally conductive contact part is disposed on a side that is of the inverter power assembly and that is away from the circuit board. The inverter power assembly is in thermally conductive connection to a part of the cooling fins through the thermally conductive contact part. The bus capacitor and the inductor are located on a circumferential side of the thermally conductive contact part.

The inverter power assembly is a main heat emitting device of the photovoltaic inverter. Therefore, temperature rise control needs to be implemented for the heat emitting device. The inverter power assembly is in thermally conductive connection to the part of the cooling fins through the thermally conductive contact part. This helps shorten a heat transfer path and improve cooling effect. The bus capacitor and the inductor are located on the circumferential side of the thermally conductive contact part, or located on a circumferential side of the inverter power assembly. The bus capacitor and the inductor may be in thermally conductive connection to the cooling fins through the bottom plate. The thermally conductive contact part may further absorb heat of the bus capacitor and the inductor from the circumferential side. This improves cooling effect. In an implementation, the thermally conductive contact part may be a part of the bottom plate, or may be a thermally conductive structure located between the bottom plate and the inverter power assembly.

The switch assembly includes a knob, a connecting rod, and a switch body. The knob and the switch body are located on an outer side and an inner side of the housing respectively. The knob is connected to the switch body through the connecting rod. The switch body is located in the second subcavity. The switch body is connected to the circuit board. The switch body includes a plurality of breaking units. An arrangement direction of the plurality of breaking units is the same as an arrangement direction of the knob and the switch body. Each breaking unit includes pins. The pins of each breaking unit are both rigidly fastened to the rear circuit board side.

In this implementation, both the switch body and the second device are located in the second subcavity. The switch body is fastened to the rear circuit board side. The pins are rigidly fastened to the rear circuit board side, so that the switch body is fastened and electrically connected to the rear circuit board side. Rigid fastening means that the pins cannot rotate or move relative to the circuit board. In a process in which the switch body is fastened to the rear circuit board side, generally the switch body needs to be fastened to the bottom housing through the connecting rod, and then the circuit board is connected to the switch body. Because the rear circuit board side is a surface that is of the circuit board and that is away from an operator, it is inconvenient for the operator to directly observe the rear circuit board side. In addition, the second device has been installed on the rear circuit board side. In this application, the switch body is fastened to the rear circuit board side in a rigid connection manner. For example, the pins may be directly inserted into the rear circuit board side and rigidly fastened to the rear circuit board side. In the rigid connection manner, installation difficulty can be reduced, and contact resistance and a heat dissipation amount between the switch body and the circuit board can be reduced.

A connection manner different from rigid connection is flexible connection. For example, flexible connection may be cable connection, and cables may rotate or move relative to the circuit board. If the breaking units of the switch body are flexibly connected to the circuit board through the cables, cable arrangement inside the photovoltaic inverter is disordered. In addition, because the cables may move relative to the circuit board, when the switch body is fastened to the rear circuit board side through the cables, positioning and installation are difficult, and problems of low operation efficiency and poor connection are easily caused. In addition, both ends of the cable generally need to be connected to the rear circuit board side and the switch body through OT terminals respectively, so that contact resistance and a heat dissipation amount of the entire loop increase, and efficiency of an entire machine decreases. During installation, because the switch body is located on the rear circuit board side, only after connecting one end of the cable to the switch body, installing and fastening the circuit board, and winding the other end of the cable sequentially from the rear circuit board side, a side face of the circuit board, to the front circuit board side, the operator can fixedly connect the other end of the cable to the front circuit board side. Compared with the rigid connection manner in this application, operation is complex, and cable arrangement is disordered.

In this implementation, the switch body and the second device are jointly fastened to the rear circuit board side. That is, devices with a large size or a large length in the first direction are arranged on the rear circuit board side in a centralized manner. Compared with arranging the switch body and the second device on the front circuit board side and the rear circuit board side in a distributed manner, in this implementation, an overall length of the photovoltaic inverter in the first direction can be reduced, so that a size of the photovoltaic inverter is small. This facilitates overall layout of a photovoltaic system.

One end of the PV port is located inside the housing and is connected to the circuit board, and the other end of the PV port passes through the housing and extends to the outer side of the housing. In this implementation, two ends of the PV port are located on the inner side of the housing and the outer side of the housing respectively. The PV port is configured to transfer a direct current to the inverter power assembly.

The PV ports are connected to some pins of the switch body through the metal traces of the circuit board. Some pins of the switch body are connected to the bus capacitor through the metal traces of the circuit board. The bus capacitor is connected to the inverter power assembly through the metal traces of the circuit board. In this implementation, connection means electrical connection. From a structural perspective, connection may be direct fixed connection or indirect fixed connection. A plurality of metal traces exist on the circuit board. The metal traces may also be referred to as conducting traces, may be copper traces, and are configured to connect devices on the circuit board. In this implementation, connection through the metal traces is implemented between the PV ports and the pins of the switch body, between the pins and the bus capacitor, and between the bus capacitor and the inverter power assembly. This reduces or avoids cables, and reduces installation difficulty. In this implementation, the direct current transferred by the PV port is converted to an alternating current by using the foregoing connection relationship, so that contact resistance and a heat dissipation amount between devices are reduced, and working efficiency of the photovoltaic inverter is improved.

In this application, the photovoltaic inverter is disposed: First, the circuit board is reversely fastened in the photovoltaic inverter, and the second device with a large heat dissipation amount or the second device with a large size is disposed on the rear circuit board side, so that cooling effect on the second device is improved. The first device with a small heat dissipation amount or the first device with a small size is disposed on the front circuit board side, so that the volume of the first subcavity between the front circuit board side and the cover plate is small, internal space of the photovoltaic inverter is fully utilized, and miniaturization of the photovoltaic inverter is facilitated.

Second, because the circuit board is reversely fastened in the photovoltaic inverter, to improve cooling effect and improve utilization of space inside the photovoltaic inverter, the inverter power assembly is in thermally conductive connection to the cooling fins through the thermally conductive contact part, so that a heat transfer path between the inverter power assembly and the cooling fins is effectively shortened, and cooling effect on the inverter power assembly is improved. The thermally conductive contact part can further provide support for the circuit board, so that structural strength and reliability between the circuit board inside the photovoltaic inverter and the housing are improved.

Third, both the switch body of the switch assembly and the second device are fastened to the rear circuit board side. In an installation process, because it is inconvenient for the operator to directly observe the rear circuit board side, in this application, the switch body is rigidly fastened to the rear circuit board side through the pins. Compared with flexible fastening, in this application, installation difficulty is reduced, and a step of manual fastening is omitted. Due to cableless connection between the switch body and the circuit board, contact resistance and a heat dissipation amount between the switch body and the circuit board can be further reduced, and working efficiency of the photovoltaic inverter is improved. In addition, impact of poor contact between the switch body and the circuit board can be reduced in processing, transportation, and assembly processes.

In an implementation, the inductor in the second device includes at least one of the following: a filter inductor, an inductor in a direct current conversion assembly, and an inductor in the inverter power assembly. In this implementation, practicability of the photovoltaic inverter is improved.

In an implementation, the breaking unit includes a movable contact and static contacts. One end that is of the pin and that is away from the circuit board is fastened to the static contact. The static contact is connected to the metal trace of the circuit board through the pin. The knob can control the movable contact of the breaking unit to rotate, to disconnect or connect the movable contact and the static contacts.

In this implementation, the breaking units are electrically connected between a photovoltaic module and the inverter power assembly through the pins. In this implementation, two ends of the pin are directly fastened to the breaking unit and the circuit board respectively. Compared with a cable connection manner, an increase of assembly and maintenance difficulty caused by a large quantity of cables can be avoided. In addition, the breaking units and the circuit board are directly connected and fastened through the pins, so that space occupied by the devices inside the photovoltaic inverter can be reduced, and the size of the photovoltaic inverter is reduced. In addition, the breaking units and the circuit board are directly connected and fastened through the pins, so that resistance between the breaking units and the circuit board can be reduced, a current transfer path from the breaking units to the circuit board is shorter, current transfer efficiency is improved, and working effect of the photovoltaic inverter is further improved.

In an implementation, one end that is of the pin and that is away from the circuit board is connected to the static contact through a connecting part. For example, one end that is of the pin and that is away from the circuit board is welded and fastened to the static contact. The connecting part is solder between the pin and the static contact. For example, the connecting part may be a long strip-shaped or bent metal structure.

In an implementation, one end of the static contact extends to an outer side of the breaking unit to form the pin. In this implementation, the pin and the static contact are of an integrated structure. This helps improve stability of connection between an input pin and the static contact and between an output pin and the static contact.

In an implementation, the pins include input pins and output pins. The breaking units include input breaking units and an output breaking unit. The input pins and the output pins are located on the input breaking units and the output breaking unit respectively. The knob is configured to control conduction between the input pins and conduction between the output pins, and is further configured to control disconnection between the input pins and disconnection between the output pins. In this implementation, the knob can be used to control conduction and disconnection between the input pins and conduction and disconnection between the output pins, to implement electrical connection and disconnection between the photovoltaic module and the switch body.

In an implementation, the switch body includes at least one input pin pair and at least one output pin pair. Each input pin pair includes two input pins. Each output pin pair includes two output pins. The PV port includes a positive connector and a negative connector.

In the input breaking unit, one input pin in each input pin pair is configured to connect to the positive connector through the metal trace of the circuit board, two input pins in each input pin pair are connected through static contacts and a movable contact in the input breaking unit, and the other input pin in each input pin pair is configured to connect to the bus capacitor through the metal trace of the circuit board.

In the output breaking unit, one output pin in each output pin pair is configured to connect to the negative connector through the metal trace of the circuit board, two output pins in each output pin pair are connected through static contacts and a movable contact in the output breaking unit, and the other output pin in each output pin pair is configured to connect to the inverter power assembly through the metal trace of the circuit board.

In this implementation, the inverter power assembly and the photovoltaic module form a loop by using the input pin pair and the output pin pair. The input pin pair is located between a positive electrode of the photovoltaic module and the inverter power assembly. The output pin pair is located between the inverter power assembly and a negative electrode of the photovoltaic module. A current flows from the positive electrode of the photovoltaic module to the inverter power assembly, and then flows from the inverter power assembly to the negative electrode of the photovoltaic module. In this implementation, the input pins and the output pins are electrically connected to the photovoltaic module and the inverter power assembly respectively through the circuit board, so that use of cables between the switch body and the photovoltaic module and between the switch body and the inverter power assembly can be avoided. This helps reduce costs, reduce occupation of internal space, and improve convenience of installation operation.

In an implementation, the second device further includes the direct current conversion assembly. The direct current conversion assembly is fastened to the rear circuit board side. The direct current conversion assembly is located between the thermally conductive contact part and the rear circuit board side. The direct current conversion assembly is in thermally conductive connection to the cooling fins through the thermally conductive contact part. Some pins of the switch body are connected to the direct current conversion assembly through the metal traces of the circuit board. The direct current conversion assembly is electrically connected to the bus capacitor through the metal traces of the circuit board. In this solution, the direct current conversion assembly is configured to perform voltage conversion on the direct current transferred to the inverter power assembly, to convert a voltage into a direct current voltage required by the inverter power assembly. In an implementation, the direct current conversion assembly is a direct current voltage boosting assembly. In this solution, the direct current conversion assembly is connected to the metal traces of the circuit board, to implement electrical connection between the direct current conversion assembly and the bus capacitor and between the direct current conversion assembly and the switch body.

In an implementation, the input pins of the switch body are connected to the direct current conversion assembly through the metal traces of the circuit board.

In an implementation, the photovoltaic inverter further includes an input-side filtering component and an output-side filtering component. Both the input-side filtering component and the output-side filtering component are connected to the circuit board. The PV port is connected to the input-side filtering component through the metal traces of the circuit board. The input-side filtering component is connected to some pins of the switch body through the metal traces of the circuit board. The inverter power assembly is connected to the output-side filtering component through the metal traces of the circuit board.

In this solution, the direct current generated by the photovoltaic module is input to the input-side filtering component through the PV port, and then the input-side filtering component transfers the direct current to the direct current conversion assembly through the switch body. The direct current conversion assembly performs voltage conversion operation on the direct current, and continues to sequentially transfer the direct current to the bus capacitor and the inverter power assembly. The direct current is converted into the alternating current in the inverter power assembly, and then the inverter power assembly transfers the alternating current to the output-side filtering component. The input-side filtering component and the output-side filtering component filter out harmonics in the direct current and the alternating current respectively, to reduce heat generated by the inverter power assembly, avoid a safety risk, and improve reliability of inverter conversion. In addition, the input-side filtering component and the output-side filtering component can further improve electromagnetic compatibility effect in working of the photovoltaic inverter. Electromagnetic compatibility (EMC) means a capability of the photovoltaic inverter to operate up to standard in an electromagnetic environment without generating intolerable electromagnetic disturbance to any device in the environment. Therefore, EMC includes requirements in two aspects: Electromagnetic disturbance generated by the photovoltaic inverter in a proper running process to the environment in which the photovoltaic inverter is located cannot exceed a specific limit. In addition, the photovoltaic inverter has a specific degree of resistance to electromagnetic disturbance existing in the environment in which the photovoltaic inverter is located, that is, electromagnetic susceptibility (EMS).

In this solution, the functional devices are electrically connected through the metal traces of the circuit board. This can save cables and simplify a structure, and can also reduce impedance between the functional devices, and improve power effect of the photovoltaic inverter.

In an implementation, the alternating current output from the output-side filtering component may be provided for a power grid. In this implementation, an application scope of the photovoltaic inverter is broadened. In an implementation, the input-side filtering component and the output-side filtering component may include filter capacitors.

In an implementation, a distance between the thermally conductive contact part and the rear circuit board side in the first direction is less than a distance between the bottom plate and the circuit board in the first direction. A length of the inverter power assembly in the first direction is less than a length of at least one of the bus capacitor, the inductor, and the switch assembly in the first direction.

In this implementation, in the first direction, lengths of the inverter power assembly in the second device and the switch assembly are not the largest. Therefore, there is still some spare space between the inverter power assembly and the bottom plate, the thermally conductive contact part may protrude toward the inverter power assembly in the first direction, and the spare space is excluded from the photovoltaic inverter. In this case, the distance between the thermally conductive contact part and the rear circuit board side is less than the distance between the bottom plate and the rear circuit board side. In this solution, internal space of the photovoltaic inverter is properly planned. This helps improve utilization of space inside the photovoltaic inverter, reduce a volume occupied by the photovoltaic inverter, and facilitate overall layout. The distance between the bottom plate and the circuit board in the first direction is a maximum distance between the bottom plate and the circuit board in the first direction.

In an implementation, the photovoltaic inverter further includes a fan. The fan is located in the second subcavity and connected to the circuit board. In this implementation, the fan is disposed in the second subcavity, so that the fan can air-cool the second device. The fan is combined with the cooling fins, so that it is easier to control a temperature of the second device within a temperature range suitable for the second device to work. The fan is disposed inside the photovoltaic inverter. This helps improve utilization of space inside the photovoltaic inverter.

In an implementation, a maximum length between the bottom plate and the rear circuit board side in the first direction is greater than a length between the cover plate and the front circuit board side in the first direction, so that the inductor, the bus capacitor, and the switch body can be accommodated between the bottom plate and the rear circuit board side.

In this implementation, the second subcavity for accommodating the second device and the switch body is located between the bottom plate and the rear circuit board side, and the first subcavity for accommodating the first device is located between the cover plate and the front circuit board side. Because lengths of the second device and the switch body in the first direction are greater than a length of the first device in the first direction, the volume of the second subcavity needs to be correspondingly set to be greater than the volume of the first subcavity, and further the distance between the bottom plate and the rear circuit board side in the first direction needs to be set to be greater than the distance between the cover plate and the front circuit board side in the first direction. In this solution, installation space is provided for disposing the inductor, the bus capacitor, and the switch body on the rear circuit board side.

In an implementation, a value of a length of either of the surface mount resistor and the surface mount capacitor in the first direction is less than or equal to 5 millimeters, so that the volume of the first subcavity is small and the overall size of the photovoltaic inverter is reduced. In this implementation, lengths of the surface mount resistor and the surface mount capacitor in the first direction are set to be small, so that the surface mount resistor and the surface mount capacitor occupy small space in the first subcavity, the volume of the first subcavity is set to be small, and miniaturization design of the photovoltaic inverter is facilitated.

In an implementation, a value of a length between the front circuit board side and the cover plate in the first direction is less than or equal to 20 millimeters. In this implementation, the value of the length between the front circuit board side and the cover plate in the first direction corresponds to the volume of the first subcavity. The volume of the first subcavity is set to be small, so that miniaturization design of the photovoltaic inverter is facilitated.

In an implementation, a value of a maximum length between the rear circuit board side and the bottom plate in the first direction is greater than or equal to 10 centimeters, so that the inductor, the bus capacitor, and the switch body can be accommodated between the rear circuit board side and the bottom plate. Because different positions of the bottom plate may not be in a same plane, in this implementation, the length between the rear circuit board side and the bottom plate in the first direction is a maximum length between the rear circuit board side and the bottom plate in the first direction, and a value of the maximum length is set to be greater than or equal to 10 centimeters, so that the second subcavity has sufficient space for accommodating the inductor, the bus capacitor, and the switch body with a large size. This helps reduce installation difficulty.

In an implementation, a value of a maximum length between the rear circuit board side and the bottom plate in the first direction is greater than or equal to 20 centimeters. In this implementation, the length between the rear circuit board side and the bottom plate in the first direction is set to properly adjust the space size of the second subcavity, so that the second subcavity has sufficient space for accommodating the inductor, the bus capacitor, and the switch body with a large size. This helps reduce installation difficulty.

In an implementation, the plurality of PV ports include positive connectors. The bottom housing includes a first subboard located between the bottom plate and the cover plate. The positive connectors are fastened to the first subboard. The arrangement direction of the knob and the switch body is parallel to the first subboard. One end of the positive connector is located inside the housing and fastened to the rear circuit board side. The other end of the positive connector passes through the housing and extends to the outer side of the housing. The other end of the positive connector is configured to connect to the positive electrode of the photovoltaic module. The second device further includes filter capacitors. The filter capacitors are fastened to the rear circuit board side. The filter capacitors are located on circumferential sides of the positive connectors and between the switch body and the first subboard. The filter capacitors are connected between the positive connectors and the pins through the metal traces of the circuit board.

In this implementation, the filter capacitors are configured to reduce impedance between the positive connectors and the filter capacitors, to improve filtering effect. The pins are a part of the switch body. The positive connectors are electrically connected to the photovoltaic module. The filter capacitors are connected between the positive connectors and the pins. That is, the filter capacitors are connected between the photovoltaic module and the switch body, and the photovoltaic module, the filter capacitors, and the switch body are sequentially electrically connected. If the switch body is electrically connected between the filter capacitors and the positive connectors, the direct current output by the photovoltaic module first passes through the switch body, and then flows into the filter capacitors. Because the switch body has specific resistance, filtering effect of the filter capacitors on the direct current is reduced. Therefore, in this implementation, filtering effect of the filter capacitors is improved.

In this implementation, one end of the positive connector passes through the first subboard and extends to the inner side of the housing. An orthographic projection of the filter capacitor on the circuit board is located on a circumferential side of an orthographic projection of the positive connector on the circuit board. Because the filter capacitors are electrically connected between the positive connectors and the switch body, in this solution, the filter capacitors are disposed close to the positive connectors, so that distances between the filter capacitors and the positive connectors are reduced, the current input from the photovoltaic module can be directly transferred to the filter capacitors, a length of a current input path of the photovoltaic inverter is effectively shortened, impedance is smaller, and filtering effect of the filter capacitors is improved. In addition, in this solution, device arrangement of the photovoltaic inverter can be further optimized. This helps reduce the size of the photovoltaic inverter.

In an implementation, the plurality of PV ports include negative connectors. One end of the negative connector is located inside the housing and fastened to the rear circuit board side. The other end of the negative connector passes through the housing and extends to the outer side of the housing. The other end of the negative connector is configured to connect to the negative electrode of the photovoltaic module.

In this implementation, a current sequentially flows from the positive electrode of the photovoltaic module to the positive connectors and the inverter power assembly, undergoes inverting conversion in the inverter power assembly, and then sequentially flows to the negative connectors and the negative electrode of the photovoltaic module, to form a loop.

In an implementation, the photovoltaic inverter further includes an insulation support. The insulation support is located between the bottom plate and the circuit board. The insulation support is fastened to the bottom plate. One end of at least one of the PV ports is fastened between the insulation support and the circuit board. The insulation support is located in the second subcavity, so that space of the second subcavity is fully utilized. In this implementation, the insulation support is configured to support the PV ports, so that the PV ports are more stably fastened to the circuit board.

In an implementation, one end that is of each PV port and that is located inside the bottom housing is fastened between the insulation support and the circuit board. For example, one end of the PV port, the circuit board, and the insulation support are fastened to each other through a screw.

In an implementation, the insulation support includes a plurality of first support parts and a plurality of second support parts. The plurality of first support parts and the plurality of second support parts are sequentially and alternately arranged in a third direction. The third direction is parallel to the arrangement direction of the knob and the switch body. In the first direction, a distance between the bottom plate and a surface that is of the first support part and that is away from the bottom plate is greater than a distance between the bottom plate and a surface that is of the second support part and that is away from the bottom plate. One end of each of some PV ports of the plurality of PV ports is fastened to the surface that is of each of the plurality of first support parts and that is away from the bottom plate. One end of each of the other PV ports of the plurality of PV ports is fastened to the surface that is of each of the plurality of second support parts and that is away from the bottom plate. In this implementation, heights of the first support parts and the second support parts are different. Some PV ports are fastened between the first support parts and the circuit board, and some PV ports are fastened between the second support parts and the circuit board, so that the PV ports are dispersedly arranged, and impact of centralized layout on stability of electrical connection between the PV ports is avoided.

In this implementation, the plurality of first support parts and the plurality of second support parts are sequentially and alternately arranged in the third direction, so that the plurality of PV ports are sequentially and alternately arranged in the third direction, and the PV ports are more orderly arranged.

In an implementation, the bottom housing includes a first subboard located between the bottom plate and the cover plate. The first subboard is parallel to the third direction. The plurality of PV ports include a plurality of positive connectors and a plurality of negative connectors. The plurality of positive connectors and the plurality of negative connectors are all fastened to the first subboard. In the first distance, distances between the plurality of positive connectors and the bottom plate are greater than distances between the plurality of negative connectors and the bottom plate. In the third direction, the plurality of positive connectors and the plurality of negative connectors are sequentially and alternately arranged. One end that is of each positive connector and that is located inside the bottom housing includes a positive metal sheet. An end that is of each negative connector and that is located inside the housing case includes a negative metal sheet. Each positive metal sheet is fastened to a surface that is of one first support part and that is away from the bottom plate, and is fastened to the circuit board. Each negative metal sheet is fastened to a surface that is of one second support part and that is away from the bottom plate.

In this implementation, the plurality of positive connectors are fastened to the first support parts, and the plurality of negative connectors are fastened to the second support parts, so that the plurality of positive connectors and the plurality of negative connectors are sequentially and alternately arranged in the third direction and distributed in a staggered manner in the first direction, mutual interference between electrical connection of the plurality of positive connectors and electrical connection of the plurality of negative connectors is reduced, stability of electrical connection is improved, and overall layout is more orderly.

In an implementation, the positive connector includes a positive connector housing. The positive connector housing is fastened to the first subboard. Two ends of the positive connector housing are located inside and outside the bottom housing respectively. The positive metal sheet is fastened to one end that is of the positive connector housing and that is located inside the bottom housing. The distance between the bottom plate and the surface that is of the first support part and that is away from the bottom plate is greater than a distance between the positive connector housing and the bottom plate. The positive metal sheet includes a bending section and a positive fastening section. The bending section is connected between the positive fastening section and the positive connector housing. The positive fastening section is fastened between the circuit board and the surface that is of the first support part and that is away from the bottom plate.

In this implementation, because the first support parts are further configured to support the circuit board, to enlarge space between the circuit board and the bottom plate or enlarge space of the second subcavity, lengths of the first support parts in the first direction need to be set to be large. The first subboard is configured to fasten the positive connector housing. Because the positive connector housing has a specific length in the first direction, when the positive connector housing is fastened to the first subboard, the positive connector housing is lower than the circuit board in the first direction. In this application, distances between the positive connector housing and the first support part and between the positive connector housing and the bottom plate are different, metal in the positive connector housing is connected to the positive fastening section through the bending section in the positive metal sheet, the positive fastening section is fastened between the first support part and the circuit board, and the positive connector is connected to the circuit board. For example, the positive metal sheet is in a "Z" shape.

The distance between the negative connector and the bottom plate is less than the distance between the positive connector and the bottom plate. Therefore, in an implementation, the negative metal sheet in the negative connector may be planar. In an implementation, the negative metal sheet in the negative connector may also be set to a "Z" shape.

In an implementation, the photovoltaic inverter further includes a filter circuit board and filter capacitors. The filter circuit board is fastened between the bottom plate and the circuit board in the first direction. In a second direction, the filter circuit board is located on a side that is of the plurality of first support parts and that is away from the first subboard. The second direction is perpendicular to both the first direction and the third direction. The filter capacitors are fastened to a surface that is of the filter circuit board and that faces the circuit board. The plurality of negative connectors are connected to the filter circuit board. The filter capacitors are connected to some pins of the switch body through the filter circuit board and the metal traces of the circuit board.

In this implementation, the filter capacitors are fastened by using the filter circuit board, and the filter capacitors are electrically connected to the circuit board through the filter circuit board, so that the filter capacitors do not occupy space on the circuit board, and space of the second subcavity can be fully utilized. In this implementation, the filter capacitors belong to the input-side filtering component, the filter capacitors are connected to the negative connectors through the filter circuit board, and the filter capacitors are connected to the switch body through the filter circuit board and the metal traces of the circuit board, so that the filter capacitors are connected between the negative connectors and the pins of the switch body, and filtering effect of the filter capacitors is improved.

In an implementation, the insulated support further includes a third support part. The third support part is located between the filter circuit board and the circuit board in the first direction. A projection of the third support part in the first direction and a projection of the filter circuit board in the first direction partially overlap. In the second direction, a distance between the third support part and the first subboard is greater than a distance between each first support part and the first subboard. The third support part is fastened to one first support part. The photovoltaic inverter further includes a first connection metal sheet. The filter circuit board is connected to one end of the first connection metal sheet. The plurality of negative connectors are connected to the first connection metal sheet through the filter circuit board. The plurality of filter capacitors are connected to the first connection metal sheet through the filter circuit board. The other end of the first connection metal sheet is fastened to a surface that is of the third support part and that is away from the bottom plate, and is fixedly connected to the circuit board.

In this implementation, one end of the first connection metal sheet is connected to the plurality of negative connectors and the plurality of filter capacitors, and the other end of the first connection metal sheet is configured to fasten to the circuit board, so that the plurality of negative connectors and the plurality of filter capacitors are connected to the circuit board through one connector, and structural layout is simplified.

In an implementation, the third support part is arranged in the third direction on a side that is of all the first support parts and the second support parts and that is away from a second subboard, so that arrangement is more orderly.

In an implementation, the first connection metal sheet includes a total connection section and a total fastening section that are connected to each other. The total connection section is connected between the filter circuit board and the total fastening section. The total fastening section is configured to connect to the circuit board. In the second direction, the total connection section is located on a side that is of the third support part and that is away from the first subboard. The total fastening section is fastened between the circuit board and a surface that is of the third support part and that is away from the bottom plate. Structural layout is more orderly.

In an implementation, the insulation support further includes an external connector pair configured to support connection to a battery pack. The external connector pair is configured to connect to the battery pack. The insulation support further includes a fourth support part, a fifth support part, and a sixth support part. In the first direction, a distance between the bottom plate and a surface that is of the sixth support part and that is away from the bottom plate is less than distances between the bottom plate and surfaces that are of the fourth support part and the fifth support part and that are away from the bottom plate. The sixth support part is configured to fixedly connect to a negative connector in the external connector pair, and is connected between the fifth support part and the circuit board through a second metal connection sheet. The fourth support part is configured to fixedly support a positive connector in the connector pair and connect the positive connector to the circuit board.

In an implementation, the first support part and the second support part are of an integrally-molded structure. In an implementation, the first support part, the second support part, and the third support part are of an integrally-molded structure. In an implementation, the first support part, the second support part, the third support part, the fourth support part, the fifth support part, and the sixth support part are of an integrally-molded structure. Structural strength of the insulation support is improved.

In an implementation, the negative connector is fastened to the first subboard. In this solution, the positive connector and the negative connector are fastened to a same subboard of the housing. This reduces installation difficulty and saves space.

In an implementation, the bottom housing further includes the second subboard located between the bottom plate and the cover plate. The second subboard is connected to and intersects with the first subboard. One end of the knob passes through the second subboard and extends to the inner side of the housing, and is fastened to the switch body. In this solution, the knob and the positive connectors are disposed on different subboards of the housing, so that installation space of the different subboards is effectively used, and an operation error can be avoided.

In an implementation, the second subboard is provided with a mounting hole that penetrates an inner surface and an outer surface of the second subboard. A sealing component is disposed on an outer side of the second subboard. The switch assembly includes a connecting rod. The connecting rod sequentially passes through the sealing component and the mounting hole and extends to the inner side of the housing. The sealing component is configured to seal a gap between the mounting hole and the connecting rod. The sealing component in this solution can avoid that water vapor or impurities enter the housing through the mounting hole and affect performance of the circuit board or an electrical component. Because the switch body is fastened to the circuit board, space between the switch body and the inner surface of the second subboard is limited, and it is inconvenient to install the sealing component on the inner surface of the second subboard. Therefore, in this implementation, the sealing component is disposed on the outer side of the second subboard, so that installation of the knob and the sealing component is facilitated.

In an implementation, the filter capacitors, the switch body, and the inductor are sequentially arranged in the second direction, where the second direction intersects with the first subboard. In this implementation, the switch body is located between the filter capacitors and the inductor in the second direction, so that layout of devices on the circuit board is optimized. Some filter capacitors, the switch body, and the inductor are disposed close to the second subboard. This helps provide installation space for disposing another device in the photovoltaic inverter. In an implementation, the second direction is perpendicular to an extension direction of the switch body and perpendicular to the first subboard. In this solution, installation difficulty of the photovoltaic inverter is reduced.

In an implementation, the filter capacitors, the inductor, and the switch body are sequentially arranged in the second direction. In this implementation, the inductor is located between the filter capacitors and the switch body in the second direction, and both the filter capacitors and the inductor are disposed close to the first subboard, so that a distance between the positive connectors and both of the filter capacitors and the inductor can be shortened, and filtering effect of the filter capacitors and the inductor on the direct current is enhanced.

In an implementation, all the pins are inserted into the circuit board and rigidly fastened to the circuit board. In this implementation, the pins are rigid, and the pins are inserted into the circuit board, so that the pins are rigidly fastened to the circuit board. When the knob is configured to control the switch body to be turned off, the switch body controls, by using the pins, the inverter power assembly to be disconnected from the photovoltaic module. When the knob is configured to control the switch body to be turned on, the switch body controls, by using the pins, the inverter power assembly to be electrically connected to the photovoltaic module. In this implementation, the pins are rigidly fastened to the circuit board in a manner of being inserted into the circuit board, so that the switch body can be more conveniently fastened and electrically connected to the circuit board. This simplifies an assembly process of the photovoltaic inverter and reduces labor costs. In addition, a distance of a position at which the switch body is fastened and electrically connected to the circuit board is shortened, so that space at a joint between the switch body and the circuit board is saved, and space utilization and power density of the photovoltaic inverter are improved.

In an implementation, all extension directions of the pins are perpendicular to the rear circuit board side, so that the pins can be conveniently inserted into the circuit board. In this implementation, when the pins of the switch body are inserted into the circuit board, because the rear circuit board side is parallel to a surface that is of the switch body and that faces the circuit board, resistance to the pins is small, and deformation is not likely to occur, so that stability of mechanical connection and electrical connection relationships between the switch body and the circuit board can be improved. This helps ensure proper operation of the photovoltaic inverter.

In an implementation, all extension directions of the pins are perpendicular to a surface that is of the switch body and that faces the circuit board, so that the switch body can be stably and fixedly connected to the circuit board through the pins. In this implementation, the extension directions of the pins are perpendicular to the surface that is of the switch body and that faces the circuit board. This helps smoothly fasten and electrically connect the switch body to the circuit board while reducing processing difficulty.

In an implementation, extension directions of the pins are perpendicular to the rear circuit board side, an included angle between the extension directions of the pins and a surface that is of the switch body and that faces the circuit board is less than 90°, and an included angle between the rear circuit board side and the surface that is of the switch body and that faces the circuit board is less than 90°. That is, the rear circuit board side is not parallel to the surface that is of the switch body and that faces the circuit board. In this implementation, assembly difficulty is reduced. The pins in this implementation are applicable to a case in which the switch body cannot be placed in parallel on the bottom housing because excessive devices exist in the bottom housing.

In an implementation, an included angle between extension directions of the pins and the rear circuit board side is less than 90°, the extension directions of the pins are perpendicular to a surface that is of the switch body and that faces the circuit board, and an included angle between the rear circuit board side and the surface that is of the switch body and that faces the circuit board is less than 90°. In this implementation, the rear circuit board side is not parallel to the surface that is of the switch body and that faces the circuit board either. In this implementation, assembly difficulty is reduced. The pins in this implementation are applicable to a case in which the circuit board cannot be placed in parallel in the bottom housing because excessive devices exist on the circuit board or the cover plate is uneven.

In an implementation, extension directions of the pins are not perpendicular to either of the rear circuit board side and a surface that is of the switch body and that faces the circuit board, and the rear circuit board side is parallel to the surface that is of the switch body and that faces the circuit board. In this implementation, the pins are obliquely inserted into the circuit board. When the pins on the switch body do not correspond to via holes in the circuit board, the pins may deviate from a height direction, so that the pins can be inserted into the via holes in the circuit board. This improves assembly flexibility of the photovoltaic inverter.

In an implementation, the pins are metal pins. The metal pins have high strength, and can be easily inserted into the circuit board and are fixedly connected to the circuit board. For example, the metal pins are copper pins.

In an implementation, the circuit board is provided with a plurality of via holes. The pins pass through the via holes and are welded to the via holes, so that the pins are rigidly fastened to the circuit board. In this implementation, the pins pass through the via holes and are welded to the via holes, so that the pins are fastened and electrically connected to the via holes, and the pins are fastened and electrically connected to the circuit board. In this implementation, the circuit board is provided with the via holes. This effectively reduces operation difficulty of inserting the pins into the circuit board.

In an implementation, pads are disposed on the front circuit board side. The pad encircles a circumferential side of the via hole. An end that is of the pin and that passes through the via hole is welded to the pad. In this implementation, the pins are welded to the circuit board through the pads, so that the pins are fastened to the front circuit board side, and the switch body is not prone to falling off from the circuit board. This helps improve stability of connection between the switch body and the circuit board.

In an implementation, a plurality of sockets are disposed on the rear circuit board side. The pins are all inserted into the sockets, and are rigidly fastened to the circuit board and electrically connected to the circuit board. In this implementation, the sockets matching the pins are disposed on the rear circuit board side, and the pins are inserted into the sockets, so that the pins are fastened and electrically connected to the sockets, and the pins are rigidly fastened and electrically connected to the circuit board. A connection relationship between the pins and the sockets in this implementation is essentially a detachable connection relationship. This helps reduce difficulty in assembling and disassembling the switch body and the circuit board.

In an implementation, the switch body includes an operation mechanism and breaking units. The knob can control, by using the operation mechanism, the breaking units to be disconnected or connected. An end that is of the pin and that is away from the circuit board is fastened in the breaking unit. In this implementation, the knob is fixedly connected to the operation mechanism, and the knob rotates to drive the operation mechanism to rotate, so that the breaking unit switches between a disconnected state and a connected state. The breaking units are electrically connected to the circuit board through the pins. Disconnection and connection of the breaking units correspond to disconnection and electrical connection between the photovoltaic module and an inverter circuit.

In an implementation, the operation mechanism is a free tripping structure. In this implementation, safety of the photovoltaic inverter is improved.

In an implementation, the switch body further includes a switch housing. The operation mechanism and the breaking units are all located inside the switch housing. The switch housing is a plastic member. In this implementation, the pins may be integrated with the switch housing through injection molding to form an integrated structure. This improves structural strength of the input pins, the output pins, and the switch housing.

In an implementation, the switch housing includes a housing body and an upper cover. The upper cover covers the housing body to form accommodating space. The operation mechanism and the breaking units are located in the accommodating space. The pins are integrated with the upper cover through injection molding to form an integrated structure. In this implementation, assembly of the switch assembly is facilitated. When the switch assembly is assembled, the operation mechanism and the breaking units may be first installed in the housing body, the pins are pre-integrated with the upper cover through injection molding to form the integrated structure, one end of the pin in the integrated structure is electrically connected and fastened to the breaking unit, and then the upper cover is fastened to the housing body.

In an implementation, the bottom plate includes a bottom plate body and a protrusion plate. The protrusion plate is the thermally conductive contact part. The bottom plate includes the bottom plate body and the protrusion plate. The protrusion plate protrudes from the bottom plate body toward the inverter power assembly and is in thermally conductive connection to the inverter power assembly. Orthographic projections of the protrusion plate and the inverter power assembly on the rear circuit board side at least partially overlap. A part of the cooling fins are located on a side that is of the protrusion plate and that is away from the inverter power assembly. The bus capacitor and the inductor are located between the rear circuit board side and the bottom plate body. A part of the cooling fins are located on a side that is of the bottom plate body and that is away from the rear circuit board side.

In this implementation, the inverter power assembly is a main heat emitting device of the photovoltaic inverter. Therefore, temperature rise control needs to be implemented for the heat emitting device. The cooling fins are located on the side that is of the protrusion plate and that is away from the inverter power assembly in the first direction. The bottom plate body is a part of the bottom plate other than the protrusion plate. Compared with the bottom plate body, the protrusion plate of the bottom plate is closer to the inverter power assembly. This helps shorten the heat transfer path and improve cooling effect. The protrusion plate is in thermally conductive connection to the inverter power assembly. That is, heat can be conducted between the protrusion plate and the inverter power assembly. Therefore, the protrusion plate can implement heat transfer from the inverter power assembly to the cooling fins. The orthographic projections of the protrusion plate and the inverter power assembly on the rear circuit board side at least partially overlap, so that an orthographic projection of a part of the cooling fins corresponding to the protrusion plate on the rear circuit board side also at least partially overlaps an orthographic projection of the inverter power assembly on the rear circuit board side, and the cooling fins can effectively cool the inverter power assembly.

In this implementation, because the protrusion plate protrudes toward the inverter power assembly relative to the bottom plate body, a part of the cooling fins located on the back side of the protrusion plate have a larger length in the first direction, a cooling area of the part of the cooling fins is increased, and cooling effect on the inverter power assembly is improved.

In this implementation, in addition to the protrusion plate, the cooling fins are further distributed on the side that is of the bottom plate body and that is away from the cover plate. The bus capacitor and the inductor in the second device are located between the rear circuit board side and the bottom plate body. A part of the cooling fins are in thermally conductive connection to the bus capacitor and the inductor. Therefore, the part of the cooling fins can cool the bus capacitor and the inductor, and cooling effect of the cooling fins is comprehensively improved.

In this implementation, functions of the protrusion plate are as follows: First, the protrusion plate can shorten the heat transfer path between the inverter power assembly and the cooling fins, and further help increase the cooling area of the cooling fins, so that cooling effect on the inverter power assembly is comprehensively improved. Second, the protrusion plate can further make full use of internal space of the photovoltaic inverter, improve high power density, further help reduce the size of the photovoltaic inverter, and indirectly improve utilization of internal space of the photovoltaic inverter, so that miniaturization design is implemented. Third, the protrusion plate can further provide support for the circuit board, so that structural strength and reliability between the circuit board inside the photovoltaic inverter and the housing are improved. Fourth, in an actual application scenario, the bottom plate is a surface that is of the photovoltaic inverter and that faces the user. Because the bottom plate is not in a field of view of the user at this time, even if the bottom plate presents an uneven shape, overall aesthetics of the photovoltaic inverter is not affected, so that use experience of the user is ensured. If the second device is disposed on the front circuit board side, the protrusion plate needs to be disposed in the cover plate to enhance cooling effect on the inverter power assembly. In this case, because the cover plate is a surface that is of the photovoltaic inverter and that directly faces the user, the cover plate is uneven, causing negative impact on viewing and use experience of the user.

In an implementation, the orthographic projection of the protrusion plate on the rear circuit board side completely covers the orthographic projection of the inverter power assembly on the rear circuit board side. In this implementation, cooling effect of the cooling fins on the inverter power assembly is further improved.

In an implementation, the cooling fins are communicated with an external cooling system. When a cooling medium conveyed by the external cooling system enters the cooling fins, the cooling medium can take away heat generated by the inverter power assembly by contacting the protrusion plate, so that a temperature of the photovoltaic inverter in a steady working state is reduced, and temperature control on the photovoltaic inverter is implemented.

In an implementation, a partial plate surface that is of the bottom plate and that corresponds, in the first direction, to a partial plate surface on which no device is mounted on the rear circuit board side protrudes toward the circuit board. In this solution, vacant space inside the photovoltaic inverter can be further reduced. This facilitates overall layout.

In an implementation, the first direction is perpendicular to the bottom plate. The first direction is the same as the height direction of the photovoltaic inverter. In this implementation, difficulty in installing the switch body and the circuit board, and the circuit board and the housing is reduced.

In an implementation, the second device further includes the direct current conversion assembly. The direct current conversion assembly is fastened to the rear circuit board side. The direct current conversion assembly is located between the protrusion plate and the rear circuit board side. Orthographic projections of the protrusion plate and the direct current conversion assembly on the rear circuit board side at least partially overlap.

In this implementation, the direct current conversion assembly is configured to perform voltage conversion on the direct current transferred to the inverter power assembly, to convert the voltage into the direct current voltage required by the inverter power assembly. In an implementation, the direct current conversion assembly is the direct current voltage boosting assembly. The direct current conversion assembly generates heat in a working state. Therefore, the orthographic projections of the protrusion plate and the direct current conversion assembly on the rear circuit board side at least partially overlap, so that a part of the cooling fins are disposed close to the direct current conversion assembly in the first direction. This helps enhance cooling of the cooling fins on the direct current conversion assembly.

In an implementation, the orthographic projection of the protrusion plate on the rear circuit board side completely covers the orthographic projection of the direct current conversion assembly on the rear circuit board side. In this implementation, cooling effect of the cooling fins on the direct current conversion assembly is further improved.

In an implementation, the protrusion plate includes a first protrusion subboard and a second protrusion subboard. The first protrusion subboard and the second protrusion subboard are spaced. The inverter power assembly is located between the first protrusion subboard and the rear circuit board side. The direct current conversion assembly is located between the second protrusion subboard and the rear circuit board side.

In this implementation, the first protrusion subboard and the second protrusion subboard are spaced. Correspondingly, the inverter power assembly and the direct current conversion assembly are spaced. This helps reduce electromagnetic interference between the inverter power assembly and the direct current conversion assembly, and ensures that working efficiency of the inverter power assembly and the direct current conversion assembly is not affected. Cooling fins corresponding to the first protrusion subboard are configured to cool the inverter power assembly. Cooling fins corresponding to the second protrusion subboard are configured to cool the direct current conversion assembly. The protrusion plate includes the first protrusion subboard and the second protrusion subboard, so that precise cooling of the heat emitting device can be implemented, and cooling efficiency can be improved.

In an implementation, the protrusion plate is of an integrated structure. The inverter power assembly and the direct current conversion assembly are disposed adjacent to each other. In this solution, processing costs of the protrusion plate are reduced, and installation difficulty of the inverter power assembly and the direct current conversion assembly is reduced.

In an implementation, the inverter power assembly includes a plurality of inverter power devices. The direct current conversion assembly includes a plurality of direct current power devices. At least one of the inverter power devices is located between the plurality of direct current power devices. In this implementation, the inverter power devices and the direct current power devices may be flexibly arranged based on a requirement, so that the inverter power assembly and the direct current conversion assembly can be applicable to different application scenarios. In addition, the inverter power devices and the direct current power devices do not need to be separately packaged as a whole, so that an operation procedure and costs can be reduced.

In an implementation, at least one of the direct current power devices is located between the plurality of inverter power devices. In this implementation, the inverter power devices and the direct current power devices may be flexibly arranged based on a requirement, so that the inverter power assembly and the direct current conversion assembly can be applicable to different application scenarios. In addition, the inverter power devices and the direct current power devices do not need to be separately packaged as a whole, so that an operation procedure and costs can be reduced.

In an implementation, the inverter power assembly is an inverter power module. The inverter power module includes an inverter packaging structure and a plurality of inverter power devices located in the inverter packaging structure. The direct current conversion assembly is a direct current conversion module. The direct current conversion module includes a direct current packaging structure and a plurality of direct current power devices located in the direct current packaging structure. In this implementation, the plurality of inverter power devices are packaged into the inverter packaging structure, and the plurality of direct current power devices are packaged into the direct current packaging structure, so that the inverter power assembly and the direct current conversion assembly are highly integrated, and the plurality of inverter power devices are installed on the rear circuit board side as a whole. This reduces installation difficulty.

In an implementation, a thermally conductive medium is disposed between the inverter power assembly and the protrusion plate, and heat generated when the inverter power assembly works is transferred to a part of the cooling fins on one side of the protrusion plate through the thermally conductive medium. In this solution, cooling effect is enhanced.

In an implementation, a positioning part is disposed on a surface that is of the switch body and that faces the circuit board. The positioning part and the pins are spaced. The positioning part is configured to perform auxiliary positioning when the switch body is fastened to the circuit board.

In this implementation, the positioning part and the pins are spaced, so that interference to electrical connection is avoided. Positioning parts are dispersedly arranged on the surface that is of the switch body and that faces the circuit board, so that the positioning parts assist in positioning the switch body more accurately. In this solution, the positioning parts are disposed on the switch body, so that connection operation between the switch body and the circuit board is more convenient.

According to a second aspect, this application provides a photovoltaic system. The photovoltaic system includes at least one of the following: a photovoltaic module, a photovoltaic optimizer, a combiner box, a box-type transformer, a power sensor, an energy storage system, an on-grid/off-grid controller, and a smart array controller, and includes the photovoltaic inverter according to any implementation of the first aspect. An input end of the photovoltaic inverter is configured to electrically connect to the photovoltaic module. An output end of the photovoltaic inverter is configured to connect to a power grid. The photovoltaic inverter is configured to convert a direct current from the photovoltaic module into an alternating current, and transfer the alternating current to the power grid.

In an implementation, the photovoltaic system includes the photovoltaic module, the photovoltaic optimizer, the photovoltaic inverter, the energy storage system, the on-grid/off-grid controller, and the power sensor. The photovoltaic optimizer is installed on the photovoltaic module. The photovoltaic module is configured to convert light energy into electric energy. The photovoltaic optimizer is configured to improve power generation efficiency of the photovoltaic module. The photovoltaic module is electrically connected to the photovoltaic inverter. The photovoltaic module transfers the direct current to the photovoltaic inverter. The photovoltaic inverter is electrically connected to the energy storage system and the on-grid/off-grid controller. The photovoltaic inverter has a direct current conversion function module. The direct current conversion function module of the photovoltaic inverter may be configured to convert the direct current generated by the photovoltaic inverter into a voltage required for energy storage of the energy storage system, and transfer the voltage to the energy storage system for energy storage. The photovoltaic inverter may convert the direct current provided by the photovoltaic module into the alternating current, and transfer the alternating current to the on-grid/off-grid controller. The on-grid/off-grid controller is electrically connected to an electrical device, and may also be electrically connected to the power grid. In an actual application scenario, the on-grid/off-grid controller has an off-grid state and an on-grid state. When the on-grid/off-grid controller is in the off-grid state, there is no electrical connection relationship between the on-grid/off-grid controller and the power grid, and the alternating current transferred by the photovoltaic inverter is provided only for the electrical devices. The electric device includes a household appliance, for example, a television set, a refrigerator, a washing machine, and the like. When the on-grid/off-grid controller is in the on-grid state, the on-grid/off-grid controller is electrically connected to the power grid through the power sensor. When the electric energy generated by the photovoltaic module cannot meet a power consumption requirement of the electric device, the power grid may supply electric energy to the photovoltaic system through the on-grid/off-grid controller. When an energy yield of the photovoltaic module exceeds power used by the electric device, the on-grid/off-grid controller may transfer excess power to the power grid. The power sensor is configured to measure a power flow status between the photovoltaic system and the power grid.

In an implementation, the photovoltaic system includes the photovoltaic module, the photovoltaic optimizer, the combiner box, the photovoltaic inverter, the box-type transformer, the energy storage system, and the smart array controller. The photovoltaic optimizer is installed on the photovoltaic module. The photovoltaic module is configured to convert light energy into electric energy. The photovoltaic optimizer is configured to improve power generation efficiency of the photovoltaic module. The photovoltaic system may include a plurality of photovoltaic modules and photovoltaic optimizers. Each of the plurality of photovoltaic modules is electrically connected to one photovoltaic inverter. The photovoltaic inverter is connected to the energy storage system, and is configured to store a direct current generated through photovoltaic inversion. The combiner box is an alternating current combiner box. The alternating current combiner box is configured to converge and transfer alternating currents generated by the plurality of photovoltaic inverters to the box-type transformer. The box-type transformer is configured to convert a voltage of the alternating currents generated by the photovoltaic inverters, and then transfer the voltage to the power grid through a power distribution room. Signals are transmitted between the smart array controller and the combiner box and between the smart array controller and the box-type transformer. The smart array controller is configured to implement communication control for the photovoltaic system.

### BRIEF DESCRIPTION OF DRAWINGS

To describe technical solutions in embodiments of this application more clearly, the following describes the accompanying drawings used in embodiments of this application.
FIG. 1 is a diagram of a structure of a photovoltaic system applied to a home power station according to an embodiment of this application;
FIG. 2 is a diagram of a structure of a photovoltaic system applied to an industrial photovoltaic power station according to an embodiment of this application;
FIG. 3 is a diagram of a structure of a photovoltaic module and a photovoltaic inverter according to an embodiment of this application;
FIG. 4 is a diagram of a structure of a photovoltaic inverter according to an embodiment of this application;
FIG. 5 is a front view of a photovoltaic inverter according to an embodiment of this application;
FIG. 6 is a front view of a photovoltaic inverter without a cover plate according to an embodiment of this application;
FIG. 7 is an AA cross-sectional view of the photovoltaic inverter shown in FIG. 6;
FIG. 8 is a diagram of a structure of a switch assembly according to an embodiment of this application;
FIG. 9 is a diagram of a structure of a breaking unit according to an embodiment of this application;
FIG. 10 is a diagram of a structure of a switch assembly and a circuit board according to an embodiment of this application;
FIG. 11 is a diagram of a structure of a breaking unit according to an embodiment of this application;
FIG. 12 is a diagram of a partial structure of a photovoltaic inverter according to an embodiment of this application;
FIG. 13 is a diagram of a structure of a photovoltaic inverter according to an embodiment of this application;
FIG. 14 is a cross-sectional view of a photovoltaic inverter according to an embodiment of this application;
FIG. 15 is a diagram of a structure of a switch body and a circuit board according to an embodiment of this application;
FIG. 16 is a diagram of a structure of a switch body and a circuit board according to an embodiment of this application;
FIG. 17 is a diagram of a structure of a switch body and a circuit board according to an embodiment of this application;
FIG. 18 is a diagram of a structure of a switch body and a circuit board according to an embodiment of this application;
FIG. 19 is a diagram of a structure of a switch body and a circuit board according to an embodiment of this application;
FIG. 20 is a diagram of a structure of a switch body and a circuit board according to an embodiment of this application;
FIG. 21 is a diagram of a structure of a switch body and a circuit board according to an embodiment of this application;
FIG. 22 is a diagram of a structure of a switch body and a circuit board according to an embodiment of this application;
FIG. 23 is a cross-sectional view of a photovoltaic inverter according to an embodiment of this application;
FIG. 24 is a diagram of electrical connection of a photovoltaic inverter according to an embodiment of this application;
FIG. 25 is a cross-sectional view of a photovoltaic inverter according to an embodiment of this application;
FIG. 26 is a diagram of a partial structure of a photovoltaic inverter according to an embodiment of this application;
FIG. 27 is a diagram of a partial structure of a photovoltaic inverter according to an embodiment of this application;
FIG. 28 is a cross-sectional view of a photovoltaic inverter according to an embodiment of this application;
FIG. 29 is a diagram of a partial structure of a photovoltaic inverter according to an embodiment of this application;
FIG. 30 is a partial enlarged diagram of the photovoltaic inverter shown in FIG. 29;
FIG. 31 is a front view of a photovoltaic inverter according to an embodiment of this application;
FIG. 32 is a diagram of a partial structure of a photovoltaic inverter according to an embodiment of this application;
FIG. 33 is an enlarged view of an M part in FIG. 32;
FIG. 34 is a diagram of a partial structure of a photovoltaic inverter according to an embodiment of this application;
FIG. 35 is a diagram of a structure of an insulation support and a PV port in a photovoltaic inverter according to an embodiment of this application;
FIG. 36 is a diagram of a structure of an insulation support and a PV port in a photovoltaic inverter according to an embodiment of this application;
FIG. 37 is a diagram of a structure of a part including an insulation support and a filter circuit board in a photovoltaic inverter according to an embodiment of this application;
FIG. 38 is a diagram of a structure of a part including an insulation support and a filter circuit board in a photovoltaic inverter according to an embodiment of this application;
FIG. 39 is an exploded diagram of a part including an insulation support and a filter circuit board in a photovoltaic inverter according to an embodiment of this application;
FIG. 40 is a diagram of a partial structure of a photovoltaic inverter according to an embodiment of this application; and
FIG. 41 is a top view of a switch body according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, position terms such as "top" and "bottom" are defined relative to positions of structures in the accompanying drawings. It should be understood that these position terms are relative concepts used for relative description and clarification, and may correspondingly change according to changes in the positions of the structures.

For ease of understanding, the following first explains and describes related technical terms and English abbreviations in embodiments of this application.

Photovoltaic inverter: An inverter is a converter that converts a direct current into a constant-frequency and constant-voltage or frequency-modulated and voltage-modulated alternating current. The photovoltaic inverter is an inverter that converts a variable direct current voltage generated by a solar panel (also referred to as a photovoltaic panel) into a mains-frequency alternating current.

Parallelism: Parallelism defined in this application is not limited to absolute parallelism. A definition of the parallelism may be understood as basic parallelism, and a case in which the absolute parallelism is not caused by factors such as an assembly tolerance, a design tolerance, and a structural flatness is allowed.

Perpendicularity: Perpendicularity defined in this application is not limited to an absolute perpendicular intersection (an included angle is 90 degrees) relationship, a case in which an absolute perpendicular intersection relationship is not caused by factors such as an assembly tolerance, a design tolerance, and a structural flatness is allowed, and an error within a small angle range is allowed. For example, a relationship within an assembly error range of 80 degrees to 100 degrees may be understood as the perpendicular relationship.

PV: short for photovoltaic, and using solar energy to generate electricity. A PV port is a port connected to a photovoltaic module.

OT terminal: also referred to as a round cold-pressed terminal. With a round head, a cylindrical tail, and an appearance of an OT form, the terminal is referred to as the OT terminal in the industry.

An embodiment of this application provides a photovoltaic inverter, including a housing, a circuit board, cooling fins, a switch assembly, and a plurality of PV ports. The housing includes a bottom housing and a cover plate. The bottom housing and the cover plate enclose an accommodating cavity. The bottom housing includes a bottom plate disposed opposite to the cover plate.

The circuit board includes a front circuit board side and a rear circuit board side that are disposed opposite to each other in a first direction. Metal traces are disposed on the circuit board. The front circuit board side faces the cover plate. The rear circuit board side faces the bottom plate. The circuit board is fastened in the accommodating cavity of the housing, and partitions the accommodating cavity into a first subcavity and a second subcavity. The first subcavity is located between the front circuit board side and the cover plate. The second subcavity is located between the rear circuit board side and the bottom plate. A volume of the first subcavity is less than a volume of the second subcavity. The first subcavity and the second subcavity accommodate a first device and a second device respectively. An operating heat dissipation amount of the second device is greater than an operating heat dissipation amount of the first device, or a length of the second device in the first direction is greater than a length of the first device in the first direction. The first device includes a surface mount resistor and a surface mount capacitor that are fastened to the front circuit board side. The second device includes an inverter power assembly, a bus capacitor, and an inductor that are fastened to the rear circuit board side.

The cooling fins are located on a side that is of the bottom plate and that is away from the cover plate. A thermally conductive contact part is disposed on a side that is of the inverter power assembly and that is away from the circuit board. The inverter power assembly is in thermally conductive connection to a part of the cooling fins through the thermally conductive contact part. The bus capacitor and the inductor are located on a circumferential side of the thermally conductive contact part.

The switch assembly includes a knob, a connecting rod, and a switch body. The knob and the switch body are located on an outer side and an inner side of the housing respectively. The knob is connected to the switch body through the connecting rod. The switch body is located in the second subcavity. The switch body is connected to the circuit board. The switch body includes a plurality of breaking units. An arrangement direction of the plurality of breaking units is the same as an arrangement direction of the knob and the switch body. Each breaking unit includes pins. The pins of each breaking unit are both rigidly fastened to the rear circuit board side.

One end of the PV port is located inside the housing and is connected to the circuit board, and the other end of the PV port passes through the housing and extends to the outer side of the housing.

The PV ports are connected to some pins of the switch body through the metal traces of the circuit board. Some pins of the switch body are connected to the bus capacitor through the metal traces of the circuit board. The bus capacitor is connected to the inverter power assembly through the metal traces of the circuit board.

In the photovoltaic inverter provided in this embodiment of this application, the circuit board is reversely fastened in the photovoltaic inverter, and the inverter power assembly is fastened to the rear circuit board side. This helps balance cooling effect and a product beauty. The switch body is rigidly fastened to the rear circuit board side through the pins, so that cable connection can be avoided, a cable connection fault can be avoided, and assembly difficulty of the photovoltaic inverter can be reduced.

The photovoltaic inverter provided in this embodiment of this application may be used in a photovoltaic system. The photovoltaic system including the photovoltaic inverter in this application may be used in two application scenarios: a home power station and an industrial photovoltaic power station.

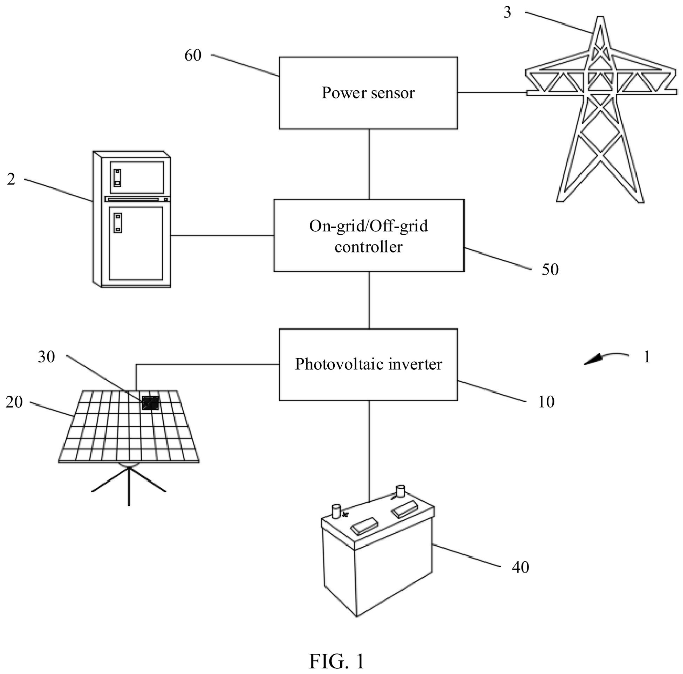

Refer to FIG. 1. FIG. 1 is a diagram of a structure of a photovoltaic system 1 applied to a home power station according to an embodiment of this application. In an implementation, the photovoltaic system 1 includes a photovoltaic module 20, a photovoltaic optimizer 30, a photovoltaic inverter 10, an energy storage system 40, an on-grid/off-grid controller 50, and a power sensor 60.

The photovoltaic optimizer 30 is installed on the photovoltaic module 20. The photovoltaic module 20 is configured to convert light energy into electric energy. The photovoltaic optimizer 30 is configured to improve power generation efficiency of the photovoltaic module 20. The photovoltaic optimizer 30 is a module-level power electronic device with direct current input and direct current output. Through connection to the photovoltaic module 20 in series, by using a current and voltage prediction technology, it is ensured that the module is always in an optimal working state. According to a working principle of a buck topology, impact of shading, inconsistent directions, or differences in electrical specifications of modules on an energy yield of a photovoltaic plant is resolved, maximum power output of the modules is implemented, and the energy yield of the system is improved.

The photovoltaic module 20 is electrically connected to the photovoltaic inverter 10. The photovoltaic module 20 transfers a direct current to the photovoltaic inverter 10. The photovoltaic inverter 10 is electrically connected to the energy storage system 40 and the on-grid/off-grid controller 50.

In an implementation, the photovoltaic inverter 10 has a direct current conversion function module. The direct current conversion function module of the photovoltaic inverter 10 may be configured to convert the direct current generated by the photovoltaic inverter into a voltage required for energy storage of the energy storage system 40, and transfer the voltage to the energy storage system 40 for energy storage.

In an implementation, the photovoltaic inverter 10 may convert the direct current provided by the photovoltaic module 20 into the alternating current, and transfer the alternating current to the on-grid/off-grid controller 50. The on-grid/off-grid controller 50 is electrically connected to an electric device 2, and may also be electrically connected to a power grid 3. In an actual application scenario, the on-grid/off-grid controller 50 has an off-grid state and an on-grid state.

When the on-grid/off-grid controller 50 is in the off-grid state, there is no electrical connection relationship between the on-grid/off-grid controller 50 and the power grid 3, and the alternating current transferred by the photovoltaic inverter 10 is provided only for the electric device 2. The electric device 2 includes a household appliance, for example, a television set, a refrigerator, a washing machine, and the like.

When the on-grid/off-grid controller 50 is in the on-grid state, the on-grid/off-grid controller 50 is electrically connected to the power grid 3 through the power sensor 60. When the electric energy generated by the photovoltaic module 20 cannot meet a power consumption requirement of the electric device 2, the power grid 3 may supply electric energy to the photovoltaic system 1 through the on-grid/off-grid controller 50. When an energy yield of the photovoltaic module 20 exceeds power used by the electric device 2, the on-grid/off-grid controller 50 may transfer excess power to the power grid 3. The power sensor 60 is configured to measure a power flow status between the photovoltaic system 1 and the power grid 3. For example, the power sensor 60 may be an electric meter.

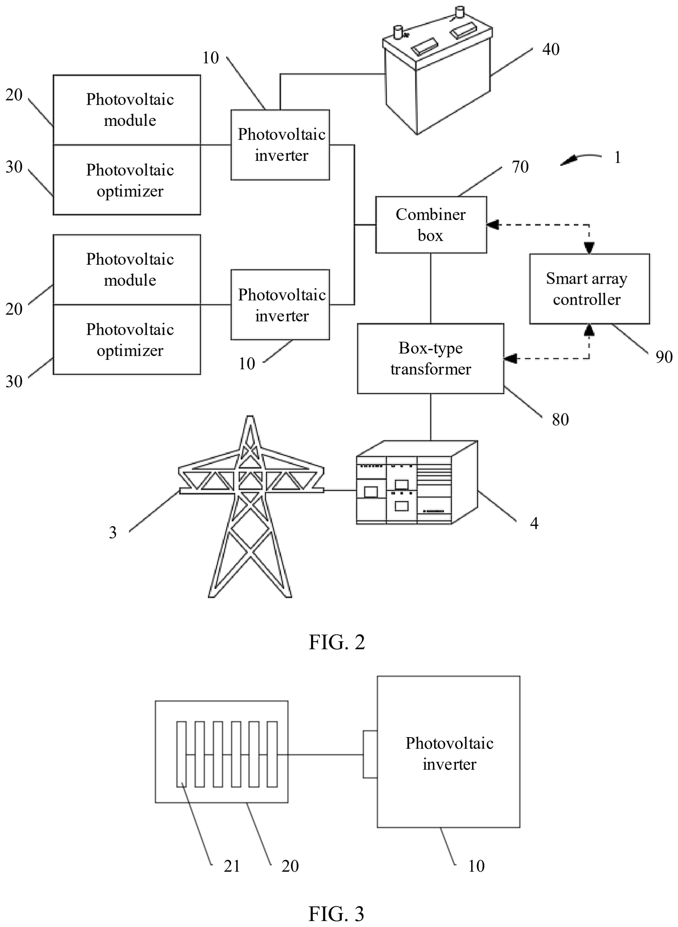

Refer to FIG. 2. FIG. 2 is a diagram of a structure of a photovoltaic system 1 applied to an industrial photovoltaic power station according to an embodiment of this application. In an implementation, the photovoltaic system 1 includes a photovoltaic module 20, a photovoltaic optimizer 30, a combiner box 70, a photovoltaic inverter 10, a box-type transformer 80, an energy storage system 40, and a smart array controller 90.

The photovoltaic optimizer 30 is installed on the photovoltaic module 20. The photovoltaic module 20 is configured to convert light energy into electric energy. The photovoltaic optimizer 30 is configured to improve power generation efficiency of the photovoltaic module 20.

In some implementations, the photovoltaic system 1 may include a plurality of photovoltaic modules 20 and photovoltaic optimizers 30. Each of the plurality of photovoltaic modules 20 is electrically connected to one photovoltaic inverter 10.

In an implementation, the photovoltaic inverter 10 is connected to the energy storage system 40, and is configured to store a direct current generated by the photovoltaic inverter 10. In an implementation, a direct current combiner box (not shown in FIG. 2) exists between the plurality of photovoltaic inverters 10 and the energy storage system 40, and is configured to converge and transfer direct currents generated by the plurality of photovoltaic inverters 10 to the energy storage system 40 for storage. It may be understood that a direct current conversion function module that can convert a direct current generated by the photovoltaic module 20 into a direct current that can be stored by the energy storage system 40 may be disposed in the photovoltaic inverter 10.

The combiner box 70 shown in FIG. 2 is an alternating current combiner box. The alternating current combiner box is configured to converge and transfer alternating currents generated by the plurality of photovoltaic inverters 10 to the box-type transformer 80. The box-type transformer 80 is configured to convert a voltage of the alternating currents generated by the photovoltaic inverters 10, and then transfer the voltage to the power grid 3 through a power distribution room 4. Signals are transmitted (shown by dashed lines in FIG. 2) between the smart array controller 90 and at least one of the following: the combiner box 70, the box-type transformer 80, the photovoltaic inverters 10, and an environment monitoring instrument (not shown in the figure). The smart array controller 90 is configured to implement communication control on the photovoltaic system 1.

It should be noted that FIG. 1 and FIG. 2 merely schematically show application scenarios of the photovoltaic system 1 in the home power station and the industrial photovoltaic power station, and do not represent structures, sizes, and a position relationship of internal devices of the photovoltaic system 1. A person skilled in the art may make adjustments based on an actual requirement.

In an implementation, the photovoltaic system 1 includes at least one of the following: a photovoltaic module 20, a photovoltaic optimizer 30, a combiner box 70, a box-type transformer 80, a power sensor 60, an energy storage system 40, an on-grid/off-grid controller 50, and a smart array controller 90, and includes a photovoltaic inverter 10. A user may use the photovoltaic inverter 10 in combination with at least one of the following: the photovoltaic module 20, the photovoltaic optimizer 30, the combiner box 70, the box-type transformer 80, the power sensor 60, the energy storage system 40, the on-grid/off-grid controller 50, and the smart array controller 90 based on a requirement.

For example, the photovoltaic module 20 and the photovoltaic inverter 10 may be combined as a whole for use, and then the whole combination of the photovoltaic module 20 and the photovoltaic inverter 10 is used together with any one of the foregoing devices. Refer to FIG. 3. FIG. 3 is a diagram of a structure of the photovoltaic module 20 and the photovoltaic inverter 10 according to an embodiment of this application. In an implementation, the photovoltaic module 20 includes at least one photovoltaic panel 21. The photovoltaic panel 21 is connected to the photovoltaic inverter 10. In an implementation, the photovoltaic module 20 includes a plurality of photovoltaic panels 21 connected in series. Direct currents of the plurality of photovoltaic panels 21 are converged in a serial connection manner and then connected to the photovoltaic inverter 10.

For example, the energy storage system 40 and the photovoltaic inverter 10 are combined as an entire photovoltaic system and used together with any one of the foregoing devices.

In an implementation, the photovoltaic inverter 10 includes a housing, a circuit board, and a switch assembly (not shown in FIG. 1 and FIG. 2). The switch assembly is configured to control connection and disconnection between the photovoltaic inverter 10 and the photovoltaic module 20. In a scenario such as replacing or repairing the photovoltaic inverter 10, the switch assembly needs to be used to control disconnection and electrical connection between the photovoltaic module 20 and the photovoltaic inverter 10, to avoid device damage caused by a short circuit. In the photovoltaic inverter 10, a switch assembly 300 is fastened to a housing 100. If the switch assembly 300 is electrically connected to a circuit board 200 (not shown in FIG. 1) through cables, a large quantity of internal connection cables exist in the photovoltaic inverter 10, installation is complex, and a cable connection fault is easily caused. In addition, if devices with a large size or devices with a large heat dissipation amount are fastened to the front circuit board side, cooling effect on these devices is poor, and use efficiency of the photovoltaic inverter 10 is affected.

However, in this application, in the photovoltaic inverter 10, the circuit board is reversely fastened in the housing, and the devices with the large size or the devices with the large heat dissipation amount such as the inverter power assembly, the capacitor, the inductor, and the switch assembly are rigidly fastened to the rear circuit board side, so that internal wiring can be reduced, and installation and maintenance of the photovoltaic inverter 10 are facilitated, safety of the photovoltaic inverter 10 is improved, and cooling effect can be improved.

The following describes in detail the photovoltaic inverter 10 provided in this embodiment of this application.

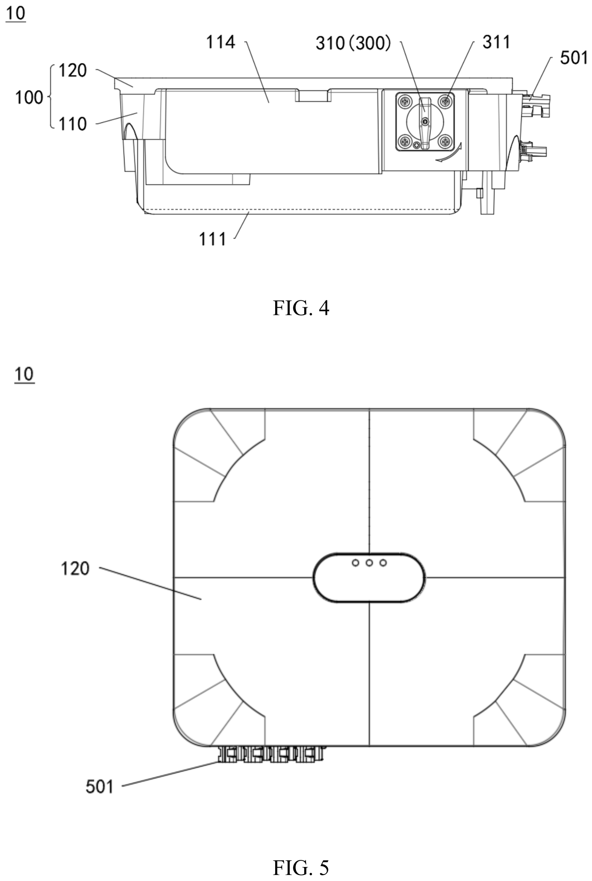

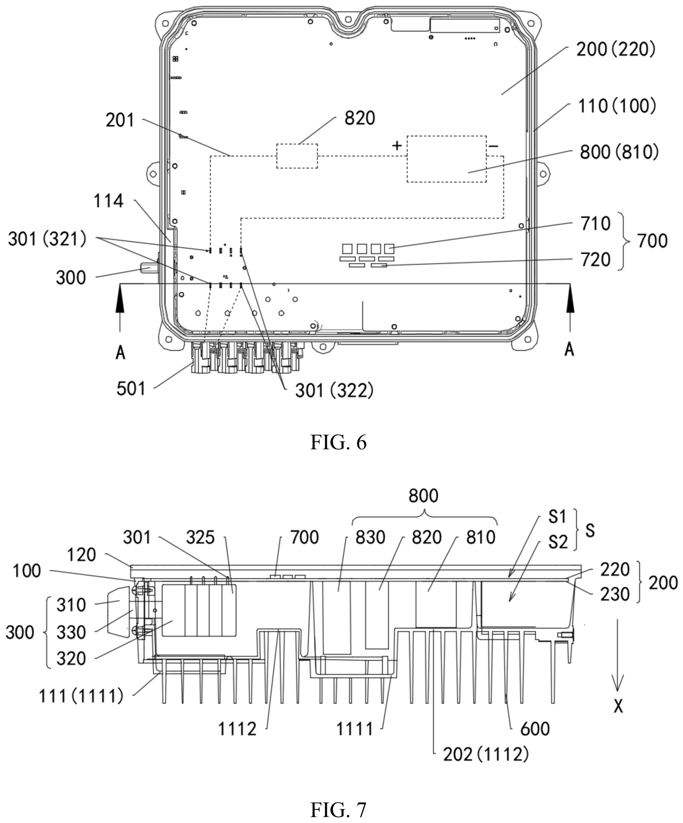

Refer to FIG. 4 to FIG. 7. FIG. 4 is a diagram of a structure of the photovoltaic inverter 10 according to an embodiment of this application. FIG. 5 is a front view of the photovoltaic inverter 10 according to an embodiment of this application. FIG. 6 is a front view of the photovoltaic inverter 10 without a cover plate according to an embodiment of this application. FIG. 7 is an AA partial cross-sectional view of the photovoltaic inverter 10 shown in FIG. 6.

In an implementation, the photovoltaic inverter 10 includes a housing 100, a circuit board 200, cooling fins 600, a switch assembly 300, and a plurality of PV ports 501 (as shown in FIG. 4 and FIG. 7). The housing 100 includes a bottom housing 110 and a cover plate 120 (as shown in FIG. 4 and FIG. 5). The bottom housing 110 and the cover plate 120 enclose an accommodating cavity S (as shown in FIG. 7). The bottom housing 110 includes a bottom plate 111 (as shown in FIG. 4) disposed opposite to the cover plate 120.

In this implementation, the bottom housing 110 is of a groove-shaped structure. The bottom housing 110 and the cover plate 120 enclose the accommodating cavity S (as shown in FIG. 7). The accommodating cavity S in the housing 100 is configured to protect the circuit board 200 and protect the switch assembly 300, the first device 700, and the second device 800 (as shown in FIG. 7) that are fastened to the circuit board 200. Because the circuit board 200 is fixedly connected to the housing 100, the switch assembly 300, the first device 700, and the second device 800 are fastened to the housing 100. When an external environment exerts an external force on the photovoltaic inverter 10, the switch assembly 300, the first device 700, and the second device 800 are fastened to the housing 100 and therefore are not prone to displacement relative to the housing 100. This helps improve stability of an overall structure of the photovoltaic inverter 10, and enables the photovoltaic inverter 10 to work in a stable state.

Still refer to FIG. 6 and FIG. 7. The circuit board 200 includes a front circuit board side 220 and a rear circuit board side 230 that are disposed opposite to each other in a first direction X. Metal traces 201 are disposed on the circuit board 200. A position shown by 201 in FIG. 6 is only used to identify the metal traces 201 of the circuit board 200, and does not represent an actual position of the metal traces 201. It should be understood that, in this application, the metal traces 201 of the circuit board 200 may be routed according to functional devices in the photovoltaic inverter 10, to implement a function of the photovoltaic inverter 10.

The front circuit board side 220 faces the cover plate 120 (as shown in FIG. 7). The rear circuit board side 230 faces the bottom plate 111. The circuit board 200 is fastened in the accommodating cavity S of the housing 100, and partitions the accommodating cavity S into a first subcavity S1 and a second subcavity S2. The first subcavity S1 is located between the front circuit board side 220 and the cover plate 120. The second subcavity S2 is located between the rear circuit board side 230 and the bottom plate 111. A volume of the first subcavity S1 is less than a volume of the second subcavity S2. The first subcavity S1 and the second subcavity S2 accommodate the first device 700 and the second device 800 respectively. An operating heat dissipation amount of the second device 800 is greater than an operating heat dissipation amount of the first device 700, or a length of the second device 800 in the first direction X is greater than a length of the first device 700 in the first direction X. The first device 700 includes a surface mount resistor 710 and a surface mount capacitor 720 (as shown in FIG. 6) that are fastened to the front circuit board side 220. The second device 800 includes an inverter power assembly 810, a bus capacitor 820, and an inductor 830 (as shown in FIG. 7) that are fastened to the rear circuit board side 230.

In this implementation, the circuit board 200 includes the front circuit board side 220 and the rear circuit board side 230 that are disposed opposite to each other in the first direction X. The front circuit board side 220 is a surface that is of the circuit board 200 and that is directly presented to the user after the user opens the cover plate 120. As shown in FIG. 5 and FIG. 6, FIG. 5 shows a diagram of installation of the photovoltaic inverter 10. When the user needs to open the cover plate 120, the cover plate 120 faces the user, and an indicator is disposed on the cover plate 120, as shown in a part in which a middle runway shape is located in FIG. 5. When the user opens the cover plate 120, a diagram presented in front of the user is shown in FIG. 6, and the front circuit board side 220 faces the user.

In this implementation, the front circuit board side 220 and the cover plate 120 enclose the first subcavity S1 (as shown in FIG. 7). The first subcavity S1 is configured to accommodate the first device 700. The rear circuit board side 230 and the bottom plate 111 enclose the second subcavity S2. The second subcavity S2 is configured to accommodate the second device 800. The volume of the first subcavity S1 is less than the volume of the second subcavity S2, to adapt to a size relationship between the first device 700 and the second device 800. In an implementation, the first device 700 further includes a diode.

In an implementation, the surface mount resistor 710 of the first device 700 is configured to limit a current in a circuit and resist interference and noise of the circuit. The surface mount capacitor 720 is configured to store a charge. The inverter power assembly 810 in the second device 800 is configured to convert a direct current into an alternating current. In an implementation, the bus capacitor 820 plays a role of storing and smoothing a direct current voltage. In an implementation, the purpose of the inductor 830 includes at least one of the following: filtering, direct current conversion, and power conversion. In an implementation, the inductor 830 in the second device 800 includes at least one of the following: a filter inductor, an inductor in a direct current conversion assembly, and an inductor in the inverter power assembly 810.

Still refer to FIG. 7. In this implementation, the cooling fins 600 are located on a side that is of the bottom plate 111 and that is away from the cover plate 120. A thermally conductive contact part 202 is disposed on a side that is of the inverter power assembly 810 and that is away from the circuit board 200. The inverter power assembly 810 is in thermally conductive connection to a part of the cooling fins 600 through the thermally conductive contact part 202. The bus capacitor 820 and the inductor 830 are located on a circumferential side of the thermally conductive contact part 202.

The inverter power assembly 810 is a main heat emitting device of the photovoltaic inverter 10. Therefore, temperature rise control needs to be implemented for the heat emitting device. The inverter power assembly 810 is in thermally conductive connection to the part of the cooling fins 600 through the thermally conductive contact part 202. This helps shorten a heat transfer path and improve cooling effect. The bus capacitor 820 and the inductor 830 are located on the circumferential side of the thermally conductive contact part 202, or located on a circumferential side of the inverter power assembly 810. The bus capacitor 820 and the inductor 830 may be in thermally conductive connection to the cooling fins 600 through the bottom plate 111. The thermally conductive contact part 202 may further absorb heat of the bus capacitor 820 and the inductor 830 from the circumferential side. This improves cooling effect. In an implementation, the thermally conductive contact part 202 may be a part of the bottom plate 111, or may be a thermally conductive structure located between the bottom plate 111 and the inverter power assembly 810.

In an implementation, the cooling fins 600 are communicated with an external cooling system. When a cooling medium conveyed by the external cooling system enters the cooling fins 600, the cooling medium can take away heat generated by the inverter power assembly 810 by using the cooling fins 600 and the thermally conductive contact part 202, so that a temperature of the photovoltaic inverter 10 in a steady working state is reduced, and temperature control on the photovoltaic inverter 10 is implemented.

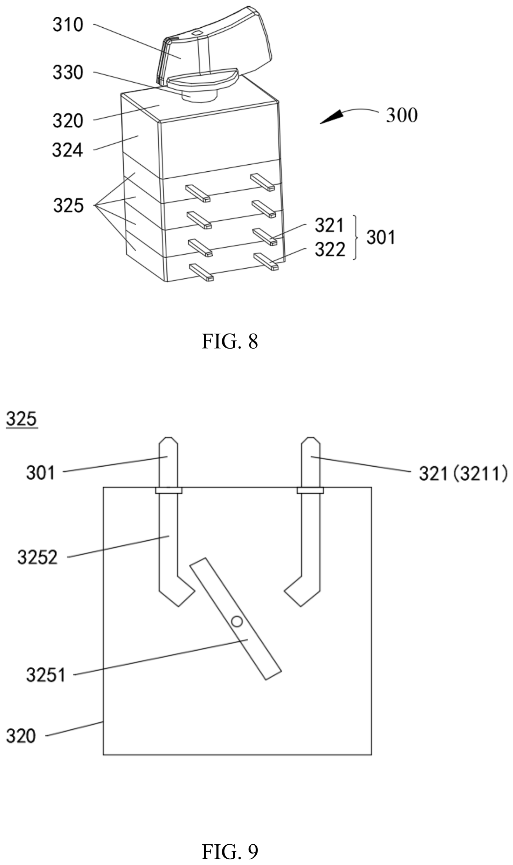

Refer to FIG. 7 and FIG. 8. FIG. 8 is a diagram of a structure of the switch assembly 300 according to an embodiment of this application. The switch assembly 300 includes a knob 310, a connecting rod 330, and a switch body 320. The knob 310 and the switch body 320 are located on an outer side and an inner side of the housing 100 respectively (as shown in FIG. 7). The knob 310 is connected to the switch body 320 through the connecting rod 330 (as shown in FIG. 7). The switch body 320 is located in the second subcavity S2 (as shown in FIG. 7). The switch body 320 is connected to the circuit board 200. The switch body 320 includes a plurality of breaking units 325 (as shown in FIG. 8). An arrangement direction of the plurality of breaking units 325 is the same as an arrangement direction of the knob 310 and the switch body 320. Each breaking unit 325 includes pins 301. The pins 301 of each breaking unit 325 are both rigidly fastened to the rear circuit board side 230 (as shown in FIG. 7 and FIG. 8).

In this implementation, both the switch body 320 and the second device 800 are located in the second subcavity S2. The switch body 320 is fastened to the rear circuit board side 230. The pins 301 are rigidly fastened to the rear circuit board side 230, so that the switch body 320 is fastened and electrically connected to the rear circuit board side 230. Rigid fastening means that the pins 301 cannot rotate or move relative to the circuit board 200. In a process in which the switch body 320 is fastened to the rear circuit board side 230, generally the switch body 320 needs to be fastened to the bottom housing 110 through the connecting rod 330, and then the circuit board 200 is connected to the switch body 320. Because the rear circuit board side 230 is a surface that is of the circuit board 200 and that is away from an operator, it is inconvenient for the operator to directly observe the rear circuit board side 230. In addition, the second device 800 has been installed on the rear circuit board side 230. In this application, the switch body 320 is fastened to the rear circuit board side 230 in a rigid connection manner. For example, the pins 301 may be directly inserted into the rear circuit board side 230 and rigidly fastened to the rear circuit board side 230. In the rigid connection manner, installation difficulty can be reduced, and contact resistance and a heat dissipation amount between the switch body 320 and the circuit board 200 can be reduced.

In an implementation, in a process of assembling the photovoltaic inverter 10, the switch body 320 is inserted into the rear circuit board side 230 through the pins and fastened to the circuit board 200, the circuit board 200 and the switch body 320 are simultaneously placed on an inner side of the bottom housing 110, the rear circuit board side 230 having the switch body 320 faces the bottom plate 111, and then the connecting rod 330 in the switch assembly 300 passes through the bottom housing 110 from an outer side of the bottom housing 110 and is inserted into the switch body 320, so that the connecting rod 330 is fastened to movable contacts in the switch body 320, the connecting rod 330 can drive the movable contacts in the switch body 320 to rotate, and then the knob 310 is installed at one end that is of the connecting rod 330 and that is located on the outer side of the bottom housing 110. Alternatively, in an implementation, after the circuit board 200 and the switch body 320 are simultaneously placed on the inner side of the bottom housing 110, one end of the knob 310 and one end of the connecting rod 330 are fastened in advance, and then the other end of the connecting rod 330 passes through the bottom housing 110 and is inserted into the switch body 320 and fastened to the movable contacts in the switch body 320.

In an implementation, a protrusion part (not shown in the figure) is disposed on a side that is of the switch body 320 and that faces the knob 310, and projections of the switch body 320 and the protrusion part in the first direction X are both located in the bottom plate 111, so that in the process of assembling the photovoltaic inverter 10, the switch body 320, the protrusion part, and the circuit board 200 may be smoothly placed on the inner side of the bottom housing 110. A connection cylinder (not shown in the figure) is disposed on a side that is of the knob 310 and that faces the switch body 320. When the knob 310 is assembled on the outer side of the bottom housing 110, the connection cylinder passes through the bottom housing 110 and is directly in inserted connection to the protrusion part, and the protrusion part is inserted into the connection cylinder and is fastened to the connection cylinder, so that the knob 310 can drive the movable contacts in the switch body 320 to rotate when rotating. It should be noted that structural forms of the protrusion part and the connection cylinder are not limited, provided that the connection cylinder and the protrusion part can be fastened when the knob 310 is aligned with the switch body 320, so that the knob 310 can drive the movable contacts in the switch body 320.

A connection manner different from rigid connection is flexible connection. For example, flexible connection may be cable connection, and cables may rotate or move relative to the circuit board 200. If the breaking units 325 of the switch body 320 are flexibly connected to the circuit board 200 through the cables, cable arrangement inside the photovoltaic inverter 10 is disordered. In addition, because the cables may move relative to the circuit board 200, if the switch body 320 is fastened to the rear circuit board side 230 through the cables, positioning and installation are difficult, and problems of low operation efficiency and poor connection are easily caused. In addition, both ends of the cable generally need to be connected to the rear circuit board side 230 and the switch body 320 through OT terminals respectively, so that contact resistance and a heat dissipation amount of the entire loop increase, and efficiency of an entire machine decreases.

In this implementation, the switch body 320 and the second device 800 are jointly fastened to the rear circuit board side 230. That is, devices with a large size or a large length in the first direction X are arranged on the rear circuit board side 230 in a centralized manner. Compared with arranging the switch body 320 and the second device 800 on the front circuit board side 220 and the rear circuit board side 230 in a distributed manner, in this implementation, an overall length of the photovoltaic inverter 10 in the first direction X can be reduced, so that a size of the photovoltaic inverter 10 is small. This facilitates overall layout of the photovoltaic system.

In an implementation, the first direction X is perpendicular to the bottom plate 111. The first direction X is the same as a height direction of the photovoltaic inverter 10. In this implementation, difficulty in installing the switch body 320 and the circuit board 200, and the circuit board 200 and the housing 100 is reduced.

One end of the PV port 501 is located inside the housing 100 and is connected to the circuit board 200 (not shown in the figure), and the other end of the PV port 501 passes through the housing 100 and extends to the outer side of the housing 100 (as shown in FIG. 4 and FIG. 6).

In this implementation, two ends of the PV port 501 are located on the inner side of the housing 100 and the outer side of the housing 100 respectively. The PV port 501 is configured to transfer a direct current to the inverter power assembly 810.

In this implementation, the PV ports 501 are connected to some pins 301 of the switch body 320 through the metal traces 201 of the circuit board 200 (as shown in FIG. 6). Some pins 301 of the switch body 320 are connected to the bus capacitor 820 through the metal traces 201 of the circuit board 200. The bus capacitor 820 is connected to the inverter power assembly 810 through the metal traces 201 of the circuit board 200. In this implementation, connection means electrical connection. From a structural perspective, connection may be direct fixed connection or indirect fixed connection. A plurality of metal traces 201 exist on the circuit board 200. The metal traces 201 may also be referred to as conducting traces, may be copper traces, and are configured to connect devices on the circuit board 200.

For example, the PV ports 501 and some pins 301 of the switch body 320 are located at different positions of the circuit board 200, and need to be electrically connected through the metal traces 201 of the circuit board 200. The PV port 501 is directly and fixedly connected to one end of one metal trace 201 of the circuit board 200, and each of some pins 301 of the switch body 320 is directly and fixedly connected to the other end of the metal trace 201, so that electrical connection between the PV ports 501 and some pins 301 of the switch body 320 is implemented.

In some implementations, one end of the metal trace 201 includes a via hole. A screw or a pin is inserted into the via hole, so that the PV port 501 may be fixedly connected to one end of the metal trace 201.

In an implementation, the bus capacitor 820 or the inverter power assembly 810 may be fixedly connected to one end of the metal trace 201 in a spaced manner through solder welding.

In some implementations, a functional device may be further disposed between the PV ports 501 and some pins 301 of the switch body 320 based on a function requirement. Electrical connection through the metal traces 201 is implemented between the PV ports 501 and the functional device or between the functional device and the pins 301.

In this implementation, connection through the metal traces 201 is implemented between the PV ports 501 and the pins 301 of the switch body 320, between the pins 301 and the bus capacitor 820, and between the bus capacitor 820 and the inverter power assembly 810. This reduces or avoids cables, and reduces installation difficulty. In this implementation, the direct current transferred by the PV port 501 is converted to an alternating current by using the foregoing connection relationship, so that contact resistance and a heat dissipation amount between devices are reduced, and working efficiency of the photovoltaic inverter 10 is improved.

In an embodiment of this application, the photovoltaic inverter 10 is disposed: First, the circuit board 200 is reversely fastened in the photovoltaic inverter 10, and the second device 800 with a large heat dissipation amount or the second device 800 with a large size is disposed on the rear circuit board side 230, so that cooling effect on the second device 800 is improved. The first device 700 with a small heat dissipation amount or the first device 700 with a small size is disposed on the front circuit board side 220, so that the volume of the first subcavity S1 between the front circuit board side 220 and the cover plate 120 is small, internal space of the photovoltaic inverter 10 is fully utilized, and miniaturization of the photovoltaic inverter 10 is facilitated.

Second, because the circuit board 200 is reversely fastened in the photovoltaic inverter 10, to improve cooling effect and improve utilization of space inside the photovoltaic inverter 10, the inverter power assembly 810 is in thermally conductive connection to the cooling fins 600 through the thermally conductive contact part 202, so that a heat transfer path between the inverter power assembly 810 and the cooling fins 600 is effectively shortened, and cooling effect on the inverter power assembly 810 is improved. The thermally conductive contact part 202 can further provide support for the circuit board 200, so that structural strength and reliability between the circuit board 200 inside the photovoltaic inverter 10 and the housing 100 are improved.

Third, both the switch body 320 of the switch assembly 300 and the second device 800 are fastened to the rear circuit board side 230. In an installation process, because it is inconvenient for the operator to directly observe the rear circuit board side 230, in this application, the switch body 320 is rigidly fastened to the rear circuit board side 230 through the pins 301. Compared with flexible fastening, in this application, installation difficulty is reduced, and a step of manual fastening is omitted. Due to cableless connection between the switch body 320 and the circuit board 200, contact resistance and a heat dissipation amount between the switch body 320 and the circuit board 200 can be further reduced, and working efficiency of the photovoltaic inverter 10 is improved. In addition, impact of poor contact between the switch body 320 and the circuit board 200 can be reduced in processing, transportation, and assembly processes.

Refer to FIG. 9. FIG. 9 is a diagram of a structure of the breaking unit 325 according to an embodiment of this application. In an implementation, the breaking unit 325 includes a movable contact 3251 and static contacts 3252. One end that is of the pin 301 and that is away from the circuit board is fastened to the static contact 3252. The static contact 3252 is connected to the metal traces of the circuit board through the pin 301. The knob can control the movable contact 3251 of the breaking unit 325 to rotate, to disconnect or connect the movable contact 3251 and the static contacts 3252.

In this implementation, the breaking units 325 are electrically connected between the photovoltaic module 20 and the inverter power assembly 810 through the pins 301. In this implementation, two ends of the pin 301 are directly fastened to the breaking unit 325 and the circuit board respectively. Compared with a cable connection manner, an increase of assembly and maintenance difficulty caused by a large quantity of cables can be avoided. In addition, the breaking units 325 and the circuit board are directly connected and fastened through the pins 301, so that space occupied by the devices inside the photovoltaic inverter 10 can be reduced, and the size of the photovoltaic inverter 10 is reduced. In addition, the breaking units 325 and the metal traces of the circuit board are directly connected and fastened through the pins 301, so that resistance between the breaking units 325 and the circuit board can be reduced, a current transfer path from the breaking units 325 to the circuit board is shorter, current transfer efficiency is improved, and working effect of the photovoltaic inverter 10 is further improved.

In an implementation, one end that is of the pin 301 and that is away from the circuit board is connected to the static contact 3252 through a connecting part (not shown in the figure). For example, the connecting part is solder. The pin 301 and the static contact 3252 are fastened through solder welding. For example, the connecting part may be a metal rod or a metal sheet.

In an implementation, one end of the static contact 3252 extends to an outer side of the breaking unit 325 to form the pin 301. In this implementation, the pin 301 and the static contact 3252 are of an integrated structure. This helps improve stability of connection between the pin 301 and the static contact 3252.

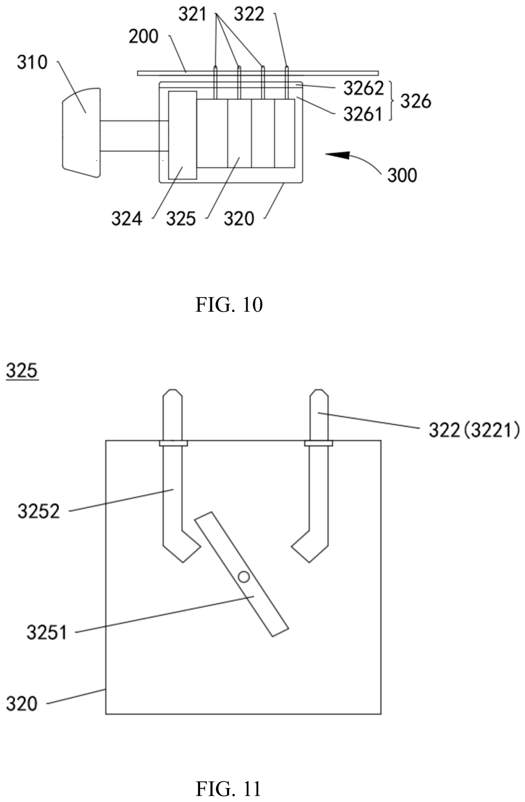

Still refer to FIG. 8, FIG. 9, and FIG. 10. FIG. 10 is a diagram of a structure of the switch assembly 300 and the circuit board 200 according to an embodiment of this application. In an implementation, the switch body 320 includes the plurality of breaking units 325 (as shown in FIG. 8 and FIG. 10). Each breaking unit 325 includes the movable contact 3251 and the two static contacts 3252 (as shown in FIG. 9). The movable contact 3251 rotates, so that two ends of the movable contact 3251 are in contact with or disconnected from the two static contacts 3252 respectively, to implement connection and disconnection of the movable contact 3251 and the static contacts 3252.

Refer to FIG. 8 to FIG. 11. FIG. 11 is a diagram of a structure of the breaking unit 325 according to an embodiment of this application. In an implementation, the pins 301 include an input pin pair 3211 and an output pin pair 3221 (as shown in FIG. 9 and FIG. 11). The input pin pair 3211 includes two input pins 321 (as shown in FIG. 9). The output pin pair 3221 includes two output pins 322. One end that is of each of the two input pins 321 of the input pin pair 3211 and that is away from the circuit board is electrically connected and fastened to each of the two static contacts 3252 of the breaking unit 325 (as shown in FIG. 9). The breaking unit 325 shown in FIG. 9 is an input breaking unit. One end that is of each of the two input pins 321 and that is away from the circuit board is welded and fastened to each of the two static contacts 3252. In this implementation, two ends of each input pin 321 of the input pin pair 3211 are directly fastened to the breaking unit 325 and the circuit board respectively (as shown in FIG. 9 and FIG. 10). Compared with a cable connection manner, an increase of assembly and maintenance difficulty caused by a large quantity of cables can be avoided. In addition, the breaking units 325 and the circuit board are directly connected and fastened through the input pins 321, so that space occupied by the devices inside the photovoltaic inverter 10 can be reduced, and the size of the photovoltaic inverter 10 is reduced. In addition, the breaking units 325 and the circuit board are directly connected and fastened through the input pins 321, so that resistance between the breaking units 325 and the circuit board can be reduced, a current transfer path from the breaking units 325 to the circuit board is shorter, current transfer efficiency is improved, and working effect of the photovoltaic inverter 10 is further improved.

In an implementation, one end of the static contact 3252 extends to an outer side of the breaking unit 325 to form the input pin 321 and the output pin 322. In this implementation, both of the input pin 321 and the output pin 322 and the static contact 3252 are of an integrated structure. This helps improve stability of connection between the input pin 321 and the static contact 3252 and between the output pin 322 and the static contact 3252.

Still refer to FIG. 11. In an implementation, the breaking unit 325 is an output breaking unit. One end that is of each of the two output pins 322 of the output pin pair 3221 and that is away from the circuit board is electrically connected and fastened to each of the two static contacts 3252 of the breaking unit 325. The breaking units 325 are electrically connected between a negative electrode of the photovoltaic module and a negative electrode of the inverter power assembly through the output pin pair 3221.

In an implementation, a quantity of input pin pairs 3211 is three, and a quantity of output pin pairs 3221 is one. Correspondingly, a quantity of input breaking units is three, and a quantity of output breaking units is one.

It should be noted that FIG. 9 and FIG. 11 merely schematically show a connection relationship between the static contacts 3252 and the pins 301, and do not represent specific structures, sizes, and a position relationship of the static contacts 3252 and the movable contact 3251.

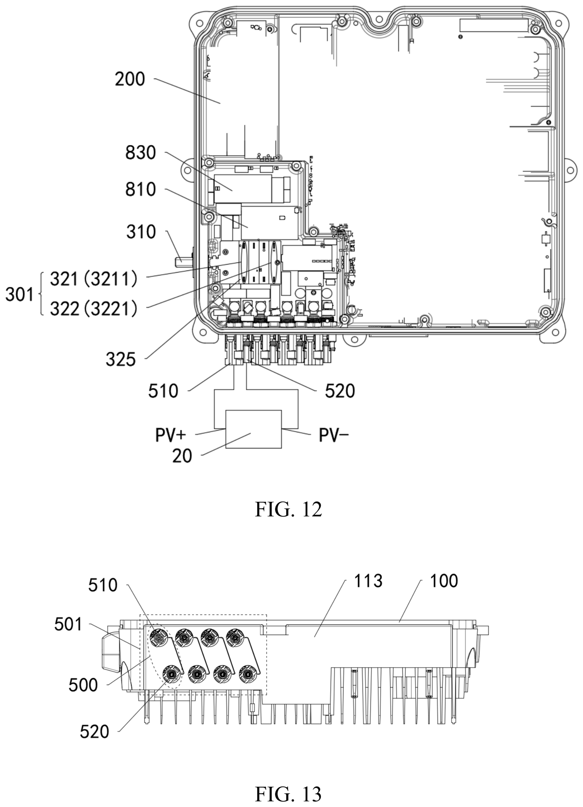

Refer to FIG. 8 and FIG. 12. FIG. 12 is a diagram of a partial structure of the photovoltaic inverter 10 according to an embodiment of this application. In an implementation, the pins 301 include input pins 321 and output pins 322 (as shown in FIG. 8 and FIG. 12). The breaking units 325 include input breaking units and an output breaking unit. The input pins 321 and the output pins 322 are located on the input breaking units and the output breaking unit respectively (as shown in FIG. 8, FIG. 9, and FIG. 11). The knob 310 is configured to control conduction between the input pins 321 and conduction between the output pins 322, and is further configured to control disconnection between the input pins 321 and disconnection between the output pins 322. In this implementation, the knob 310 can be used to control conduction and disconnection between the input pins 321 and conduction and disconnection between the output pins 322, to implement electrical connection and disconnection between the photovoltaic module 20 and the switch body 320.

Refer to FIG. 12 and FIG. 13. FIG. 13 is a diagram of a structure of the photovoltaic inverter 10 according to an embodiment of this application. In an implementation, the switch body 320 includes at least one input pin pair 3211 and at least one output pin pair 3221 (as shown in FIG. 12). Each input pin pair 3211 includes two input pins 321. Each output pin pair 322 includes two output pins 322. The PV port 501 includes a positive connector 510 and a negative connector 520 (as shown in FIG. 13).

In the input breaking unit, one input pin 321 in each input pin pair 3211 is configured to connect to the positive connector 510 through the metal trace of the circuit board 200 (as shown in FIG. 12 and FIG. 13), two input pins 321 in each input pin pair 3211 are connected through static contacts 3252 and a movable contact 3251 in the input breaking unit, and the other input pin 321 in each input pin pair 3211 is configured to connect to the bus capacitor 820 through the metal trace of the circuit board 200 (as shown in FIG. 6 and FIG. 12).

In the output breaking unit, one output pin 322 in each output pin pair 3221 is configured to connect to the negative connector 520 through the metal trace of the circuit board 200 (as shown in FIG. 12 and FIG. 13), two output pins 322 in each output pin pair 3221 are connected through static contacts 3252 and a movable contact 3251 in the output breaking unit, and the other output pin 322 in each output pin pair 3221 is configured to connect to the inverter power assembly 810 through the metal trace of the circuit board 200 (as shown in FIG. 6 and FIG. 12).

In this implementation, the inverter power assembly 810 and the photovoltaic module 20 form a loop by using the input pin pair 3211 and the output pin pair 3221. The input pin pair 3211 is located between a positive electrode of the photovoltaic module 20 and the inverter power assembly 810. The output pin pair 3221 is located between the inverter power assembly 810 and a negative electrode of the photovoltaic module 20. A current flows from the positive electrode of the photovoltaic module 20 to the inverter power assembly 810, and then flows from the inverter power assembly 810 to the negative electrode of the photovoltaic module 20. In this implementation, the input pins 321 and the output pins 322 are electrically connected to the photovoltaic module 20 and the inverter power assembly 810 respectively through the metal traces of the circuit board 200, so that use of cables between the switch body 320 and the photovoltaic module 20 and between the switch body 320 and the inverter power assembly 810 can be avoided. This helps reduce costs, reduce occupation of internal space, and improve convenience of installation operation.

Still refer to FIG. 12 and FIG. 13. In an implementation, the photovoltaic inverter 10 includes a plurality of connector pairs 500 (as shown in FIG. 12 and FIG. 13) fastened to the bottom housing 110. Each connector pair 500 includes a positive connector 510 and a negative connector 520 (as shown in FIG. 13). One end of the positive connector 510 is connected to the positive electrode (not shown in the figure) of the photovoltaic module 20, and the other end of the positive connector 510 is fastened to the circuit board 200 and electrically connected to the circuit board 200 (as shown in FIG. 12). One end of the negative connector 520 is connected to the negative electrode (not shown in the figure) of the photovoltaic module 20, and the other end of the negative connector 520 is fastened to the circuit board 200 and electrically connected to the circuit board 200 (as shown in FIG. 12). One input pin 321 in each input pin pair 3211 is electrically connected to the other end of the positive connector 510 through the circuit board 200 (as shown in FIG. 13), and is further electrically connected to the positive electrode of the photovoltaic module 20. One output pin 322 in each output pin pair 3221 is configured to electrically connect to the other end of the negative connector 520 through the circuit board 200 (as shown in FIG. 13), and is further electrically connected to the negative electrode of the photovoltaic module 20.

In an implementation, the quantity of input pin pairs 3211 is three, and a quantity of connector pairs 500 is three and is the same as the quantity of input pin pairs 3211. Each of positive connectors 510 in the three connector pairs 500 is electrically connected to one input pin 321 in the three input pin pairs 3211. Each of negative connectors 520 in the three connector pairs 500 is electrically connected to one output pin 322 in the output pin pairs 3221. In another implementation, a quantity of connector pairs 500 may be determined based on the quantity of input pin pairs 3211. This is not limited herein.

In an implementation, a connector pair electrically connected to the battery pack (not shown in the figure) is further disposed on the bottom housing 110. As shown in FIG. 13, the PV ports 501 include three connector pairs 500, where the three connector pairs 500 are configured to electrically connect to the photovoltaic module. The photovoltaic inverter further includes the connector pair 500, configured to electrically connect to the battery pack.

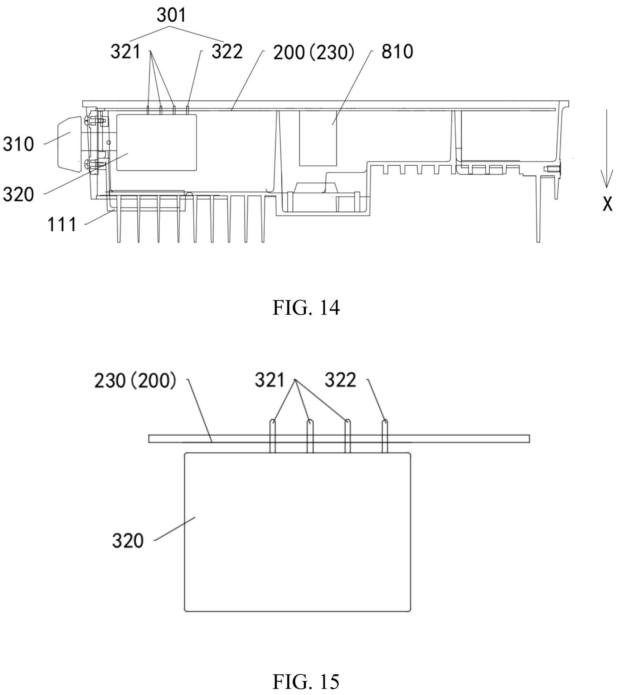

Refer to FIG. 14. FIG. 14 is a cross-sectional view of the photovoltaic inverter 10 according to an embodiment of this application. In an implementation, the pins 301 are all inserted into the circuit board 200 and rigidly fastened to the circuit board 200. Specifically, the input pins 321 and the output pins 322 are all inserted into the circuit board 200 and rigidly fastened to the circuit board 200. In this implementation, the input pins 321 and the output pins 322 are rigid. For example, the input pins 321 and the output pins 322 are metal pins. The metal pins are inserted into the circuit board 200, so that the input pins 321 and the output pins 322 are rigidly fastened to the circuit board 200. When the knob 310 is configured to control the switch body 320 to be turned off, the switch body 320 controls, by using the input pins 321 and the output pins 322, the inverter power assembly 810 to be disconnected from the photovoltaic module. When the knob 310 is configured to control the switch body 320 to be turned on, the switch body 320 controls, by using the input pins 321 and the output pins 322, the inverter power assembly 810 to be electrically connected to the photovoltaic module.

In this implementation, the input pins 321 and the output pins 322 are rigidly fastened to the circuit board 200 in a manner of being inserted into the circuit board 200, so that the switch body 320 can be more conveniently fastened and electrically connected to the circuit board 200. This simplifies an assembly process of the photovoltaic inverter 10 and reduces labor costs. In addition, a distance of a position at which the switch body 320 is fastened and electrically connected to the circuit board 200 is shortened, so that space at a joint between the switch body 320 and the circuit board 200 is saved, and space utilization and power density of the photovoltaic inverter 10 are improved.

In an implementation, in a process in which the switch body 320 is installed on and fastened to the rear circuit board side 230, generally the switch body 320 needs to be fastened to the bottom housing 110 through the connecting rod 330, and then the circuit board 200 is connected to the switch body 320. Because the rear circuit board side 230 is the surface that is of the circuit board 200 and that is away from the operator, it is inconvenient for the operator to directly observe the rear circuit board side 230. In addition, the second device 800 has been installed on the rear circuit board side 230. In this implementation, the pins 301 may be directly inserted into the rear circuit board side 230 and rigidly fastened to the rear circuit board side 230. This can reduce installation difficulty. In this implementation, sizes are specified in advance to align the pins 301 of the switch body 320 with insertion positions of the circuit board 200, so that the pins 301 can be directly inserted into and fastened to the circuit board 200.

In a cable connection manner, during installation, because the switch body 320 is located on the rear circuit board side 230, only after connecting one end of the cable to the switch body 320, installing and fastening the circuit board 200, and winding the other end of the cable sequentially from the rear circuit board side 230, a side face of the circuit board 200, to the front circuit board side 220, the operator can fixedly connect the other end of the cable to the front circuit board side 220. Compared with the rigid connection manner in this application, in this manner, operation is complex, and cable arrangement is disordered. In conclusion, in a manner of inserting the pins 301 of the switch body 320 into the rear circuit board side 230, operation is more convenient, and labor costs are saved.

Refer to FIG. 15. FIG. 15 is a diagram of a structure of the switch body 320 and the circuit board 200 according to an embodiment of this application. In an implementation, all extension directions of the pins 301 are perpendicular to the rear circuit board side 230. In a specific implementation, all extension directions of the input pins 321 and the output pins 322 are perpendicular to the rear circuit board side 230, so that the input pins 321 and the output pins 322 can be more conveniently inserted into the circuit board 200. In addition, the extension directions of the input pins 321 and the output pins 322 are perpendicular to a surface that is of the switch body 320 and that faces the circuit board 200, so that the switch body 320 can be better fixedly connected to the circuit board 200 through the input pins 321 and the output pins 322.

In this implementation, the rear circuit board side 230 is a surface that is of the circuit board 200 and that faces the switch body 320 in the first direction X. When the input pins 321 and the output pins 322 of the switch body 320 are inserted into the circuit board 200, because the surface that is of the circuit board 200 and that faces the switch body 320 is parallel to the surface that is of the switch body 320 and that faces the circuit board 200, resistance to the input pins 321 and the output pins 322 is small, and deformation is not likely to occur, so that stability of mechanical connection and electrical connection relationships between the switch body 320 and the circuit board 200 can be improved. This helps ensure proper operation of the photovoltaic inverter 10.

It should be noted that perpendicularity defined in embodiments of this application is not limited to an absolute perpendicular intersection (an included angle is 90 degrees) relationship, a case in which an absolute perpendicular intersection relationship is not caused by factors such as an assembly tolerance, a design tolerance, and a structural flatness is allowed, and an error within a small angle range is allowed. For example, a relationship within an assembly error range of 80 degrees to 100 degrees may be understood as the perpendicular relationship.

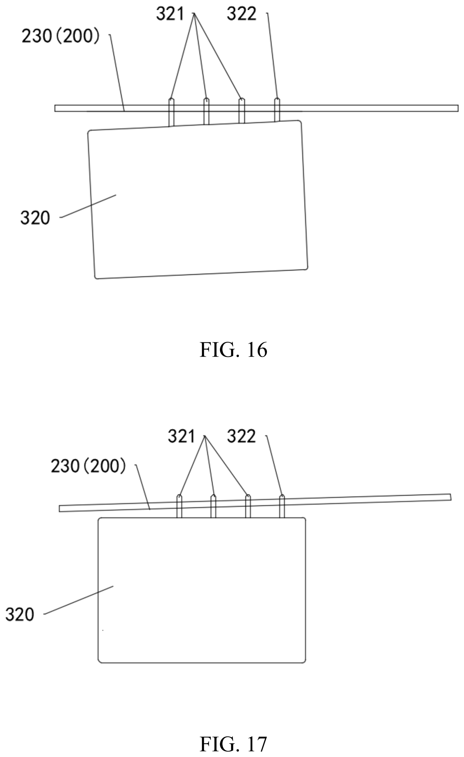

Refer to FIG. 16. FIG. 16 is a diagram of a structure of the switch body 320 and the circuit board 200 according to an embodiment of this application. In an implementation, extension directions of the input pins 321 and the output pins 322 are perpendicular to either of the rear circuit board side 230 and a surface that is of the switch body 320 and that faces the circuit board 200. In this implementation, the extension directions of the input pins 321 and the output pins 322 are perpendicular to either of the rear circuit board side 230 and the surface that is of the switch body 320 and that faces the circuit board 200. This helps smoothly fasten and electrically connect the switch body 320 to the circuit board 200 while reducing processing difficulty.

As shown in FIG. 16, the extension directions of the input pins 321 and the output pins 322 are perpendicular to a surface that is of the circuit board 200 and that faces the switch body 320, an included angle between the extension directions of the input pins 321 and the output pins 322 and the surface that is of the switch body 320 and that faces the circuit board 200 is less than 90°, and an included angle between the surface that is of the circuit board 200 and that faces the switch body 320 and the surface that is of the switch body 320 and that faces the circuit board 200 is less than 90°. That is, the surface that is of the circuit board 200 and that faces the switch body 320 is not parallel to the surface that is of the switch body 320 and that faces the circuit board 200. In this implementation, assembly difficulty is reduced. When the switch body 320 cannot be placed in parallel in the bottom housing 110 because excessive devices exist on the bottom housing 110, the switch body 320 may be electrically connected to the circuit board 200 in the implementation shown in FIG. 16.

Refer to FIG. 17. FIG. 17 is a diagram of a structure of the switch body 320 and the circuit board 200 according to an embodiment of this application. An included angle between extension directions of the input pins 321 and the output pins 322 and the rear circuit board side 230 is less than 90°, the extension directions of the input pins 321 and the output pins 322 are perpendicular to a surface that is of the switch body 320 and that faces the circuit board 200, and an included angle between the rear circuit board side 230 and the surface that is of the switch body 320 and that faces the circuit board 200 is less than 90°. In this implementation, a surface that is of the circuit board 200 and that faces the switch body 320 is not parallel to the surface that is of the switch body 320 and that faces the circuit board 200 either. In this implementation, assembly difficulty is reduced. When the circuit board 200 cannot be placed in parallel in the bottom housing 110 because excessive devices exist on the circuit board 200 or the cover plate is uneven, the switch body 320 may be electrically connected to the circuit board 200 in the implementation shown in FIG. 17.

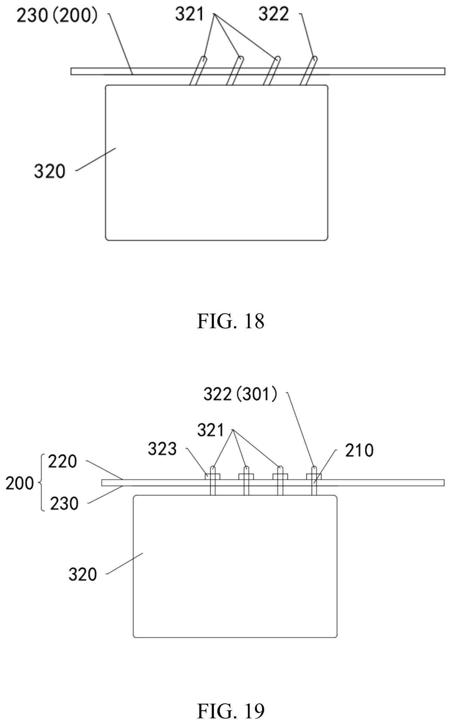

Refer to FIG. 18. FIG. 18 is a diagram of a structure of the switch body 320 and the circuit board 200 according to an embodiment of this application. In an implementation, extension directions of the input pins 321 and the output pins 322 are not perpendicular to either of the rear circuit board side 230 and a surface that is of the switch body 320 and that faces the circuit board 200. The rear circuit board side 230 is parallel to the surface that is of the switch body 320 and that faces the circuit board 200. In this implementation, the input pins 321 and the output pins 322 are obliquely inserted into the circuit board 200. When the input pins 321 and the output pins 322 on the switch body 320 do not correspond to via holes in the circuit board 200, the input pins 321 and the output pins 322 may deviate from a height direction, so that the input pins 321 and the output pins 322 can be inserted into the via holes in the circuit board 200. In the implementations shown in FIG. 16 to FIG. 18, the photovoltaic inverter 10 can adapt to a plurality of assembly scenarios. This improves assembly flexibility of the photovoltaic inverter 10.

Refer to FIG. 19. FIG. 19 is a diagram of a structure of the switch body 320 and the circuit board 200 according to an embodiment of this application. In an implementation, the circuit board 200 is provided with a plurality of via holes 210. The pins 301 pass through the via holes 210 and are welded to the via holes 210, so that the pins 301 are rigidly fastened to the circuit board 200 and connected to the metal traces of the circuit board 200. The via holes 210 are also referred to as plated holes. The via holes 210 are obtained by forming metal on side walls of through holes that penetrate the circuit board 200. The circuit board 200 can be electrically connected to an external device through the via holes 210. In this implementation, the pins 301 pass through the via holes 210 and are welded to the via holes 210, so that the pins 301 are fastened and electrically connected to the via holes 210, and the pins 301 are fastened and electrically connected to the circuit board 200. In an implementation, the via hole 210 may be the via hole at one end of the metal trace. In other words, one end of the metal trace includes the via hole 210.

In an implementation, pads 323 are disposed on the surface that is of the circuit board 200 and that is away from the switch body 320. The pad 323 encircles a circumferential side of the via hole 210. An end that is of the pin 301 and that passes through the via hole 210 is welded to the pad 323 (as shown in FIG. 19). The pads 323 can improve stability of connection between the pins 301 and the circuit board 200.

In this implementation, the pins 301 sequentially penetrate the rear circuit board side 230 and the front circuit board side 220 of the circuit board 200. The pads 323 are located on the front circuit board side 220. The pads 323 are welded to the circuit board 200, so that the pins 301 are fastened to the front circuit board side 220, and the switch body 320 is not prone to falling off from the circuit board 200. This helps improve stability of connection between the switch body 320 and the circuit board 200.

In an implementation, the circuit board 200 is in crimped connection to the switch body 320 through the pins 301. For example, one end that is of the pin 301 and that passes through the via hole 210 is fastened to the circuit board 200 through a screw, so that the circuit board 200 and the switch body 320 are tightly pressed and fixedly connected.

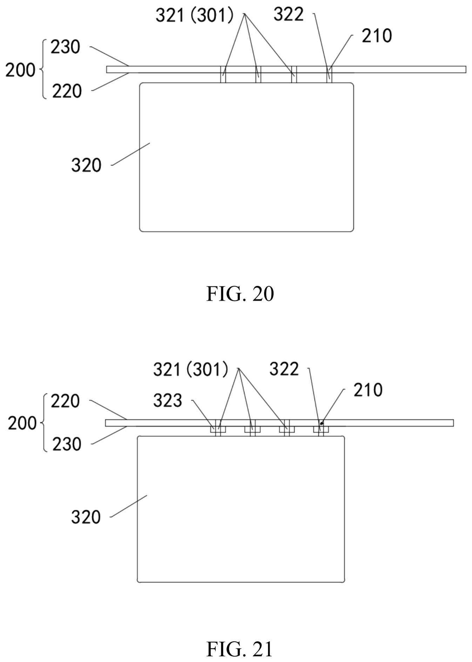

Refer to FIG. 20. FIG. 20 is a diagram of a structure of the switch body 320 and the circuit board 200 according to an embodiment of this application. In some implementations, one end that is of the pin 301 and that is inserted into the via hole 210 is welded into the via hole 210. For example, the end that is of the pin 301 and that is inserted into the via hole 210 may be welded into the via hole 210 through wave soldering.

Refer to FIG. 21. FIG. 21 is a diagram of a structure of the switch body 320 and the circuit board 200 according to an embodiment of this application. In some implementations, one end that is of the pin 301 and that is away from the switch body 320 is welded to one end that is of the via hole 210 and that faces the rear circuit board side 230. In an implementation, one end that is of the pin 301 and that is away from the switch body 320 is welded to the pad 323 located on the rear circuit board side 230. For example, the insertion end of the pin 301 may be welded to the rear circuit board side 230 through wave soldering.

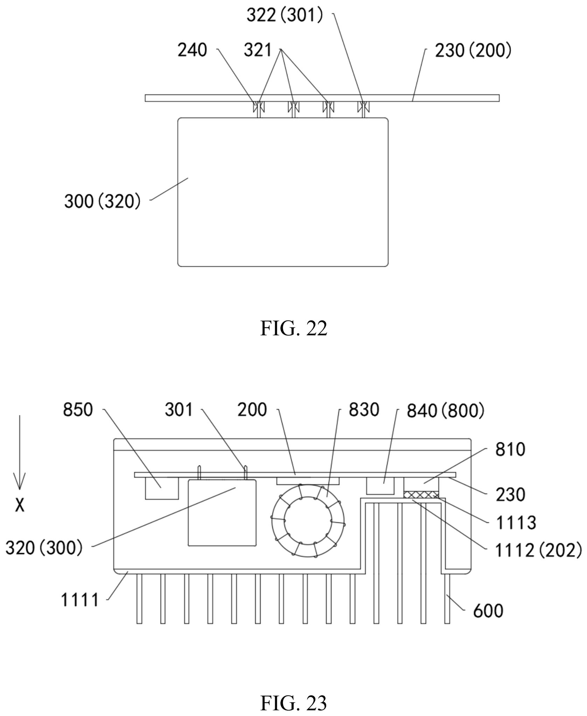

Refer to FIG. 22. FIG. 22 is a diagram of a structure of the switch body 320 and the circuit board 200 according to an embodiment of this application. In an implementation, a plurality of sockets 240 are disposed on the rear circuit board side 230. The pins 301 are all inserted into the sockets 240, rigidly fastened to the circuit board 200, and electrically connected to the circuit board 200. In this implementation, the sockets 240 matching the pins 301 are disposed on the circuit board 200, and the pins 301 are inserted into the sockets 240, so that the pins 301 are fastened and electrically connected to the sockets 240, and the pins 301 are rigidly fastened and electrically connected to the circuit board 200.

For example, the socket 240 includes two spring plates disposed opposite to each other. The two spring plates have an elastic force to approach each other. When being inserted into the two spring plates, the pin 301 is fastened by the two spring plates and electrically connected to the spring plates.

For example, to increase a contact area between the pin and the spring plate, the pin 301 may be set to a flat metal sheet, so that the contact area between the pin 301 and the spring plate is increased, and connection stability and electrical connection stability are improved.

In another implementation, the pin 301 may be set to a shape matching a shape of the socket 240. For example, the pin 301 may be set to a cylindrical shape, a square cylindrical shape, or the like.

Still refer to FIG. 10. In an implementation, the switch body 320 includes an operation mechanism 324 and the breaking units 325. The knob 310 can control, by using the operation mechanism 324, the breaking units 325 to be disconnected or connected. An end that is of the input pin 321 and that is away from the circuit board 200 and one end that is of the output pin 322 and that is away from the circuit board 200 are fastened in the breaking units 325.

In this implementation, the knob 310 is fixedly connected to the operation mechanism 324, and the knob 310 rotates to drive the operation mechanism 324 to rotate, so that the breaking unit 325 switches between a disconnected state and a connected state. The breaking units 325 are electrically connected to the circuit board 200 through the pins 301. Disconnection and connection of the breaking units 325 correspond to disconnection and electrical connection between the photovoltaic module 20 and the inverter power assembly 810.

In an implementation, the operation mechanism 324 is a free tripping structure. In this implementation, safety of the photovoltaic inverter 10 is improved.

Still refer to FIG. 10. In an implementation, the switch body 320 further includes a switch housing 326. The operation mechanism 324 and the breaking units 325 are all located inside the switch housing 326. In an implementation, the switch housing 326 is a plastic member. The input pins 321 and the output pins 322 may be integrated with the switch housing 326 through injection molding to form an integrated structure. This improves structural strength of the input pins 321, the output pins 322, and the switch housing 326.

Still refer to FIG. 10. In an implementation, the switch housing 326 includes a housing body 3261 and an upper cover 3262. The upper cover 3262 covers the housing body 3261 to form an accommodating space. The operation mechanism 324 and the breaking units 325 are located in the accommodating space. In an implementation, the input pins 321 and the output pins 322 may be integrated with the upper cover 3262 through injection molding to form an integrated structure. In this implementation, assembly of the switch assembly 300 is facilitated. When the switch assembly 300 is assembled, the operation mechanism 324 and the breaking units 325 may be first installed in the housing body 3261, the input pins 321 and the output pins 322 are pre-integrated with the upper cover 3262 through injection molding to form the integrated structure, one end of the input pin 321 and one end of the output pin 322 in the integrated structure are electrically connected and fastened to the breaking units 325, and then the upper cover 3262 is fastened to the housing body 3261.

Refer to FIG. 23. FIG. 23 is a cross-sectional view of the photovoltaic inverter 10 according to an embodiment of this application. In an implementation, the second device 800 further includes a direct current conversion assembly 840. The direct current conversion assembly 840 is fastened to the rear circuit board side 230. The direct current conversion assembly 840 is located between the thermally conductive contact part 202 and the rear circuit board side 230. The direct current conversion assembly 840 is in thermally conductive connection to the cooling fins 600 through the thermally conductive contact part 202. Some pins 301 of the switch body 320 are connected to the direct current conversion assembly 840 through the metal traces of the circuit board 200. The direct current conversion assembly 840 is electrically connected to the bus capacitor through the metal traces of the circuit board 200. In this implementation, the direct current conversion assembly 840 is configured to perform voltage conversion on the direct current transferred to the inverter power assembly 810, to convert a voltage into a direct current voltage required by the inverter power assembly 810. In an implementation, the direct current conversion assembly 840 is a direct current voltage boosting assembly. In this implementation, the direct current conversion assembly 840 is connected to the metal traces of the circuit board 200, to implement electrical connection between the direct current conversion assembly 840 and the bus capacitor and between the direct current conversion assembly 840 and the switch body 320.

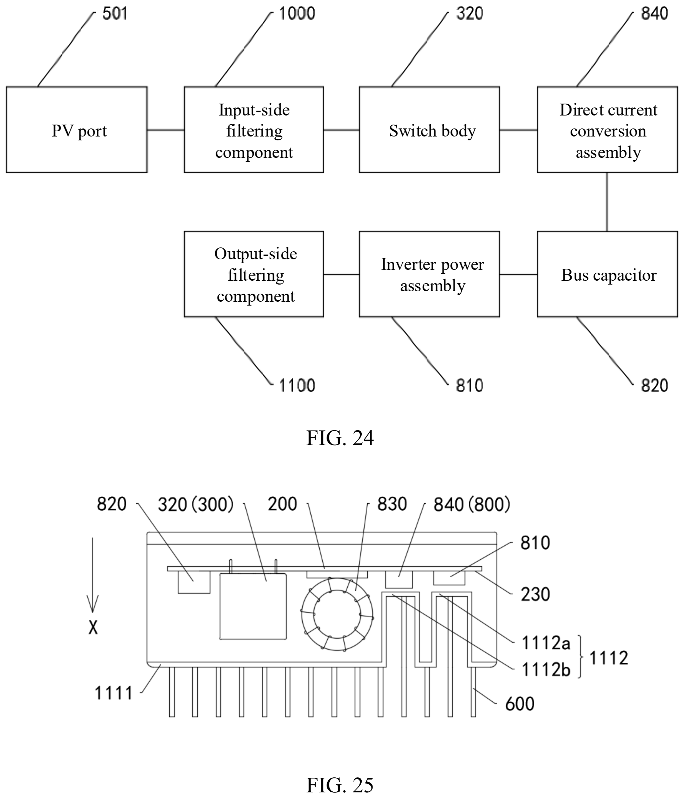

Refer to FIG. 24. FIG. 24 is a diagram of electrical connection of the photovoltaic inverter 10 according to an embodiment of this application. In an implementation, the photovoltaic inverter further includes an input-side filtering component 1000 and an output-side filtering component 1100. Both the input-side filtering component 1000 and the output-side filtering component 1100 are connected to the circuit board. The PV port 501 is connected to the input-side filtering component 1000 through the metal traces of the circuit board. The input-side filtering component 1000 is connected to some pins of the switch body 320 through the metal traces of the circuit board. The switch body 320 is connected to the direct current conversion assembly 840 through the metal traces of the circuit board. The direct current conversion assembly 840 is connected to the bus capacitor 820 through the metal traces of the circuit board. The bus capacitor 820 is connected to the inverter power assembly 810 through the metal traces of the circuit board. The inverter power assembly 810 is connected to the output-side filtering component 1100 through the metal traces of the circuit board.

In this implementation, the direct current generated by the photovoltaic module is input to the input-side filtering component 1000 through the PV port 501, and then the input-side filtering component 1000 transfers the direct current to the direct current conversion assembly 840 through the switch body 320. The direct current conversion assembly 840 performs voltage conversion operation on the direct current, and continues to sequentially transfer the direct current to the bus capacitor 820 and the inverter power assembly 810. The direct current is converted into the alternating current in the inverter power assembly 810, and then the inverter power assembly 810 transfers the alternating current to the output-side filtering component 1100. The input-side filtering component 1000 and the output-side filtering component 1100 filter out harmonics in the direct current and the alternating current respectively, to reduce heat generated by the inverter power assembly 810, avoid a safety risk, and improve reliability of inverter conversion. In addition, the input-side filtering component 1000 and the output-side filtering component 1100 can further improve electromagnetic compatibility effect in working of the photovoltaic inverter. Electromagnetic compatibility (Electromagnetic Compatibility, EMC) means a capability of the photovoltaic inverter to operate up to standard in an electromagnetic environment without generating intolerable electromagnetic disturbance to any device in the environment. Therefore, EMC includes requirements in two aspects: Electromagnetic disturbance (Electromagnetic Disturbance) generated by the photovoltaic inverter in a proper running process to the environment in which the photovoltaic inverter is located cannot exceed a specific limit. In addition, the photovoltaic inverter has a specific degree of resistance to electromagnetic disturbance existing in the environment in which the photovoltaic inverter is located, that is, electromagnetic susceptibility (Electromagnetic Susceptibility, EMS).

In this implementation, the functional devices are electrically connected through the metal traces of the circuit board. This can save cables and simplify a structure, and can also reduce impedance between the functional devices, and improve power effect of the photovoltaic inverter.

In an implementation, the alternating current output from the output-side filtering component 1100 may be provided for a power grid. In this implementation, an application scope of the photovoltaic inverter is broadened. In an implementation, the input-side filtering component 1000 and the output-side filtering component 1100 may include filter capacitors 850.

Still refer to FIG. 7. In an implementation, the bottom plate 111 includes a bottom plate body 1111 and a protrusion plate 1112. The protrusion plate 1112 is the thermally conductive contact part 202. The protrusion plate 1112 protrudes from the bottom plate body 1111 toward the inverter power assembly 810 and is in thermally conductive connection to the inverter power assembly 810. Orthographic projections of the protrusion plate 1112 and the inverter power assembly 810 on the rear circuit board side 230 at least partially overlap. A part of the cooling fins 600 are located on a side that is of the protrusion plate 1112 and that is away from the inverter power assembly 810. The bus capacitor 820 and the inductor 830 are located between the rear circuit board side 230 and the bottom plate body 1111. A part of the cooling fins 600 are located on a side that is of the bottom plate body 1111 and that is away from the rear circuit board side 230.

The cooling fins 600 are located on the side that is of the protrusion plate 1112 and that is away from the inverter power assembly 810 in the first direction X. The bottom plate body 1111 is a part of the bottom plate 111 other than the protrusion plate 1112. Compared with the bottom plate body 1111, the protrusion plate 1112 of the bottom plate 111 is closer to the inverter power assembly 810. This helps shorten the heat transfer path and improve cooling effect. The protrusion plate 1112 is in thermally conductive connection to the inverter power assembly 810. That is, heat can be conducted between the protrusion plate 1112 and the inverter power assembly 810. Therefore, the protrusion plate 1112 can implement heat transfer from the inverter power assembly 810 to the cooling fins 600. The orthographic projections of the protrusion plate 1112 and the inverter power assembly 810 on the rear circuit board side 230 at least partially overlap, so that an orthographic projection of a part of the cooling fins 600 corresponding to the protrusion plate 1112 on the rear circuit board side 230 also at least partially overlaps an orthographic projection of the inverter power assembly 810 on the rear circuit board side 230, and the cooling fins 600 can effectively cool the inverter power assembly 810.

In this implementation, because the protrusion plate 1112 protrudes toward the inverter power assembly 810 relative to the bottom plate body 1111, a part of the cooling fins 600 located on the back side of the protrusion plate 1112 have a larger length in the first direction X, a cooling area of the part of the cooling fins 600 is increased, and cooling effect on the inverter power assembly 810 is improved.

In an implementation, in addition to the protrusion plate 1112, the cooling fins 600 are further distributed on the side that is of the bottom plate body 1111 and that is away from the cover plate 120. The bus capacitor 820 and the inductor 830 in the second device 800 are located between the rear circuit board side 230 and the bottom plate body 1111. In an implementation, a part of the cooling fins 600 are in thermally conductive connection to the bus capacitor 820 and the inductor 830. Therefore, the part of the cooling fins 600 can cool the bus capacitor 820 and the inductor 830, and cooling effect of the cooling fins 600 is comprehensively improved. For example, the bus capacitor 820 and the inductor 830 are in thermally conductive connection to the bottom plate body 1111 through a thermally conductive medium 1113.

In an implementation, the orthographic projection of the protrusion plate 1112 on the rear circuit board side 230 completely covers the orthographic projection of the inverter power assembly 810 on the rear circuit board side 230. In this implementation, cooling effect of the cooling fins 600 on the inverter power assembly 810 is further improved.

In this implementation, in the first aspect, the protrusion plate 1112 can shorten the heat transfer path between the inverter power assembly 810 and the cooling fins 600, and further help increase the cooling area of the cooling fins 600, so that cooling effect on the inverter power assembly 810 is comprehensively improved. In the second aspect, the protrusion plate 1112 can further make full use of internal space of the photovoltaic inverter 10, improve high power density, further help reduce the size of the photovoltaic inverter 10, and indirectly improve utilization of internal space of the photovoltaic inverter 10, so that miniaturization design is implemented, and overall layout is optimized. In the third aspect, the protrusion plate 1112 can further provide support for the circuit board 200, so that structural strength and reliability between the circuit board 200 inside the photovoltaic inverter 10 and the housing 100 are improved. In the fourth aspect, in an actual application scenario, the bottom plate 111 is a surface that is of the photovoltaic inverter 10 and that faces the user. Because the bottom plate 111 is not in a field of view of the user at this time, even if the bottom plate 111 presents an uneven shape, overall aesthetics of the photovoltaic inverter 10 is not affected, so that use experience of the user is ensured. If the second device 800 is disposed on the front circuit board side 220, the protrusion plate 1112 needs to be disposed in the cover plate 120 to enhance cooling effect on the inverter power assembly 810. In this case, because the cover plate 120 is a surface that is of the photovoltaic inverter 10 and that directly faces the user, the cover plate 120 is uneven, causing negative impact on viewing and use experience of the user.

It should be noted that the first device 700 shown in FIG. 6 merely indicates that the first device 700 is located on the front circuit board side 220, and does not represent a quantity and an actual distribution position of the first device 700. Details may be set based on a requirement. The inverter power assembly 810 shown in FIG. 6 indicates a connection relationship with the pin 301, and does not represent that the inverter power assembly 810 is located on the front circuit board side 220. It should be noted that FIG. 7 merely schematically shows internal devices of the photovoltaic inverter 10, and does not represent specific structures or sizes of the internal devices. For example, actual distribution positions and sizes of 810/820 and 830 in the second device 800 on the rear circuit board side 230 in FIG. 7 are not limited to those shown in FIG. 7. FIG. 7 is only used to show a relative position relationship of the inverter power assembly 810 relative to the protrusion plate 1112, and relative position relationships of the bus capacitor 820 and the inductor 830 between the rear circuit board side 230 and the bottom plate body 1111.

Still refer to FIG. 23. In an implementation, the second device 800 further includes the direct current conversion assembly 840. The direct current conversion assembly 840 is fastened to the rear circuit board side 230. The direct current conversion assembly 840 is located between the protrusion plate 1112 and the rear circuit board side 230. Orthographic projections of the protrusion plate 1112 and the direct current conversion assembly 840 on the rear circuit board side 230 at least partially overlap.

In this implementation, the direct current conversion assembly 840 generates heat in a working state. Therefore, the orthographic projections of the protrusion plate 1112 and the direct current conversion assembly 840 on the rear circuit board side 230 at least partially overlap, so that a part of the cooling fins 600 are disposed close to the direct current conversion assembly 840 in the first direction X. This helps enhance cooling effect of the cooling fins 600 on the direct current conversion assembly 840.

In an implementation, the orthographic projection of the protrusion plate 1112 on the rear circuit board side 230 completely covers the orthographic projection of the direct current conversion assembly 840 on the rear circuit board side 230. In this implementation, cooling effect of the cooling fins 600 on the direct current conversion assembly 840 is further improved.

Refer to FIG. 25. FIG. 25 is a cross-sectional view of the photovoltaic inverter 10 according to an embodiment of this application. In an implementation, the protrusion plate 1112 includes a first protrusion subboard 1112a and a second protrusion subboard 1112b. The first protrusion subboard 1112a and the second protrusion subboard 1112b are spaced. The inverter power assembly 810 is located between the first protrusion subboard 1112a and the rear circuit board side 230. The direct current conversion assembly 840 is located between the second protrusion subboard 1112b and the rear circuit board side 230.

In this implementation, the first protrusion subboard 1112a and the second protrusion subboard 1112b are spaced. Correspondingly, the inverter power assembly 810 and the direct current conversion assembly 840 are spaced. This helps reduce electromagnetic interference between the inverter power assembly 810 and the direct current conversion assembly 840, and ensures that working efficiency of the inverter power assembly and the direct current conversion assembly is not affected. Cooling fins 600 corresponding to the first protrusion subboard 1112a are configured to cool the inverter power assembly 810. Cooling fins 600 corresponding to the second protrusion subboard 1112b are configured to cool the direct current conversion assembly 840. The protrusion plate 1112 includes the first protrusion subboard 1112a and the second protrusion subboard 1112b, so that precise cooling of the heat emitting device can be implemented, and cooling efficiency can be improved.

Still refer to FIG. 23. In an implementation, the protrusion plate 1112 is of an integrated structure. The inverter power assembly 810 and the direct current conversion assembly 840 are disposed adjacent to each other. In this solution, processing costs of the protrusion plate 1112 are reduced, and installation difficulty of the inverter power assembly 810 and the direct current conversion assembly 840 is reduced.

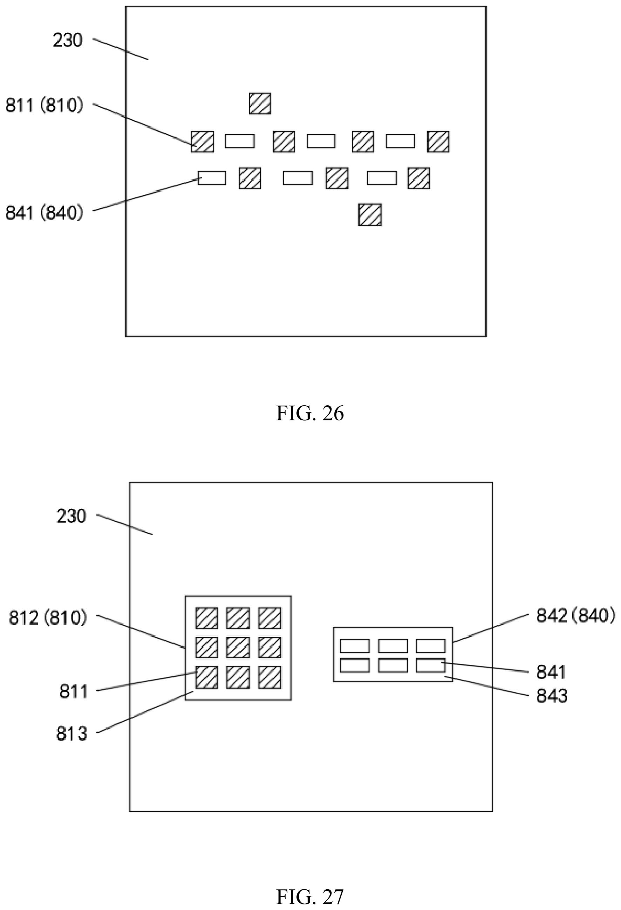

Refer to FIG. 26. FIG. 26 is a diagram of a partial structure of the photovoltaic inverter 10 according to an embodiment of this application. In an implementation, the inverter power assembly 810 includes a plurality of inverter power devices 811. The direct current conversion assembly 840 includes a plurality of direct current power devices 841. At least one of the inverter power devices 811 is located between the plurality of direct current power devices 841. The inverter power devices 811 and the direct current power devices 841 are power electronic devices that can implement a power conversion function, and include but are not limited to an insulated gate bipolar transistor (Insulated Gate Bipolar Transistor, IGBT), a silicon carbide power transistor, a silicon transistor, a metal-oxide semiconductor field-effect transistor (Metal-Oxide Semiconductor Field-Effect Transistor, MOS), a diode, and the like. In this implementation, the inverter power device 811 is configured to implement an alternating current-to-direct current conversion function. The direct current power device 841 is configured to implement a direct current voltage boosting function. In this implementation, the inverter power devices 811 and the direct current power devices 841 may be flexibly arranged based on a requirement, so that the inverter power assembly 810 and the direct current conversion assembly 840 can be applicable to different application scenarios. This reduces material costs.

In an implementation, at least one of the direct current power devices 841 is located between the plurality of inverter power devices 811. In this implementation, the inverter power devices 811 and the direct current power devices 841 may be flexibly arranged based on a requirement, so that the inverter power assembly 810 and the direct current conversion assembly 840 can be applicable to different application scenarios. This reduces material costs.

Refer to FIG. 27. FIG. 27 is a diagram of a partial structure of the photovoltaic inverter 10 according to an embodiment of this application. In an implementation, the inverter power assembly 810 is an inverter power module 812. The inverter power module 812 includes an inverter packaging structure 813 and a plurality of inverter power devices 811 located in the inverter packaging structure 813. The direct current conversion assembly 840 is a direct current conversion module 842. The direct current conversion module 842 includes a direct current packaging structure 843 and a plurality of direct current power devices 841 located in the direct current packaging structure 843. In this implementation, the plurality of inverter power devices 811 are packaged into the inverter packaging structure 813, and the plurality of direct current power devices 841 are packaged into the direct current packaging structure 843, so that the inverter power assembly 810 and the direct current conversion assembly 840 are highly integrated, and the plurality of inverter power devices 811 are installed on the rear circuit board side 230 as a whole. This reduces installation difficulty.

It should be noted that FIG. 26 and FIG. 27 merely schematically show an arrangement manner of the inverter power assembly 810 and the direct current conversion assembly 840, and do not represent specific structures, sizes, and a position relationship between the inverter power assembly 810 and the direct current conversion assembly 840. A person skilled in the art may make adjustments based on an actual requirement.

Still refer to FIG. 23. In an implementation, the thermally conductive medium 1113 is disposed between the inverter power assembly 810 and the protrusion plate 1112, and heat generated when the inverter power assembly 810 works is transferred to a part of the cooling fins 600 on one side of the protrusion plate 1112 through the thermally conductive medium 1113. In this solution, cooling effect is enhanced. In some implementations, for example, the thermally conductive medium 1113 may alternatively be other thermally conductive materials such as thermally conductive silicone grease, a thermally conductive silicone sheet, and a thermal adhesive. These thermally conductive media 1113 do not need to bond and fasten the protrusion plate 1112 and the inverter power assembly 810. This avoids that the inverter power assembly 810 and the protrusion plate 1112 cannot be detached during maintenance and therefore are damaged. In some implementations, to enhance reliability of the photovoltaic inverter 10, the thermally conductive medium 1113 having a bonding and fastening property may also be used between the protrusion plate 1112 and the inverter power assembly 810. For example, the thermally conductive medium 1113 is a thermally conductive adhesive.

In an implementation, a thermally conductive medium 1113 (not shown in the figure) is disposed between the direct current conversion assembly 840 and the protrusion plate 1112, heat generated when the direct current conversion assembly 840 works is transferred to a part of the cooling fins 600 on one side of the protrusion plate 1112 through the thermally conductive medium 1113. In this solution, cooling effect is enhanced. In some implementations, for example, the thermally conductive medium 1113 may alternatively be other thermally conductive materials such as thermally conductive silicone grease, a thermally conductive silicone sheet, and a thermal adhesive.

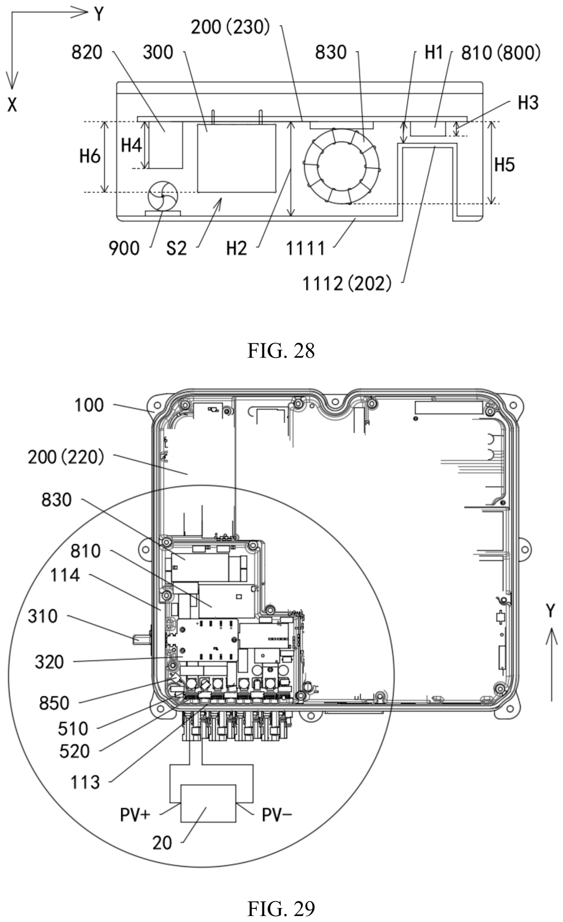

Refer to FIG. 28. FIG. 28 is a cross-sectional view of the photovoltaic inverter 10 according to an embodiment of this application. In an implementation, a distance between the thermally conductive contact part 202 and the rear circuit board side 230 in the first direction X is less than a distance between the bottom plate 111 and the circuit board 200 in the first direction X. A length of the inverter power assembly 810 in the first direction X is less than a length of at least one of the bus capacitor 820, the inductor 830, and the switch assembly 300 in the first direction X. In this embodiment, the thermally conductive contact part 202 is the protrusion plate 1112. A distance between the protrusion plate 1112 and the rear circuit board side 230 in the first direction X is less than a distance between the bottom plate body 1111 and the circuit board 200 in the first direction X.

In this implementation, the first direction X is a direction in which the bottom plate 111 and the circuit board 200 are stacked. The distance between the protrusion plate 1112 and the rear circuit board side 230 in the first direction X is H1. The distance between the bottom plate body 1111 and the circuit board 200 in the first direction X is H2. H1<H2. The protrusion plate 1112 is closer to the rear circuit board side 230 in the first direction X relative to the bottom plate body 1111. The length of the inverter power assembly 810 in the first direction X is H3. Lengths of the bus capacitor 820, the inductor 830, and the switch assembly 300 in the first direction X are H4, H5, and H6 respectively. H3 and H4, and H5 and H6 satisfy at least one of the following relational expressions: H3<H4, H3<H5, and H1<H6. The inverter power assembly 810 occupies a small length in the first direction X. Therefore, there is still some spare space between the inverter power assembly 810 and the bottom plate 111, the protrusion plate 1112 in the bottom plate 111 may be set to protrude toward the inverter power assembly 810 in the first direction X, and the spare space is excluded from the photovoltaic inverter 10. In this case, the distance between the protrusion plate 1112 and the rear circuit board side 230 is less than the distance between the bottom plate body 1111 and the rear circuit board side 230. In this solution, internal space of the photovoltaic inverter 10 is properly planned. This helps improve utilization of space inside the photovoltaic inverter 10, reduce a volume occupied by the photovoltaic inverter 10, and facilitate overall layout.

In the implementation shown in FIG. 28, the bottom plate body 1111 is a horizontal plate. In some embodiments, because values of H4, H5, and H6 are different, for a purpose of making full use of internal space of the photovoltaic inverter 10, the bottom plate body 1111 is an uneven plate, as shown in FIG. 7. The distance H2 between the bottom plate body 1111 and the circuit board 200 in the first direction X is a maximum distance between the bottom plate body 1111 and the circuit board 200 in the first direction X.

Still refer to FIG. 28. In an implementation, the photovoltaic inverter 10 further includes a fan 900. The fan 900 is located in the second subcavity S2 and connected to the circuit board 200. In this implementation, the fan 900 is disposed in the second subcavity S2, so that the fan 900 can air-cool the second device 800. The fan 900 is combined with the cooling fins, so that it is easier to control a temperature of the second device 800 within a temperature range suitable for the second device 800 to work. The fan 900 is disposed inside the photovoltaic inverter 10. This helps improve utilization of space inside the photovoltaic inverter 10. The fan 900 in FIG. 28 is only used to show that the fan 900 is located in the second subcavity S2, and does not represent a specific position of the fan 900 in the second subcavity S2. The specific position may be set based on component layout of the second subcavity S2.

Still refer to FIG. 7. In an implementation, a maximum length between the bottom plate 111 and the rear circuit board side 230 in the first direction X is greater than a length between the cover plate 120 and the front circuit board side 220 in the first direction X. In an implementation, a maximum length between the bottom plate body 1111 and the rear circuit board side 230 in the first direction X is greater than the length between the cover plate 120 and the front circuit board side 220 in the first direction X, so that the inductor 830, the bus capacitor 820, and the switch body 320 can be accommodated between the bottom plate body 1111 and the rear circuit board side 230. In this implementation, the bottom plate body 1111 is a part other than the protrusion plate 1112, and the protrusion plate 1112 protrudes toward the circuit board 200. Therefore, the maximum length between the bottom plate 111 and the rear circuit board side 230 in the first direction X is equal to the maximum length between the bottom plate body 1111 and the rear circuit board side 230 in the first direction X.

In this implementation, the second subcavity S2 for accommodating the second device 800 and the switch body 320 is located between the bottom plate 111 and the rear circuit board side 230, and the first subcavity S1 for accommodating the first device 700 is located between the cover plate 120 and the front circuit board side 220. Because sizes of the second device 800 and the switch body 320 in the first direction X are greater than a size of the first device 700 in the first direction X, the volume of the second subcavity S2 needs to be correspondingly set to be greater than the volume of the first subcavity S1, and further the distance between the bottom plate body 1111 and the rear circuit board side 230 in the first direction X needs to be greater than the distance between the cover plate 120 and the front circuit board side 220 in the first direction X. In this solution, installation space is provided for disposing the inductor 830, the bus capacitor 820, and the switch body 320 on the rear circuit board side 230.

In an implementation, a value of a length of either of the surface mount resistor 710 and the surface mount capacitor 720 in the first direction X is less than or equal to 5 millimeters, so that the volume of the first subcavity S1 is small and the overall size of the photovoltaic inverter 10 is reduced. In this implementation, lengths of the surface mount resistor 710 and the surface mount capacitor 720 in the first direction X are set to be small, so that the surface mount resistor 710 and the surface mount capacitor 720 occupy small space in the first subcavity S1, the volume of the first subcavity S1 is set to be small, and miniaturization design of the photovoltaic inverter 10 is facilitated.

In an implementation, a value of the length between the front circuit board side 220 and the cover plate 120 in the first direction X is less than or equal to 20 millimeters. In this implementation, the value of the length between the front circuit board side 220 and the cover plate 120 in the first direction X corresponds to the volume of the first subcavity S1. The volume of the first subcavity S1 is set to be small, so that miniaturization design of the photovoltaic inverter 10 is facilitated.

In an implementation, a value of the maximum length between the rear circuit board side 230 and the bottom plate 111 in the first direction X is greater than or equal to 10 centimeters. In a specific implementation, a value of the length between the rear circuit board side 230 and the bottom plate body 1111 in the first direction X is greater than or equal to 10 centimeters, so that the inductor 830, the bus capacitor 820, and the switch body 320 can be accommodated between the rear circuit board side 230 and the bottom plate body 1111. In this implementation, because different positions of the bottom plate body 1111 may not be in a same plane, the length between the rear circuit board side 230 and the bottom plate body 1111 in the first direction X is the maximum length between the rear circuit board side 230 and the bottom plate body 1111 in the first direction X, and the value of the maximum length is set to be greater than or equal to 10 centimeters, so that the second subcavity S2 has sufficient space for accommodating the inductor 830, the bus capacitor 820, and the switch body 320 with a large size. This helps reduce installation difficulty.

In an implementation, a value of the length between the rear circuit board side 230 and the bottom plate body 1111 in the first direction X is greater than or equal to 20 centimeters. In this implementation, the length between the rear circuit board side 230 and the bottom plate body 1111 in the first direction X is set to properly adjust the space size of the second subcavity S2, so that the second subcavity S2 has sufficient space for accommodating the inductor 830, the bus capacitor 820, and the switch body 320 that have a large size. This helps reduce installation difficulty.

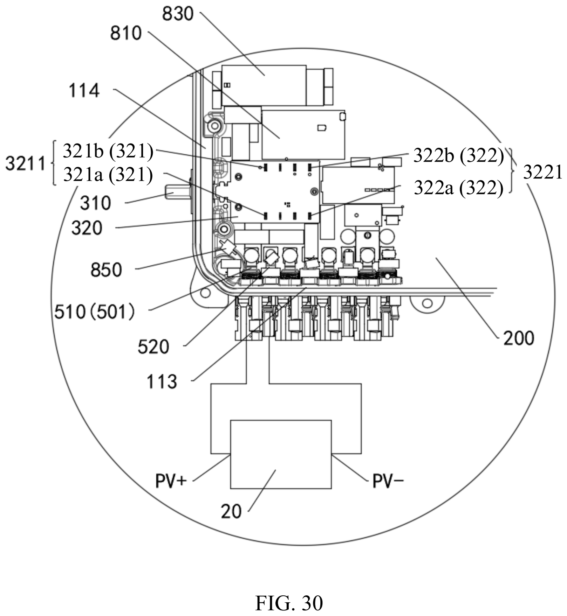

Refer to FIG. 29 and FIG. 30. FIG. 29 is a diagram of a partial structure of the photovoltaic inverter 10 according to an embodiment of this application. FIG. 30 is a partial enlarged diagram of the photovoltaic inverter 10 shown in FIG. 29. In an implementation, the plurality of PV ports 501 include positive connectors 510 (as shown in FIG. 29). One end of the positive connector 510 is located inside the housing 100 and fastened to the rear circuit board side (as shown in FIG. 30), the other end of the positive connector 510 passes through the housing 100 and extends to the outer side of the housing 100 (as shown in FIG. 29), and the other end of the positive connector 510 is configured to electrically connect to the positive electrode PV+ of the photovoltaic module 20. The second device 800 further includes filter capacitors 850. The filter capacitors 850 are electrically connected between the positive connectors 510 and the input pins 321 (as shown in FIG. 30) through the metal traces 201 of the circuit board 200, to reduce impedance between the positive connectors 510 and the filter capacitors 850 and improve filtering effect.

The inductor 830 and the filter capacitors 850 form a resonant circuit. Harmonics in a direct current are filtered out, so that heat generated by the inverter power assembly 810 is reduced, a safety risk is avoided, and reliability of inverter conversion is improved. In this implementation, the resonant circuit formed by the inductor 830 and the filter capacitors 850 is an input-side filter circuit. In an implementation, an output-side filter circuit exists on an output side of the inverter power assembly 810.

In this implementation, the positive connectors 510 are electrically connected to the photovoltaic module 20, and the pins 301 is a part of the switch body 320. In this solution, the filter capacitors 850 are electrically connected between the positive connectors 510 and the input pins 321. That is, the photovoltaic module 20, the filter capacitors 850, and the switch body 320 are sequentially electrically connected. If the switch body 320 is electrically connected between the filter capacitors 850 and the positive connectors 510, the direct current output by the photovoltaic module 20 first passes through the switch body 320, and then flows into the filter capacitors 850. Because the switch body 320 has specific resistance, filtering effect of the filter capacitors 850 on the direct current is reduced. Therefore, in this implementation, filtering effect of the filter capacitors 850 is improved.

In this implementation, a quantity of positive connectors 510 is the same as the quantity of input pin pairs 3211.

In an implementation, the filter capacitors 850 may be disposed on either of the front circuit board side 220 and the rear circuit board side 230. When the filter capacitors 850 may be disposed on the rear circuit board side 230, internal space of the second subcavity S2 may be fully utilized.

Still refer to FIG. 29 and FIG. 30. In an implementation, the plurality of PV ports 501 further include negative connectors 520 (as shown in FIG. 29). One end of the negative connector 520 is located inside the housing 100 and fastened to the rear circuit board side (as shown in FIG. 30). The other end of the negative connector 520 passes through the housing 100 and extends to the outer side of the housing 100 (as shown in FIG. 29). The other end of the negative connector 520 is configured to electrically connect to the negative electrode PV- of the photovoltaic module 20.

In this implementation, the output pin pairs 3221 are located between a negative electrode of the inverter power assembly 810 and the negative electrode PV- of the photovoltaic module 20. A current sequentially flows from the positive electrode PV+ of the photovoltaic module 20 to the positive connectors 510, the input pin pairs 3211, and the positive electrode of the inverter power assembly 810, undergoes inversion conversion in the inverter power assembly 810, and then sequentially flows from the negative electrode of the inverter power assembly 810 to the output pin pairs 3221, the negative connectors 520, and the negative electrode of the photovoltaic module 20, to form a loop.

In this implementation, a quantity of negative connectors 520 is the same as the quantity of output pin pairs 3221.

In an implementation, positions of the positive connectors 510 and the negative connectors 520 may be exchanged. Correspondingly, positions of the positive electrode PV+ of the photovoltaic module 20 and the negative electrode PV- of the photovoltaic module 20 are exchanged, which is not limited to a position relationship shown in FIG. 30, provided that the positive connectors 510 can be electrically connected to the positive electrode PV+ of the photovoltaic module 20, and the negative connectors 520 can be electrically connected to the negative electrode PV-of the photovoltaic module 20.

In an implementation, the positive connectors 510 and/or the negative connectors 520 are detachably connected to the circuit board 200. For example, one end of the positive connector 510 may be fixedly connected to the circuit board 200 through a screw. When detachment is needed, the screw is removed, so that the positive connector 510 can be separated from the circuit board 200. For example, when the negative connector 520 is far away from the circuit board 200, the negative connector 520 may be detachably connected to the circuit board 200 through a connection component.

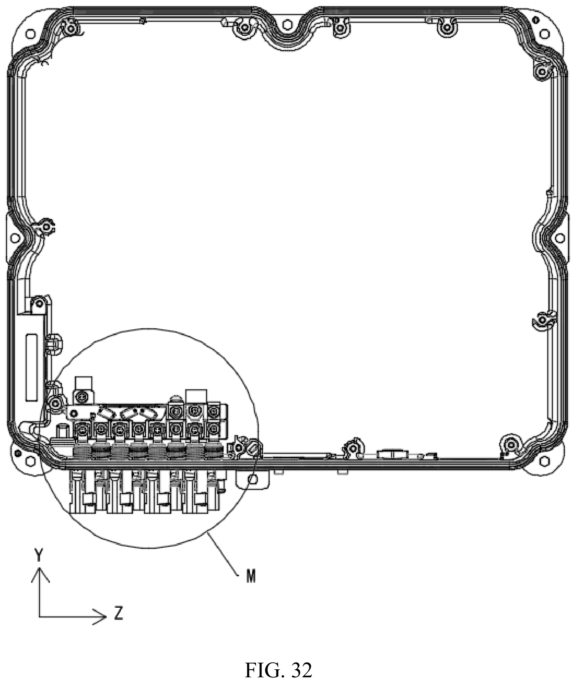

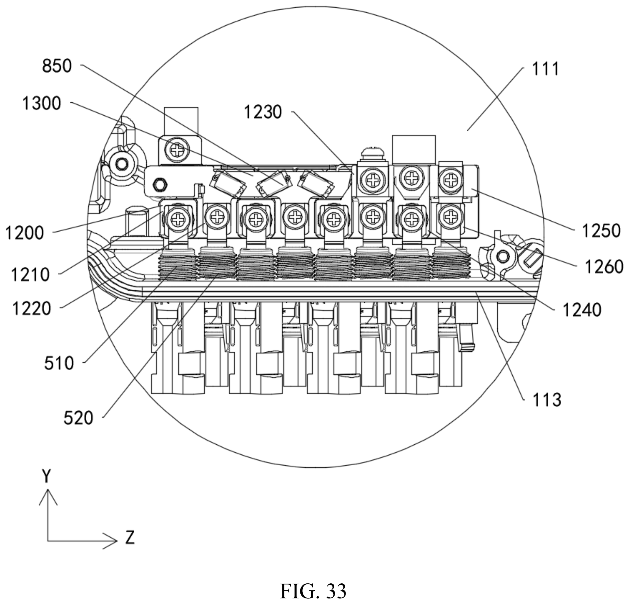

Refer to FIG. 32 and FIG. 33. FIG. 32 is a diagram of a partial structure of the photovoltaic inverter according to an embodiment of this application. FIG. 33 is an enlarged view of an M part in FIG. 32. In an implementation, the photovoltaic inverter 10 further includes an insulation support 1200. The insulation support 1200 is located between the bottom plate 111 and the circuit board 200. The circuit board is omitted in FIG. 32 and FIG. 33. The insulation support 1200 is fastened to the bottom plate 111. One end of at least one of the PV ports 501 is fastened between the insulation support 1200 and the circuit board 200. The insulation support 1200 is located in the second subcavity S2, so that space of the second subcavity S2 is fully utilized. In this implementation, the insulation support 1200 is configured to support the PV ports 501, so that the PV ports 501 are more stably fastened to the circuit board 200. In an implementation, the insulation support 1200 is made of a non-conductive material, to avoid affecting electrical connection between the PV ports 501 and the circuit board 200. In an implementation, the insulation support 1200 may be fastened to the bottom plate 111 through a screw or an adhesive.

In an implementation, one end that is of each PV port 501 and that is located inside the bottom housing 110 is fastened between the insulation support 1200 and the circuit board 200. For example, one end of the PV port 501, the circuit board 200, and the insulation support 1200 are fastened to each other through a screw.

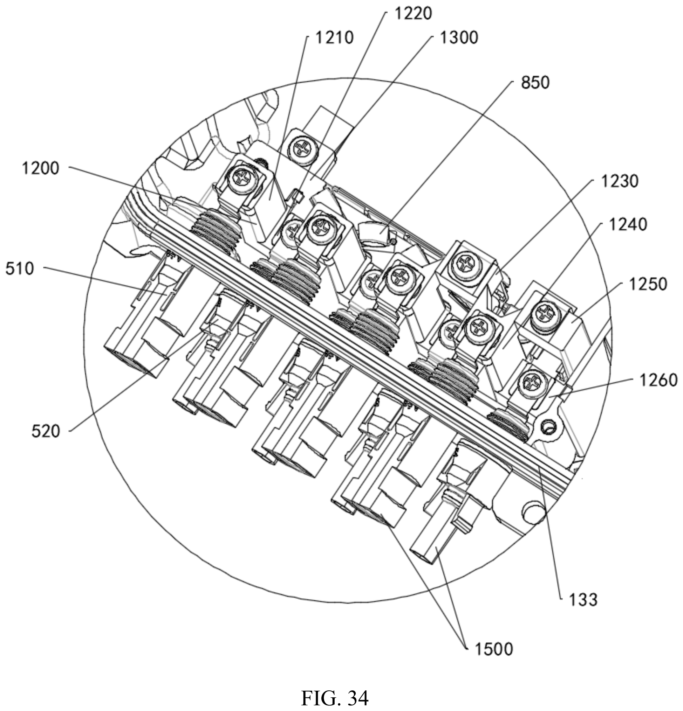

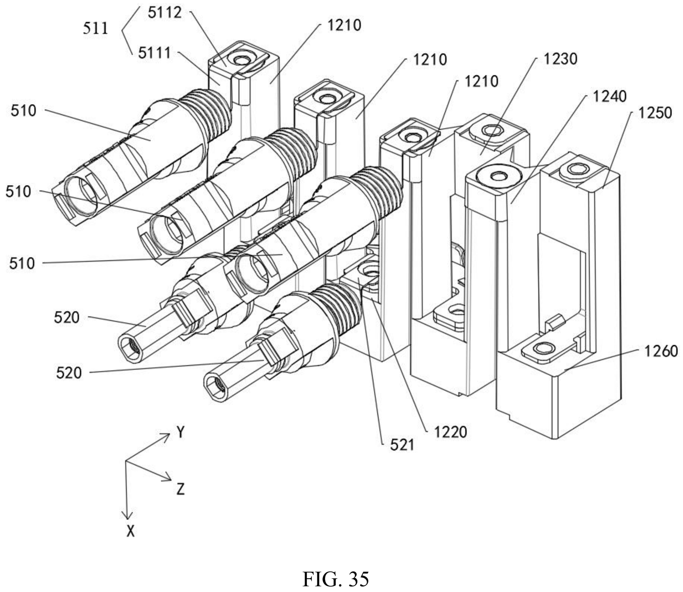

Refer to FIG. 34 and FIG. 35. FIG. 34 is a diagram of a partial structure of the photovoltaic inverter according to an embodiment of this application. FIG. 35 is a diagram of a structure of the insulation support and the PV port in the photovoltaic inverter according to an embodiment of this application. In an implementation, the insulation support 1200 includes a plurality of first support parts 1210 and a plurality of second support parts 1220. The plurality of first support parts 1210 and the plurality of second support parts 1220 are sequentially and alternately arranged in a third direction Z. The third direction Z is parallel to the arrangement direction of the knob 310 and the switch body 320. In the first direction X, a distance between the bottom plate 111 and a surface that is of the first support part 1210 and that is away from the bottom plate 111 is greater than a distance between the bottom plate 111 and a surface that is of the second support part 1220 and that is away from the bottom plate 111. One end of each of some PV ports 501 of the plurality of PV ports 501 is fastened to the surface that is of each of the plurality of first support parts 1210 and that is away from the bottom plate 111. One end of each of the other PV ports 501 of the plurality of PV ports 501 is fastened to the surface that is of each of the plurality of second support parts 1220 and that is away from the bottom plate 111. In this implementation, heights of the first support parts 1210 and the second support parts 1220 are different. Some PV ports 501 are fastened between the first support parts 1210 and the circuit board 200, and some PV ports 501 are fastened between the second support parts 1220 and the circuit board 200, so that the PV ports 501 are dispersedly arranged, and impact of centralized layout on stability of electrical connection between the PV ports 501 is avoided.

In this implementation, the plurality of first support parts 1210 and the plurality of second support parts 1220 are sequentially and alternately arranged in the third direction Z, so that the plurality of PV ports 501 are sequentially and alternately arranged in the third direction Z, and the PV ports 501 are more orderly arranged.

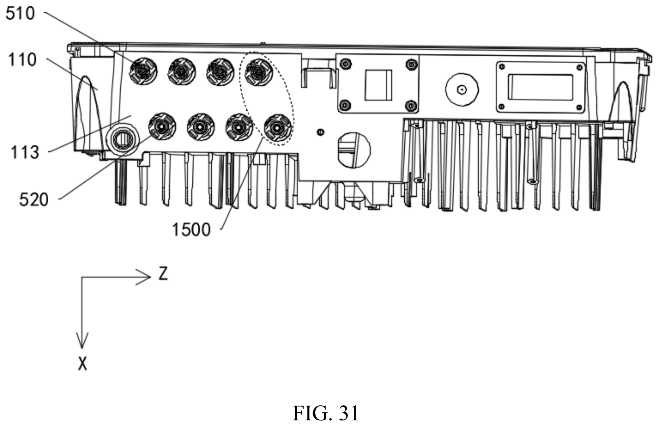

Refer to FIG. 31. FIG. 31 is a front view of the photovoltaic inverter according to an embodiment of this application. In an implementation, the bottom housing 110 includes a first subboard 113 located between the bottom plate 111 and the cover plate 120. The first subboard 113 is parallel to the third direction Z. The plurality of PV ports 501 include a plurality of positive connectors 510 and a plurality of negative connectors 520. The plurality of positive connectors 510 and the plurality of negative connectors 520 are all fastened to the first subboard 113. In the first direction X, distances between the plurality of positive connectors 510 and the bottom plate 111 are greater than distances between the plurality of negative connectors 520 and the bottom plate 111. In the third direction Z, the plurality of positive connectors 510 and the plurality of negative connectors 520 are sequentially and alternately arranged.

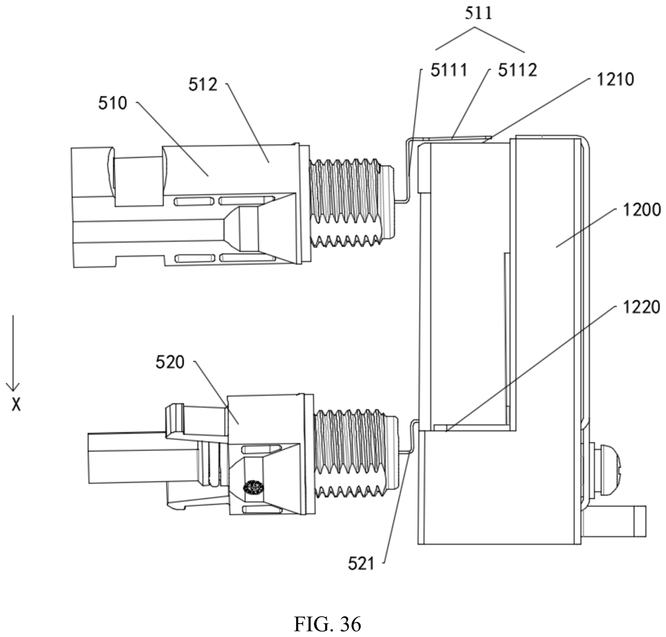

Refer to FIG. 35 and FIG. 36. FIG. 36 is a diagram of a structure of the insulation support and the PV port in the photovoltaic inverter according to an embodiment of this application. In an implementation, one end that is of each positive connector 510 and that is located inside the bottom housing 110 includes a positive metal sheet 511. One end that is of each negative connector 520 and that is located inside the housing includes a negative metal sheet 521. Each positive metal sheet 511 is fastened to a surface that is of one first support part 1210 and that is away from the bottom plate 111, and is fastened to the circuit board 200. Each negative metal sheet 521 is fastened to a surface that is of one second support part 1220 and that is away from the bottom plate 111.

In this implementation, the plurality of positive connectors 510 are fastened to the first support parts 1210, and the plurality of negative connectors 520 are fastened to the second support parts 1220, so that the plurality of positive connectors 510 and the plurality of negative connectors 520 are sequentially and alternately arranged in the third direction Z and distributed in a staggered manner in the first direction X, mutual interference between electrical connection of the plurality of positive connectors 510 and electrical connection of the plurality of negative connectors 520 is reduced, stability of electrical connection is improved, and overall layout is more orderly.

In this implementation, the positive connector 510 is fastened between the first support part 1210 and the circuit board 200 through the positive metal sheet 511 located in the bottom housing 110. For example, the first support part 1210, the positive connector 510, and the circuit board 200 each have a corresponding screw hole. The first support part 1210, the positive connector 510, and the circuit board 200 are fastened to each other in the first direction X through a screw. A screw cap of the screw is located on a side that is of the circuit board 200 and that is away from the first support part 1210.

In this implementation, the negative connector 520 is fastened to the second support part 1220 through the negative metal sheet 521 located in the bottom housing 110. For example, the second support part 1220 and the negative connector 520 each have a corresponding screw hole. The second support part 1220 and the negative connector 520 are fastened to each other in the first direction X through a screw. A screw cap of the screw is located in the second subcavity S2 and located on a surface that is of the negative metal sheet 521 and that is away from the second support part 1220.

In an implementation, the positive connector 510 includes a positive connector housing 512 (as shown in FIG. 36). The positive connector housing 512 is fastened to the first subboard 113. Two ends of the positive connector housing 512 are located inside and outside the bottom housing 110 respectively. The positive metal sheet 511 is fastened to one end that is of the positive connector housing 512 and that is located inside the bottom housing 110. A distance between the bottom plate 111 and the surface that is of the first support part 1210 and that is away from the bottom plate 111 is greater than a distance between the positive connector housing 512 and the bottom plate 111. The positive metal sheet 511 includes a bending section 5111 and a positive fastening section 5112. The bending section 5111 is connected between the positive fastening section 5112 and the positive connector housing 512. The positive fastening section 5112 is fastened between the circuit board 200 and the surface that is of the first support part 1210 and that is away from the bottom plate 111.

In this implementation, because the first support parts 1210 are further configured to support the circuit board 200, to enlarge space between the circuit board 200 and the bottom plate 111 or enlarge space of the second subcavity S2, lengths of the first support parts 1210 in the first direction X need to be set to be large. However, the first subboard 113 is configured to fasten the positive connector housing 512. Because the positive connector housing 512 has a specific length in the first direction X, when the positive connector housing 512 is fastened to the first subboard 113, the positive connector housing 512 is lower than the circuit board 200 in the first direction X. In this application, distances between the positive connector housing 512 and the first support part 1210 and between the positive connector housing 512 and the bottom plate 111 are different, metal in the positive connector housing 512 is connected to the positive fastening section 5112 through the bending section in the positive metal sheet 511, the positive fastening section 5112 is fastened between the first support part 1210 and the circuit board 200, and the positive connector 510 is connected to the circuit board 200. For example, the positive metal sheet 511 is in a "Z" shape.

The distance between the negative connector 520 and the bottom plate 111 is less than the distance between the positive connector 510 and the bottom plate 111. Therefore, in an implementation, the negative metal sheet 521 in the negative connector 520 may be planar. In an implementation, the negative metal sheet 521 in the negative connector 520 may also be set to a "Z" shape.

Still refer to FIG. 30. In an implementation, the bottom housing 110 includes a first subboard 113 located between the bottom plate 111 and the cover plate 120. The positive connectors 510 are fastened to the first subboard 113. The arrangement direction of the knob 310 and the switch body 320 is parallel to the first subboard 113. The filter capacitors 850 are located on circumferential sides of the positive connectors 510 and between the switch body 320 and the first subboard 113, so that a connection line between the filter capacitors 850 and the positive connectors 510 is shorter, and the photovoltaic inverter 10 has a more compact structure and a smaller size.

In this implementation, one end of the positive connector 510 passes through the first subboard 113 and extends to the inner side of the housing 100. An orthographic projection of the filter capacitor 850 on the circuit board 200 is located on a circumferential side of an orthographic projection of the positive connector 510 on the circuit board 200. Because the filter capacitors 850 are electrically connected between the positive connectors 510 and the switch body 320, in this solution, the filter capacitors 850 are disposed close to the positive connectors 510, so that distances between the filter capacitors 850 and the positive connectors 510 are reduced, the current input from the photovoltaic module 20 can be directly transferred to the filter capacitors 850, a length of a current input path of the photovoltaic inverter 10 is effectively shortened, impedance is smaller, and filtering effect of the filter capacitors 850 is improved. In addition, in this solution, device arrangement of the photovoltaic inverter 10 can be further optimized. This helps reduce the size of the photovoltaic inverter 10.

It should be noted that, when the photovoltaic inverter 10 is not installed, the bottom plate 111 of the photovoltaic inverter 10 may be placed facing the ground, and the cover plate 120 of the housing 100 is located above the bottom plate 111. When the photovoltaic inverter 10 is installed on a site of the photovoltaic system, the first subboard 113 of the housing 100 may be placed facing the ground, and a subboard disposed opposite to the first subboard 113 is located above the first subboard 113. In some implementations, an installation direction of the photovoltaic inverter 10 may be set based on an onsite environment and a function requirement.

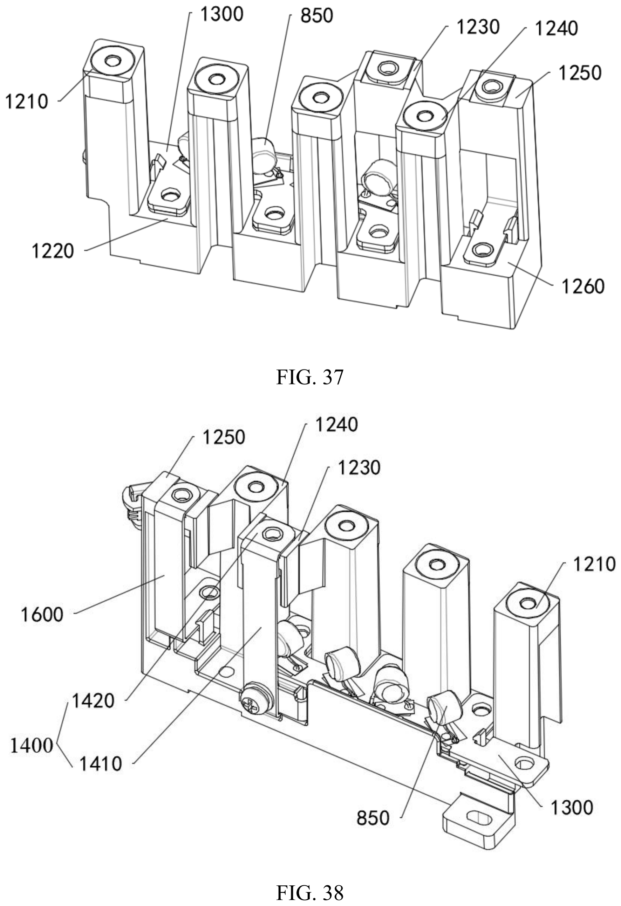

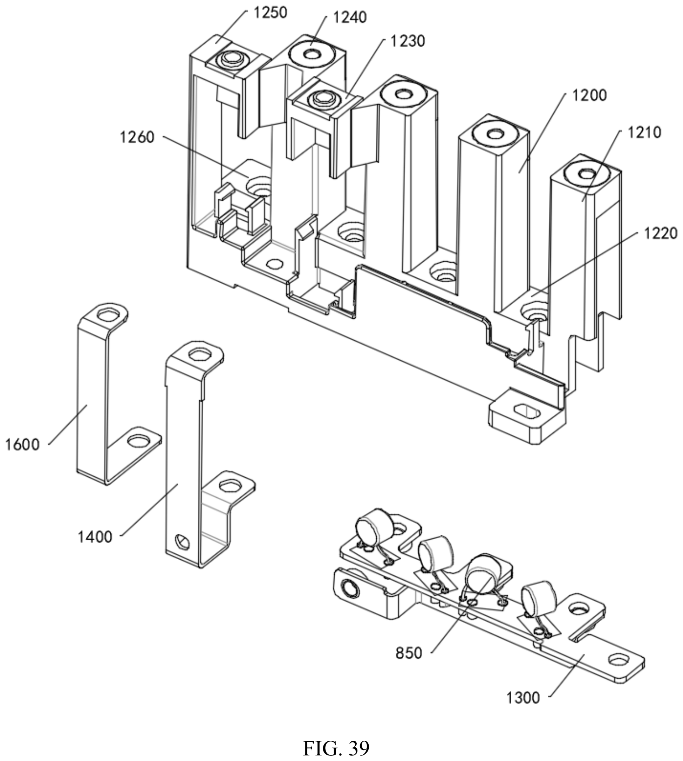

Refer to FIG. 37, FIG. 38, and FIG. 39. FIG. 37 is a diagram of a structure of a part including the insulation support and the filter circuit board in the photovoltaic inverter according to an embodiment of this application. FIG. 38 is a diagram of the structure of the part including the insulation support and the filter circuit board in the photovoltaic inverter according to an embodiment of this application. FIG. 39 is an exploded diagram of the part including the insulation support and the filter circuit board in the photovoltaic inverter according to an embodiment of this application. In an implementation, the photovoltaic inverter 10 further includes a filter circuit board 1300 and filter capacitors 850. The filter circuit board 1300 is fastened between the bottom plate 111 and the circuit board 200 in the first direction X. In a second direction Y, the filter circuit board 1300 is located on a side that is of the plurality of first support parts 1210 and that is away from the first subboard 113. The second direction Y is perpendicular to both the first direction X and the third direction Z. The filter capacitors 850 are fastened to a surface that is of the filter circuit board 1300 and that faces the circuit board 200. The plurality of negative connectors 520 are connected to the filter circuit board 1300. The filter capacitors 850 are connected to some pins 301 of the switch body 320 through the filter circuit board 1300 and the metal traces of the circuit board 200.

In this implementation, the filter capacitors 850 are fastened by using the filter circuit board 1300, and the filter capacitors 850 are electrically connected to the circuit board 200 through the filter circuit board 1300, so that the filter capacitors 850 do not occupy space on the circuit board 200, and space of the second subcavity S2 can be fully utilized. In this implementation, the filter capacitors 850 belong to the input-side filtering component 1000, the filter capacitors 850 are connected to the negative connectors 520 through the filter circuit board 1300, and the filter capacitors 850 are connected to the switch body 320 through the filter circuit board 1300 and the metal traces of the circuit board 200, so that the filter capacitors 850 are connected between the negative connectors 520 and the pins 301 of the switch body 320, and filtering effect of the filter capacitors 850 is improved.

Still refer to FIG. 38 and FIG. 39. In an implementation, the insulation support 1200 further includes a third support part 1230. The third support part 1230 is located between the filter circuit board 1300 and the circuit board 200 in the first direction X. A projection of the third support part 1230 in the first direction X and a projection of the filter circuit board 1300 in the first direction X partially overlap. In the second direction Y, a distance between the third support part 1230 and the first subboard 113 is greater than a distance between each first support part 1210 and the first subboard 113. The third support part 1230 is fastened to one first support part 1210. The photovoltaic inverter 10 further includes a first connection metal sheet 1400. The filter circuit board 1300 is connected to one end of the first connection metal sheet 1400. The plurality of negative connectors 520 are connected to the first connection metal sheet 1400 through the filter circuit board 1300. The plurality of filter capacitors 850 are connected to the first connection metal sheet 1400 through the filter circuit board 1300. The other end of the first connection metal sheet 1400 is fastened to a surface that is of the third support part 1230 and that is away from the bottom plate 111, and is fixedly connected to the circuit board 200.

In this implementation, one end of the first connection metal sheet 1400 is connected to the plurality of negative connectors 520 and the plurality of filter capacitors 850, and the other end of the first connection metal sheet 1400 is configured to fasten to the circuit board 200, so that the plurality of negative connectors 520 and the plurality of filter capacitors 850 are connected to the circuit board 200 through one connector, and structural layout is simplified.

In an implementation, the third support part 1230 is arranged in the third direction Z on a side that is of all the first support parts 1210 and the second support parts 1220 and that is away from a second subboard 114, so that arrangement is more orderly.

In an implementation, the first connection metal sheet 1400 includes a total connection section 1410 and a total fastening section 1420 that are connected to each other. The total connection section 1410 is connected between the filter circuit board 1300 and the total fastening section 1420. The total fastening section 1420 is configured to connect to the circuit board 200. In the second direction Y, the total connection section 1410 is located on a side that is of the third support part 1230 and that is away from the first subboard 113. The total fastening section 1420 is fastened between the circuit board 200 and a surface that is of the third support part 1230 and that is away from the bottom plate 111. Structural layout is more orderly.

In an implementation, the insulation support 1200 further includes an external connector pair 1500 configured to support connection to a battery pack, as shown in FIG. 31. The external connector pair 1500 is configured to connect to the battery pack. The insulation support 1200 further includes a fourth support part 1240, a fifth support part 1250, and a sixth support part 1260 (as shown in FIG. 37 and FIG. 38). In the first direction X, a distance between the bottom plate 111 and a surface that is of the sixth support part 1260 and that is away from the bottom plate 111 is less than distances between the bottom plate 111 and surfaces that are of the fourth support part 1240 and the fifth support part 1250 and that are away from the bottom plate 111. The sixth support part 1260 is configured to fixedly connect to a negative connector in the external connector pair 1500 (as shown in FIG. 34), and is connected between the fifth support part 1250 and the circuit board 200 through a second metal connection plate 1600. The fourth support part 1240 is configured to fixedly support a positive connector in the external connector pair 1500 and connect the positive connector to the circuit board 200.

In an implementation, the first support part 1210 and the second support part 1220 are of an integrally-molded structure. In an implementation, the first support part 1210, the second support part 1220, and the third support part 1230 are of an integrally-molded structure. In an implementation, the first support part 1210, the second support part 1220, the third support part 1230, the fourth support part 1240, the fifth support part 1250, and the sixth support part 1260 are of an integrally-molded structure. Structural strength of the insulation support 1200 is improved.

Still refer to FIG. 30. In an implementation, the bottom housing 110 further includes the second subboard 114 located between the bottom plate 111 and the cover plate 120. The second subboard 114 is connected to and intersects with the first subboard 113. One end of the knob 310 passes through the second subboard 114 and extends to the inner side of the housing 100, and is fastened to the switch body 320. In this solution, the knob 310 and the positive connectors 510 are disposed on different subboards of the housing 100, so that installation space of the different subboards is effectively used, and an operation error can be avoided.

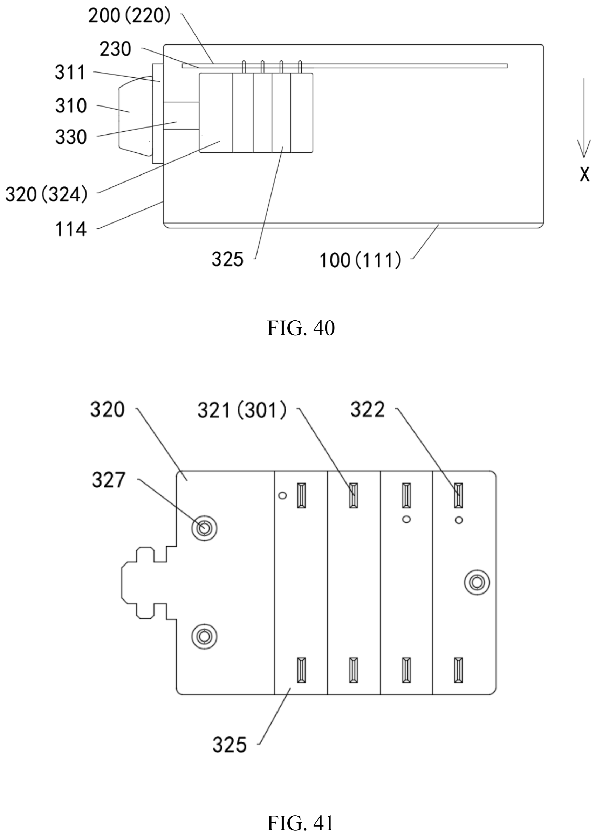

Refer to FIG. 7 and FIG. 40. FIG. 40 is a diagram of a partial structure of the photovoltaic inverter 10 according to an embodiment of this application. In an implementation, the second subboard 114 is provided with a mounting hole (not shown in FIG. 40) that penetrates an inner surface and an outer surface of the second subboard 114. A sealing component 311 (as shown in FIG. 2 and FIG. 40) is disposed on an outer side of the second subboard 114. The knob 310 includes a connecting rod 330 (as shown in FIG. 40). The connecting rod 330 sequentially passes through the sealing component 311 and the mounting hole and extends to the inner side of the housing 100. The sealing component 311 is configured to seal a gap between the mounting hole and the connecting rod 330, to avoid that water vapor or impurities enter the housing 100 through the mounting hole and affect performance of the circuit board 200 or an electrical component. For example, the sealing component 311 may be a sealing gasket. Alternatively, the sealing component 311 includes a sealing base and a sealing rubber sheet, where the sealing base presses the sealing rubber sheet on the outer surface of the second subboard 114 through a screw. Because the switch body 320 is fastened to the circuit board 200, space between the switch body 320 and the inner surface of the second subboard 114 is limited, and it is inconvenient to install the sealing component 311 on the inner surface of the second subboard 114. In this implementation, the sealing component 311 is disposed on the outer side of the second subboard 114, so that installation of the knob 310 and the sealing component 311 is facilitated. In some implementations, when space between the switch body 320 and the second subboard 114 is sufficient, the sealing component 311 may alternatively be installed on the inner side of the second subboard 114.

In an implementation, the three input pin pairs 3211 and the one output pin pair 3221 are sequentially arranged. An arrangement direction is parallel to an extension direction of the switch body 320. The output pin pair 3221 is arranged farther away from the housing 100 than the input pin pairs 3211. In another implementation, positions of the input pin pairs 3211 and the output pin pair 3221 may be exchanged.

In an implementation, in the input pin pair 3211, an input pin 321 electrically connected to the photovoltaic module 20 is denoted as 321a (as shown in FIG. 30), and an input pin 321 electrically connected to the inverter circuit is denoted as 321b. Compared with the input pin 321b, the input pin 321a is disposed closer to the first subboard 113, so that a distance between the input pin 321a and the positive electrode PV+ of the photovoltaic module 20 can be reduced, and a structure of the photovoltaic inverter is more compact.

In an implementation, in the output pin pair 3221, an output pin 322 electrically connected to the photovoltaic module 20 is denoted as 322a (as shown in FIG. 30), and an output pin 322 electrically connected to the inverter circuit is denoted as 322b. Compared with the output pin 321b, the output pin 321a is disposed closer to the first subboard 113, so that a distance between the output pin 322a and the negative electrode PV- of the photovoltaic module 20 can be reduced, and the structure of the photovoltaic inverter is more compact.

In an implementation, in the input pin pair 3211, positions of the input pin 321a and the input pin 321b may be exchanged. In the output pin pair 3221, positions of the output pin 321a and the output pin 321b may be exchanged, to adapt to a plurality of scenarios.

Still refer to FIG. 30. In an implementation, the negative connectors 520 are fastened to the first subboard 113. In this solution, the positive connector 510 and the negative connector 520 are fastened to a same subboard of the housing 100. This reduces installation difficulty and saves space.

Refer to FIG. 23 and FIG. 29. In an implementation, the filter capacitors 850, the switch assembly 300, and the inductor 830 are sequentially arranged in the second direction Y. The second direction Y intersects with an extension direction of the switch body 320 and intersects with the first subboard 113 (as shown in FIG. 29). In this implementation, in the second direction Y, the switch assembly 300 is located between the filter capacitors 850 and the inductor 830, so that layout of devices on the circuit board 200 is optimized. Some filter capacitors 850, the switch assembly 300, and the inductor 830 are disposed close to the second subboard 114. This helps provide installation space for disposing another device in the photovoltaic inverter 10. In an implementation, the second direction Y is perpendicular to an extension direction of the switch body 320 and perpendicular to the first subboard 113. In this solution, installation difficulty of the photovoltaic inverter 10 is reduced.

In another implementation, the filter capacitors 850, the inductor 830, and the switch assembly 300 are sequentially arranged in the second direction Y. In this implementation, in the second direction Y, the inductor 830 is located between the filter capacitors 850 and the switch assembly 300, and both the filter capacitors 850 and the inductor 830 are disposed close to the first subboard 113, so that a resonant circuit formed by the filter capacitors 850 and the inductor 830 can be closer to the positive connectors 510, and filtering effect of the resonant circuit on the direct current is enhanced.

Refer to FIG. 41. FIG. 41 is a top view of the switch body 320 according to an embodiment of this application. In an implementation, positioning parts 327 are disposed on a surface that is of the switch body 320 and that faces the circuit board. The positioning parts 327 and the pins 301 are spaced. The positioning parts 327 are configured to perform auxiliary positioning when the switch body 320 is fastened to the circuit board.

In this implementation, the positioning parts 327 and the pins 301 are spaced, so that interference to electrical connection is avoided. The positioning parts 327 are dispersedly arranged on the surface that is of the switch body 320 and that faces the circuit board, so that the positioning parts 327 assist in positioning the switch body 320 more accurately. In this solution, the positioning parts 327 are disposed on the switch body 320, so that connection operation between the switch body 320 and the circuit board 200 is more convenient.

In the embodiment shown in FIG. 41, the switch body 320 includes three positioning parts 327. The three positioning parts 327 are separately close to two ends, in the extension direction of the switch body 320, of the surface that is of the switch body 320 and that faces the circuit board. In some other embodiments, a quantity of the positioning parts 327 may be any other positive integer, and positions of the plurality of positioning parts 327 may be randomly selected. A person skilled in the art may make adjustments based on an actual requirement. The quantity and distribution of the positioning parts 327 are not specifically limited in this application.

The photovoltaic inverter and the photovoltaic system provided in embodiments of this application are described in detail above. The principles and embodiments of this application are described herein by using specific examples. The description about the foregoing embodiments is merely provided to help understand the method and core ideas of this application. In addition, a person of ordinary skill in the art can make variations and modifications in terms of the specific embodiments and application scopes according to the ideas of this application. In conclusion, the content of this specification shall not be construed as a limitation to this application.

## Claims

1. A photovoltaic inverter, comprising:
a housing, comprising a bottom housing and a cover plate, wherein the bottom housing and the cover plate enclose an accommodating cavity, and the bottom housing comprises a bottom plate disposed opposite to the cover plate;
a circuit board, comprising a front circuit board side and a rear circuit board side that are disposed opposite to each other in a first direction, wherein metal traces are disposed on the circuit board, the front circuit board side faces the cover plate, the rear circuit board side faces the bottom plate, the circuit board is fastened in the accommodating cavity of the housing, and partitions the accommodating cavity into a first subcavity and a second subcavity, the first subcavity is located between the front circuit board side and the cover plate, the second subcavity is located between the rear circuit board side and the bottom plate, a volume of the first subcavity is less than a volume of the second subcavity, the first subcavity and the second subcavity accommodate a first device and a second device respectively, an operating heat dissipation amount of the second device is greater than an operating heat dissipation amount of the first device, or a length of the second device in the first direction is greater than a length of the first device in the first direction, the first device comprises a surface mount resistor and a surface mount capacitor that are fastened to the front circuit board side, and the second device comprises an inverter power assembly, a bus capacitor, and an inductor that are fastened to the rear circuit board side;
cooling fins, wherein the cooling fins are located on a side that is of the bottom plate and that is away from the cover plate, a thermally conductive contact part is disposed on a side that is of the inverter power assembly and that is away from the circuit board, the inverter power assembly is in thermally conductive connection to a part of the cooling fins through the thermally conductive contact part, and the bus capacitor and the inductor are located on a circumferential side of the thermally conductive contact part;
a switch assembly, wherein the switch assembly comprises a knob, a connecting rod, and a switch body, the knob and the switch body are located on an outer side and an inner side of the housing respectively, the knob is connected to the switch body through the connecting rod, the switch body is located in the second subcavity, the switch body is connected to the circuit board, the switch body comprises a plurality of breaking units, an arrangement direction of the plurality of breaking units is the same as an arrangement direction of the knob and the switch body, each breaking unit comprises pins, and the pins of each breaking unit are both rigidly fastened to the rear circuit board side; and
a plurality of PV ports, wherein one end of the PV port is located inside the housing and is connected to the circuit board, and the other end of the PV port passes through the housing and extends to the outer side of the housing; and
the PV ports are connected to some pins of the switch body through the metal traces of the circuit board, some pins of the switch body are connected to the bus capacitor through the metal traces of the circuit board, and the bus capacitor is connected to the inverter power assembly through the metal traces of the circuit board.

2. The photovoltaic inverter according to claim 1, wherein the breaking unit comprises a movable contact and static contacts, one end that is of the pin and that is away from the circuit board is fastened to the static contact, the static contact is connected to the metal trace of the circuit board through the pin, and the knob is capable of controlling the movable contact of the breaking unit to rotate, to disconnect or connect the movable contact and the static contacts.

3. The photovoltaic inverter according to claim 2, wherein one end that is of the pin and that is away from the circuit board is connected to the static contact through a connecting part; or one end of the static contact extends to an outer side of the breaking unit to form the pin.

4. The photovoltaic inverter according to claim 2, wherein the pins comprise input pins and output pins, the breaking units comprise input breaking units and an output breaking unit, the input pins and the output pins are located on the input breaking units and the output breaking unit respectively, and the knob is configured to control conduction between the input pins and conduction between the output pins, and is further configured to control disconnection between the input pins and disconnection between the output pins.

5. The photovoltaic inverter according to claim 4, wherein the switch body comprises at least one input pin pair and at least one output pin pair, each input pin pair comprises two input pins, each output pin pair comprises two output pins, and the PV port comprises a positive connector and a negative connector;
in the input breaking unit, one input pin in each input pin pair is configured to connect to the positive connector through the metal trace of the circuit board, two input pins in each input pin pair are connected through static contacts and a movable contact in the input breaking unit, and the other input pin in each input pin pair is configured to connect to the bus capacitor through the metal trace of the circuit board; and
in the output breaking unit, one output pin in each output pin pair is configured to connect to the negative connector through the metal trace of the circuit board, two output pins in each output pin pair are connected through static contacts and a movable contact in the output breaking unit, and the other output pin in each output pin pair is configured to connect to the inverter power assembly through the metal trace of the circuit board.

6. The photovoltaic inverter according to claim 1, wherein the second device further comprises a direct current conversion assembly, the direct current conversion assembly is fastened to the rear circuit board side, the direct current conversion assembly is located between the thermally conductive contact part and the rear circuit board side, and the direct current conversion assembly is in thermally conductive connection to the cooling fins through the thermally conductive contact part; and
some pins of the switch body are connected to the direct current conversion assembly through the metal traces of the circuit board, and the direct current conversion assembly is electrically connected to the bus capacitor through the metal traces of the circuit board.

7. The photovoltaic inverter according to claim 6, wherein the photovoltaic inverter further comprises an input-side filtering component and an output-side filtering component, and both the input-side filtering component and the output-side filtering component are connected to the circuit board;
the PV port is connected to the input-side filtering component through the metal traces of the circuit board, and the input-side filtering component is connected to some pins of the switch body through the metal traces of the circuit board; and
the inverter power assembly is connected to the output-side filtering component through the metal traces of the circuit board.

8. The photovoltaic inverter according to any one of claims 1 to 7, wherein a distance between the thermally conductive contact part and the rear circuit board side in the first direction is less than a distance between the bottom plate and the circuit board in the first direction, and a length of the inverter power assembly in the first direction is less than a length of at least one of the bus capacitor, the inductor, and the switch assembly in the first direction.

9. The photovoltaic inverter according to any one of claims 1 to 7, wherein a maximum length between the bottom plate and the rear circuit board side in the first direction is greater than a length between the cover plate and the front circuit board side in the first direction, so that the inductor, the bus capacitor, and the switch body are capable of being accommodated between the bottom plate and the rear circuit board side.

10. The photovoltaic inverter according to any one of claims 1 to 7, wherein a value of a length of either of the surface mount resistor and the surface mount capacitor in the first direction is less than or equal to 5 millimeters;
a value of a length between the front circuit board side and the cover plate in the first direction is less than or equal to 20 millimeters, so that the volume of the first subcavity is small and an overall size of the photovoltaic inverter is reduced; and/or
a value of a maximum length between the rear circuit board side and the bottom plate in the first direction is greater than or equal to 10 centimeters, so that the inductor, the bus capacitor, and the switch body are capable of being accommodated between the rear circuit board side and the bottom plate.

11. The photovoltaic inverter according to any one of claims 1 to 7, wherein the plurality of PV ports comprise positive connectors, the bottom housing comprises a first subboard located between the bottom plate and the cover plate, the positive connectors are fastened to the first subboard, the arrangement direction of the knob and the switch body is parallel to the first subboard, one end of the positive connector is located inside the housing and fastened to the rear circuit board side, the second device further comprises filter capacitors, the filter capacitors are fastened to the rear circuit board side, the filter capacitors are located on circumferential sides of the positive connectors and between the switch body and the first subboard, and the filter capacitors are connected between the positive connectors and the pins through the metal traces of the circuit board.

12. The photovoltaic inverter according to any one of claims 1 to 7, wherein the photovoltaic inverter further comprises an insulation support, the insulation support is located between the bottom plate and the circuit board, the insulation support is fastened to the bottom plate, and one end of at least one of the PV ports is fastened between the insulation support and the circuit board.

13. The photovoltaic inverter according to claim 12, wherein the insulation support comprises a plurality of first support parts and a plurality of second support parts, the plurality of first support parts and the plurality of second support parts are sequentially and alternately arranged in a third direction, the third direction is parallel to the arrangement direction of the knob and the switch body, in the first direction, a distance between the bottom plate and a surface that is of the first support part and that is away from the bottom plate is greater than a distance between the bottom plate and a surface that is of the second support part and that is away from the bottom plate, one end of each of some PV ports of the plurality of PV ports is fastened to the surface that is of each of the plurality of first support parts and that is away from the bottom plate, and one end of each of the other PV ports of the plurality of PV ports is fastened to the surface that is of each of the plurality of second support parts and that is away from the bottom plate.

14. The photovoltaic inverter according to claim 13, wherein the bottom housing comprises a first subboard located between the bottom plate and the cover plate, the first subboard is parallel to the third direction, the plurality of PV ports comprise a plurality of positive connectors and a plurality of negative connectors, the plurality of positive connectors and the plurality of negative connectors are all fastened to the first subboard, in the first distance, distances between the plurality of positive connectors and the bottom plate are greater than distances between the plurality of negative connectors and the bottom plate, and in the third direction, the plurality of positive connectors and the plurality of negative connectors are sequentially and alternately arranged; and
one end that is of each positive connector and that is located inside the housing case comprises a positive metal sheet, one end that is of each negative connector and that is located inside the housing case comprises a negative metal sheet, each positive metal sheet is fastened to a surface that is of one first support part and that is away from the bottom plate, and is fastened to the circuit board, and each negative metal sheet is fastened to a surface that is of one second support part and that is away from the bottom plate.

15. The photovoltaic inverter according to claim 14, wherein the positive connector comprises a positive connector housing and the positive metal sheet, the positive connector housing is fastened to the first subboard, two ends of the positive connector housing are located inside and outside the bottom housing respectively, the positive metal sheet is fastened to one end that is of the positive connector housing and that is located inside the bottom housing, the distance between the bottom plate and the surface that is of the first support part and that is away from the bottom plate is greater than a distance between the positive connector housing and the bottom plate, the positive metal sheet comprises a bending section and a positive fastening section, the bending section is connected between the positive fastening section and the positive connector housing, and the positive fastening section is fastened between the circuit board and the surface that is of the first support part and that is away from the bottom plate.

16. The photovoltaic inverter according to claim 14, wherein the photovoltaic inverter further comprises a filter circuit board and filter capacitors, the filter circuit board is fastened between the bottom plate and the circuit board in the first direction, in a second direction, the filter circuit board is located on a side that is of the plurality of first support parts and that is away from the first subboard, the second direction is perpendicular to both the first direction and the third direction, the filter capacitors are fastened to a surface that is of the filter circuit board and that faces the circuit board, the plurality of negative connectors are connected to the filter circuit board, and the filter capacitors are connected to some pins of the switch body through the filter circuit board and the metal traces of the circuit board.

17. The photovoltaic inverter according to claim 16, wherein the insulated support further comprises a third support part, the third support part is located between the filter circuit board and the circuit board in the first direction, a projection of the third support part in the first direction partially overlaps a projection of the filter circuit board in the first direction, in the second direction, a distance between the third support part and the first subboard is greater than a distance between each first support part and the first subboard, and the third support part is fastened to one first support part; and
the photovoltaic inverter further comprises a total negative metal sheet, the filter circuit board is connected to one end of the total negative metal sheet, the plurality of negative connectors are connected to the total negative metal sheet through the filter circuit board, the plurality of filter capacitors are connected to the total negative metal sheet through the filter circuit board, and the other end of the total negative metal sheet is fastened to a surface that is of the third support part and that is away from the bottom plate, and is fixedly connected to the circuit board.

18. The photovoltaic inverter according to any one of claims 1 to 7, wherein all the pins are inserted into the circuit board and rigidly fastened to the circuit board.

19. The photovoltaic inverter according to claim 18, wherein the circuit board is provided with a plurality of via holes, and the pins pass through the via holes and are welded to the via holes, so that the pins are rigidly fastened to the circuit board.

20. The photovoltaic inverter according to claim 6, wherein the bottom plate comprises a bottom plate body and a protrusion plate, the protrusion plate is the thermally conductive contact part, the protrusion plate protrudes from the bottom plate body toward the inverter power assembly and is in thermally conductive connection to the inverter power assembly, orthographic projections of the protrusion plate and the inverter power assembly on the rear circuit board side at least partially overlap, orthographic projections of the protrusion plate and the direct current conversion assembly on the rear circuit board side at least partially overlap, the bus capacitor and the inductor are located between the rear circuit board side and the bottom plate body, and a part of the cooling fins are located on a side that is of the bottom plate body and that is away from the rear circuit board side.

21. The photovoltaic inverter according to claim 20, wherein the protrusion plate comprises a first protrusion subboard and a second protrusion subboard, the first protrusion subboard and the second protrusion subboard are spaced, the inverter power assembly is located between the first protrusion subboard and the rear circuit board side, and the direct current conversion assembly is located between the second protrusion subboard and the rear circuit board side; or
the protrusion plate is of an integrated structure, and the inverter power assembly and the direct current conversion assembly are disposed adjacent to each other.

22. The photovoltaic inverter according to claim 20, wherein the inverter power assembly comprises a plurality of inverter power devices, the direct current conversion assembly comprises a plurality of direct current power devices, and at least one of the inverter power devices is located between the plurality of direct current power devices, or at least one of the direct current power devices is located between the plurality of inverter power devices; or
the inverter power assembly is an inverter power module, the inverter power module comprises an inverter packaging structure and a plurality of inverter power devices located in the inverter packaging structure, the direct current conversion assembly is a direct current conversion module, and the direct current conversion module comprises a direct current packaging structure and a plurality of direct current power devices located in the direct current packaging structure.

23. The photovoltaic inverter according to any one of claims 1 to 7, wherein a positioning part is disposed on a surface that is of the switch body and that faces the circuit board, the positioning part and the pins are spaced, and the positioning part is configured to perform auxiliary positioning when the switch body is fastened to the circuit board.

24. A photovoltaic system, comprising at least one of the following: a photovoltaic module, a photovoltaic optimizer, a combiner box, a box-type transformer, a power sensor, an energy storage system, an on-grid/off-grid controller, and a smart array controller, and comprising
the photovoltaic inverter according to any one of claims 1 to 23, wherein an input end of the photovoltaic inverter is configured to electrically connect to the photovoltaic module, an output end of the photovoltaic inverter is configured to connect to a power grid, and the photovoltaic inverter is configured to convert a direct current from the photovoltaic module into an alternating current, and transfer the alternating current to the power grid.
